# EUROPEAN PATENT APPLICATION

(11) **EP 1 988 568 A1**
(43) Date of publication of application: **05.11.2008**
(21) Application number: 07715034.0
(22) Date of filing: 21.02.2007
(51) Int. Cl.: H01L 21/304, B24B 37/04, B65G 49/07, H01L 21/677

(54) **SUBSTRATE TREATING DEVICE, SUBSTRATE CONVEY DEVICE, SUBSTRATE GRASPING DEVICE, AND CHEMICAL SOLUTION TREATING DEVICE**

(30) Priority: 22.02.2006 JP 2006046002
(71) Applicant: EBARA CORPORATION, Ohta-ku, Tokyo 144-8510 (JP)
(72) Inventor: TAKAHASHI, Nobuyuki, Ohta-ku, Tokyo 1448510 (JP); NISHIDA, Hiroaki, Ohta-ku, Tokyo 1448510 (JP); TORII, Hiroomi, Ohta-ku, Tokyo 1448510 (JP); ISOBE, Soichi, Ohta-ku, Tokyo 1448510 (JP); SONE, Tadakazu, Ohta-ku, Tokyo 1448510 (JP); KOSUGE, Ryuichi, Ohta-ku, Tokyo 1448510 (JP); KANEKO, Hiroyuki, Ohta-ku, Tokyo 1448510 (JP); SOTOZAKI, Hiroshi, Ohta-ku, Tokyo 1448510 (JP); MITSUKURA, Takao, Ohta-ku, Tokyo 1448510 (JP); OGAWA, Takahiro, Ohta-ku, Tokyo 1448510 (JP); SUGITA, Kenichi, Ohta-ku, Tokyo 1448510 (JP)
(74) Representative: Wagner, Karl H.
(86) International application number: PCT/JP2007/053699
(87) International publication number: WO 2007/099976

(57) **Abstract**

The present invention relates to a substrate processing apparatus which can improve a tact time of substrate processing. A polishing apparatus as the substrate processing apparatus includes plural polishing sections (3a, 3b) each for polishing a semiconductor wafer (W), and a swing transporter (7) for transferring the wafer (W). The swing transporter (7) includes a wafer clamp mechanism (112) adapted to clamp the wafer (W), a vertically moving mechanism (104, 106) for vertically moving the wafer clamp mechanism (112) along a frame (102) of a casing of the polishing section (3a), and a swing mechanism (108, 110) for swinging the wafer clamp mechanism (112) about a shaft adjacent to the frame (102).

## Description

### Technical Field

The present invention relates to a substrate processing apparatus, and more particularly to a substrate processing apparatus for polishing a substrate, such as a semiconductor wafer, to a flat mirror finish. The present invention also relates to a substrate transfer apparatus for use in such a substrate processing apparatus. Further, the present invention relates to a substrate clamp apparatus for use in such a substrate transfer apparatus and a reversing machine. Furthermore, the present invention relates to a chemical-liquid treatment apparatus for use in the above-mentioned substrate processing apparatus.

### Background Art

As semiconductor devices have become more highly integrated in recent years, circuit interconnects have become finer and distances between those interconnects have become smaller. In photolithography capable of forming interconnects with not more than 0.5 µm in wide, surfaces, on which pattern images are to be focused by a stepper, are required to be as flat as possible because a focal depth of an optical system is small. Thus, a polishing apparatus for performing chemical mechanical polishing (CMP) has been used as means for planarizing a surface of such a semiconductor wafer.

This type of chemical mechanical polishing (CMP) apparatus comprises a top ring and a polishing table having a polishing cloth thereon. An abrasive liquid (slurry) is supplied onto a surface of the polishing cloth while a workpiece (wafer) is interposed between the polishing table and the top ring. The top ring presses the workpiece against the polishing table to thereby polish a surface of the workpiece to a flat mirror finish.

In a substrate processing apparatus such as a polishing apparatus, a tact time of substrate processing is required to be short. Further, there has recently been a demand for the substrate processing apparatuses to have a structure that can simplify maintenance operations.

In the above-mentioned substrate processing apparatus, a substrate transfer apparatus is used for transferring a substrate. This substrate transfer apparatus is also required to achieve a short tact time so that a tact time of substrate processing as a whole can be short. Furthermore, there has also been a demand for the substrate transfer apparatus to have a small number of components in order to achieve a simple structure and a low cost.

In the above-mentioned substrate processing apparatus, a substrate clamp apparatus is provided in each processing section for holding a substrate during processing. However, a conventional substrate clamp apparatus has a problem in securely holding substrates of different sizes.

Furthermore, several types of chemical liquids are used in the above-mentioned substrate processing apparatus. Thus, a chemical-liquid supply apparatus is provided for supplying those chemical liquids to each of the processing sections of the substrate processing apparatus. There has been a demand for such a chemical-liquid supply apparatus to require a small installation space and a low cost and to improve an efficiency of maintenance operations.

### Disclosure of Invention

The present invention has been made in view of the above drawbacks. It is therefore a first object of the present invention to provide a substrate processing apparatus which can improve a tact time of processing a substrate.

It is a second object of the present invention to provide a substrate processing apparatus which can facilitate maintenance operations.

It is a third object of the present invention to provide a substrate transfer apparatus which has a small number of components and a simple structure and can achieve a low cost.

It is a fourth object of the present invention to provide a substrate transfer apparatus which can improve a tact time of substrate processing.

It is a fifth object of the present invention to provide a substrate clamp apparatus which can securely clamp a substrate.

It is a sixth object of the present invention to provide a chemical-liquid supply apparatus which requires a small installation space and a low cost and can improve an efficiency of maintenance operations.

According to a first aspect of the present invention, there is provided a substrate processing apparatus which can shorten a tact time of substrate processing. This substrate processing apparatus includes plural processing sections each for performing predetermined processing on a substrate, and a substrate transfer mechanism for transferring the substrate between the plural processing sections. The substrate transfer mechanism includes a substrate clamp mechanism adapted to clamp the substrate, a vertically moving mechanism for vertically moving the substrate clamp mechanism along a frame of a casing of one of the plural processing sections, and a swing mechanism for swinging the substrate clamp mechanism about the frame or a shaft adjacent to the frame.

The above substrate transfer mechanism does not require arms to extend and contract like a conventional transfer robot. Instead, this substrate transfer mechanism can be composed of the vertically moving mechanism, the swing mechanism, and the substrate clamp mechanism. Therefore, the structure of the substrate transfer mechanism can be simple, and a small force is required for operation thereof. As a result, a substrate can be quickly transferred, and a tact time of processing the substrate can be shortened. Further, because the frame of the processing section, such as a polishing section, is used to constitute the substrate transfer mechanism, a space for allowing the arms to extend and contract is not required. Therefore, the substrate transfer mechanism can be small, and thus requires a small installation area. Furthermore, stiffness of the substrate transfer mechanism can be enhanced.

According to a second aspect of the present invention, there is provided a substrate processing apparatus which can shorten a tact time of substrate processing. This substrate processing apparatus includes a first processing section for performing a first process on a substrate, a reversing machine for reversing the substrate that has been processed in the first processing section, and a second processing section for performing a second process on the substrate that has been reversed by the reversing machine. The reversing machine includes holding members configured to clamp the substrate, a reversing mechanism for reversing the substrate clamped by the holding members, and a vertically movable temporary stage disposed below the holding members. The temporary stage is for holding the substrate that has been reversed by the reversing mechanism. This temporary stage can be used as a buffer when transferring the substrate. Therefore, a tact time of processing the substrate as a whole can be shortened.

The substrate processing apparatus may include a substrate transfer mechanism for transferring a substrate between the first processing section or second processing section and the holding members or temporary stage of the reversing machine.

According to a third aspect of the present invention, there is provided a substrate processing apparatus which can shorten a tact time of substrate processing. This substrate processing apparatus includes plural processing sections for performing predetermined processing on a substrate, and a substrate transfer mechanism for transferring the substrate between the plural processing sections. The substrate transfer mechanism includes a horizontal transfer mechanism for transferring the substrate between predetermined processing sections selected from the plural processing sections, and a vertical transfer mechanism for transferring the substrate so as to skip the predetermined processing sections. The horizontal transfer mechanism is operable to transfer the substrate in a direction parallel to a surface of the substrate with an attitude of the substrate kept horizontal, and the vertical transfer mechanism is operable to transfer the substrate in the direction parallel to the surface of the substrate with the attitude of the substrate kept vertical.

With this substrate processing mechanism, the substrate is not affected by contamination of the processing section, and can thus be transferred to another processing section under a clean condition. Further, a route of the substrate transferred by the horizontal transfer mechanism can be different from that by the vertical transfer mechanism. Therefore, the substrate can be prevented from staying in the substrate transfer mechanism. As a result, a tact time of substrate processing can be shortened.

According to a fourth aspect of the present invention, there is provided a substrate processing apparatus which can facilitate maintenance operations. This substrate processing apparatus includes plural processing sections each for performing predetermined processing on a substrate. At least one of the plural processing sections includes a frame, an immovable leg for fixing the frame, and a caster leg having a main roller movable in a pullout direction of the frame. A length of the caster leg is adjustable.

With this structure, at least one processing section can be easily separated from other processing sections. Therefore, maintenance operations can be facilitated.

The caster leg may have a side roller contacting a component adjacent to the caster leg. Further, the frame may have a projection located between a pair of guide members extending in the pullout direction and provided adjacent to the frame.

According to a fifth aspect of the present invention, there is provided a substrate processing apparatus which can facilitate maintenance operations. This substrate processing apparatus includes plural units each for performing predetermined processing on a substrate, and a frame for housing the plural units therein. The frame includes slide blocks attached to legs of the plural units, plates on which the slide blocks slide, and guide members for guiding the slide blocks, sliding on the plates, in a pullout direction of the frame.

With this structure, the unit, which processes the substrate, can be easily removed from the substrate processing apparatus. Therefore, maintenance operations can be facilitated.

According to a sixth aspect of the present invention, there is provided a substrate transfer apparatus which has a small number of components and a simple structure, and can achieve a low cost. This substrate transfer apparatus includes a guide stage for holding a top ring adapted to hold a substrate, a push stage vertically movable relative to the guide stage, a cylinder having a ball spline mechanism for vertically moving the guide stage, and a linear way adapted to perform centering of the guide stage.

With this structure, the number of components can be small, the structure can be simplified, and a low cost can be achieved.

According to a seventh aspect of the present invention, there is provided a substrate transfer apparatus which can shorten a tact time of substrate processing. This substrate transfer apparatus includes plural chucking units each having a pair of clamp arms for clamping a periphery of a substrate, an opening and closing mechanism for moving the pair of clamp arms in directions toward and away from one another, a rotating mechanism for rotating the clamp arms about a shaft extending in an arrangement direction of the plural chucking units, a vertically moving mechanism for vertically moving the plural chucking units, and a moving mechanism for moving the plural chucking units along the arrangement direction of the plural chucking units. The clamp arms are symmetrically arranged about a center of the substrate so as to face one another.

With this structure, plural substrates can be simultaneously transferred by the plural chucking units. Further, after the substrate transfer apparatus terminates transferring of the substrates, the clam arms are moved outside the processing sections, so that processing of the substrates can be performed in the processing sections, while the substrate transfer apparatus can move to a desired standby position. Therefore, processing of the substrates in the processing sections can be started quickly, and a tact time can be shortened.

According to an eighth aspect of the present invention, there is provided a substrate processing apparatus including a processing section for performing predetermined processing on a substrate, and the substrate transfer apparatus for transferring the substrate to and from the processing section. The processing section includes plural rollers for holding and rotating the substrate, and positioning guides configured to allow a vertical movement of the substrate transferred by the substrate transfer apparatus, while restricting a horizontal movement of the substrate. Each of the plural rollers has a support portion onto which the substrate is placed.

According to a ninth aspect of the present invention, there is provided a substrate processing apparatus including plural processing sections each for performing predetermined processing on a substrate, and the substrate transfer apparatus for transferring the substrate between the plural processing sections. The substrate transfer apparatus is operable to transfer the substrate to the plural processing sections using the clamp arms, move the clamp arms from the plural processing sections and then rotate the clamp arms, and then move the clamp arms to predetermined positions.

According to a tenth aspect of the present invention, there is provided a substrate clamp apparatus which can securely clamp a substrate. This substrate clamp apparatus includes a pair of clamp members having at least two chucking mechanisms which are to be brought into contact with a periphery of a substrate, and an opening and closing mechanism for moving the pair of clamp members in directions toward and away from one another. The pair of clamp members are arranged symmetrically about a center of the substrate so as to face one another.

With this structure, because the clamp members are moved in directions opposite to one another along a common line to hold and release the substrate, reliable clamp of the substrate can be realized.

The chucking mechanisms may comprise circular pieces shaped to come into point contact with the periphery of the substrate. Further, the chucking mechanisms may comprise chucking members shaped to come into line contact with the periphery of the substrate. In this case, it is preferable that each of the chucking mechanisms includes a slope which is gradually inclined with an upward gradient toward the periphery of the substrate, and a projection provided at an outermost periphery of the slope.

According to an eleventh aspect of the present invention, there is provided a chemical liquid supply apparatus which requires a small installation space and a low cost, and can improve an efficiency of maintenance operations. This chemical liquid supply apparatus includes a chemical liquid supply pipe for supplying a chemical liquid, a pressure sensor for detecting pressure of the chemical liquid flowing through the chemical liquid supply pipe, a first air operate valve for adjusting a flow rate of the chemical liquid flowing through the chemical liquid supply pipe, a pure water supply pipe for supplying pure water to the chemical liquid supply pipe, a second air operate valve for adjusting a flow rate of the pure water flowing through the pure water supply pipe, a check valve for preventing backflow of the chemical liquid from the chemical liquid supply pipe into the pure water supply pipe, a chemical liquid return pipe for returning the chemical liquid unused from the chemical liquid supply pipe, and a third air operate valve for adjusting a flow rate of the chemical liquid flowing through the chemical liquid return pipe. The chemical liquid supply pipe, the pressure sensor, the first air operate valve, the pure water supply pipe, the second air operate valve, the check valve, the chemical liquid return pipe, and the third air operate valve are arranged in a single unit.

With this structure, because the pressure sensor, the first, second and third air operate valves, the check valves and other components are integrally assembled, an installation space thereof can be small and a cost can be low. Furthermore, because these components are assembled within a single space, an efficiency of maintenance operations can be improved.

According to a twelfth aspect of the present invention, there is provided a substrate processing apparatus including plural processing sections each for performing predetermined processing on a substrate, and a substrate transfer mechanism for transferring the substrate between the plural processing sections. The substrate transfer mechanism includes projections extending toward a center of the substrate and having upper projections and lower projections, a transfer robot operable to place a periphery of the substrate onto upper surfaces of the lower projections and then move away from the projection, and an opening and closing mechanism operable to move the projections toward the center of the substrate and to close the projections when the periphery of the substrate is placed onto the upper surfaces of the lower projections.

As described above, the present invention can achieve a short tact time of substrate processing and easy maintenance operations. Further, the present invention can provide a substrate transfer apparatus which can achieve a small number of components, a simple structure, and a low cost. Further, the present invention can provide a substrate clamp apparatus which can reliably clamp the substrate. Furthermore, the present invention can provide a chemical liquid supply apparatus which requires a small installation space and a low cost and can improve an efficiency of maintenance operations.

### Brief Description of Drawings

FIG. 1 is a plan view showing an entire arrangement of a polishing apparatus as a substrate processing apparatus according to an embodiment of the present invention;
FIG. 2 is a perspective view showing an outline of the polishing apparatus shown in FIG. 1;
FIGS. 3A and 3B are views each showing front loading units of the polishing apparatus shown in FIG. 1, FIG. 3A being a front view, and FIG. 3B being a side view;
FIG. 4 is a side view of a transfer robot in the polishing apparatus shown in FIG. 1;
FIG. 5 is a plan view showing a hand of a transfer robot according to another embodiment of the present invention;
FIG. 6 is a side view, partly in cross section, showing a structure of a top ring of the polishing apparatus shown in FIG. 1;
FIG. 7 is a vertical cross-sectional view showing a dresser of the polishing apparatus shown in FIG. 1 and shows a diamond dresser;
FIG. 8 is a vertical cross-sectional view showing a dresser of the polishing apparatus shown in FIG. 1 and shows a brush dresser;
FIG. 9 is a perspective view showing a swing transporter and a reversing machine in a cleaning section of the polishing apparatus shown in FIG. 1;
FIG. 10 is a front view of a first linear transporter of the polishing apparatus shown in FIG. 1;
FIG. 11 is a plan view of FIG. 10;
FIG. 12 is a front view showing a second linear transporter of the polishing apparatus shown in FIG. 1;
FIG. 13 is a plan view of FIG. 12;
FIGS. 14 is a perspective view showing a reversing machine of a first polishing section of the polishing apparatus shown in FIG. 1;
FIG. 15 is a plan view of FIG. 14;
FIG. 16 is a side view of FIG. 14;
FIG. 17 is a vertical cross-sectional view showing an opening-closing mechanism of the reversing machine shown in FIG. 14;
FIGS. 18 is a vertical cross-sectional view showing the opening-closing mechanism of the reversing machine shown in FIG. 14;
FIG. 19 is a cross-sectional view taken along line XIX-XIX shown in FIG. 15;
FIG. 20 is a plan view showing a state in which the reversing machine of FIG. 14 receives a wafer;
FIG. 21 is a perspective view showing a state in which the reversing machine of FIG. 20 receives a wafer;
FIG. 22 is a plan view showing a state in which the reversing machine of FIG. 14 reverses a wafer;
FIG. 23 is a perspective view showing a temporary stage of the reversing machine in the cleaning section of the polishing apparatus shown in FIG. 1;
FIG. 24 is a perspective view showing a state in which the temporary stage shown in FIG. 23 is elevated;
FIG. 25 is a vertical cross-sectional view showing a lifter of the polishing apparatus shown in FIG. 1;
FIG. 26 is a vertical cross-sectional view showing a pusher of the polishing apparatus shown in FIG. 1;
FIG. 27 is a perspective view showing a transfer unit of the polishing apparatus shown in FIG. 1;
FIGS. 28A and 28B are schematic views each showing operations of the transfer unit of the polishing apparatus shown in FIG. 27;
FIG. 29 is a perspective view showing the transfer unit with its arms raised;
FIGS. 30A and 30B are views explanatory of operation of the transfer unit shown in FIG. 27, FIG. 30A being a horizontal cross-sectional view, FIG. 30B being a vertical cross-sectional view;
FIG. 31A is a side view schematically showing a standby state of the transfer unit shown in FIG. 27;
FIG. 31B is a rear view of FIG. 31A;
FIG. 32A is a side view schematically showing a moving state of the transfer unit shown in FIG. 27;
FIG. 32B is a rear view of FIG. 32A;
FIG. 32C is a side view schematically showing a moving state of the transfer unit shown in FIG. 27;
FIG. 32D is a rear view of FIG. 32C;
FIG. 33 is a perspective view schematically showing a primary cleaning device 42;
FIG. 34 is a plan view schematically showing the primary cleaning device 42;
FIG. 35 is a schematic view showing operations in which a wafer is transferred to the cleaning device 42;
FIG. 36 is a schematic view showing operations in which the wafer is placed onto rollers (shoulder portions) of the cleaning device 42;
FIG. 37 is a schematic view showing operations in which the wafer is clamped;
FIG. 38 is a schematic view showing operations in which the wafer is clamped and processed;
FIGS. 39A through 39D are schematic views explanatory of operations of the first linear transporter when serial processing is performed;
FIGS. 40A through 40D are schematic views explanatory of operations of the first linear transporter when serial processing is performed;
FIGS. 41A through 41D are schematic views explanatory of operations of the first linear transporter when serial processing is performed;
FIGS. 42A through 42D are schematic views explanatory of operations of the first linear transporter when serial processing is performed;
FIGS. 43A through 43D are schematic views explanatory of operations of the second linear transporter when serial processing is performed;
FIGS. 44A through 44D are schematic views explanatory of operations of the second linear transporter when serial processing is performed;
FIGS. 45A through 45E are schematic views explanatory of operations of the second linear transporter when serial processing is performed;
FIGS. 46A through 46D are schematic views explanatory of operations of the first linear transporter when parallel processing is performed;
FIGS. 47A through 47D are schematic views explanatory of operations of the first linear transporter when parallel processing is performed;
FIGS. 48A through 48E are schematic views explanatory of operations of the first linear transporter when parallel processing is performed;
FIGS. 49A through 49D are schematic views explanatory of operations of the second linear transporter when parallel processing is performed;
FIGS. 50A through 50D are schematic views explanatory of operations of the second linear transporter when parallel processing is performed;
FIGS. 51A through 51E are schematic views explanatory of operations of the second linear transporter when parallel processing is performed;
FIG. 52 is a schematic view showing a modified example of the polishing apparatus shown in FIG. 1;
FIG. 53 is a perspective view showing a frame structure of the polishing apparatus shown in FIG. 1;
FIG. 54 is a schematic view showing a lower portion of the frame of the cleaning section shown in FIG. 53;
FIG. 55 is a perspective view showing a caster leg attached to the frame of the cleaning section shown in FIG. 53;
FIG. 56 is a perspective view showing a state in which the frame of the cleaning section is pulled out;
FIG. 57 is a schematic view showing a lower portion of the frame of the cleaning section shown in FIG. 53;
FIG. 58 is a schematic view showing guide members provided next to the frame of the cleaning section shown in FIG. 53;
FIG. 59 is a perspective view showing a structure of the cleaning section shown in FIG. 53;
FIG. 60 is a perspective view showing an installation structure of one of cleaning units shown in FIG. 59;
FIG. 61 is a block diagram showing a chemical liquid supply apparatus of the polishing apparatus shown in FIG. 1;
FIG. 62 is a vertical cross-sectional view showing the chemical liquid supply apparatus shown in FIG. 61; and
FIG. 63 is a vertical cross-sectional view showing the chemical liquid supply apparatus shown in FIG. 61.

### Best Mode for Carrying Out the Invention

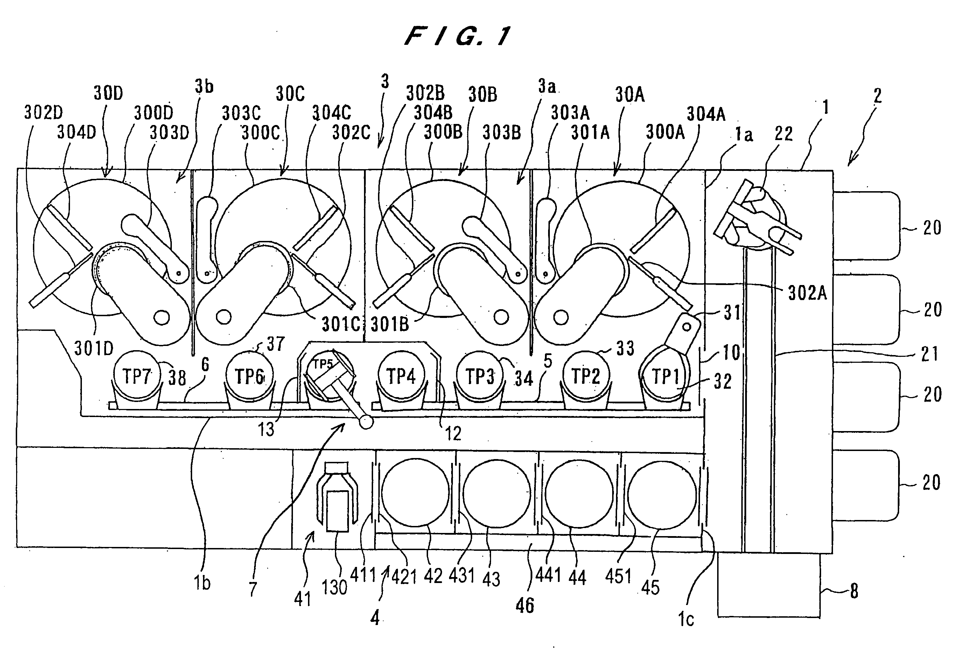

A polishing apparatus according to embodiments of the present invention will be described below in detail with reference to FIGS. 1 through 63. Identical or corresponding elements are denoted by the same reference numerals, and will not be described repetitively.

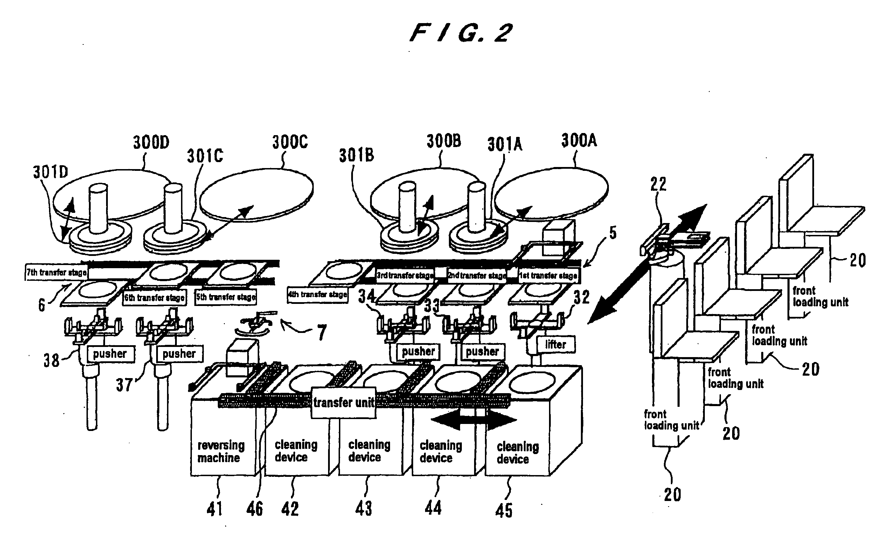

FIG. 1 is a plan view showing an entire arrangement of a polishing apparatus according to an embodiment of the present invention, and FIG. 2 is a perspective view showing an outline of the polishing apparatus shown in FIG. 1. As shown in FIG. 1, the polishing apparatus of the present embodiment has a housing 1 in a rectangular form. An interior space of the housing 1 is divided into a loading/unloading section 2, a polishing section 3 (3a, 3b), and a cleaning section 4 by partition walls 1a, 1b, and 1c. The loading/unloading section 2, the polishing sections 3a and 3b, and the cleaning section 4 are assembled independently of each other, and evacuation of gas from these sections is performed independently of each other.

The loading/unloading section 2 has two or more front loading units 20 (four in the present embodiment) on which wafer cassettes, each storing a number of semiconductor wafers, are placed. The front loading units 20 are arranged adjacent to each other along a width direction of the polishing apparatus (a direction perpendicular to a longitudinal direction of the polishing apparatus). Each of the front loading units 20 can receive thereon an open cassette, an SMIF (Standard Manufacturing Interface) pod, or a FOUP (Front Opening Unified Pod). The SMIF and FOUP are a hermetically sealed container which houses a wafer cassette therein and covers it with a partition wall to thereby provide interior environments isolated from an external space.

Further, the loading/unloading section 2 has a moving mechanism 21 extending along an arrangement direction of the front loading units 20. A transfer robot 22 is installed on the moving mechanism 21 and is movable along the arrangement direction of the front loading units 20. This transfer robot 22 is operable to move on the moving mechanism 21 so as to access the wafer cassettes mounted on the front loading units 20. The transfer robot 22 has vertically arranged two hands, which are separately used. For example, the upper hand can be used for returning a polished semiconductor wafer to the wafer cassette, and the lower hand can be used for transferring a non-polished semiconductor wafer.

The loading/unloading section 2 is required to be a cleanest area. Therefore, pressure in the interior of the loading/unloading section 2 is kept higher at all times than pressures in the exterior space of the apparatus, the polishing section 3, and the cleaning section 4. Further, a filter fan unit (not shown in the drawings) having a clean air filter, such as HEPA filter or ULPA filter, is provided above the moving mechanism 21 of the transfer robot 22. This filter fan unit removes particles, toxic vapor, and toxic gas from air to produce clean air, and forms downward flow of the clean air at all times.

The polishing section 3 is an area where a semiconductor wafer is polished. This polishing section 3 comprises a first polishing section 3a having a first polishing unit 30A and a second polishing unit 30B therein, and a second polishing section 3b having a third polishing unit 30C and a fourth polishing unit 30D therein. As shown in FIG. 1, the first polishing unit 30A, the second polishing unit 30B, the third polishing unit 30C, and the fourth polishing unit 30D are arranged along the longitudinal direction of the polishing apparatus.

As shown in FIG. 1, the first polishing unit 30A comprises a polishing table 300A having a polishing surface, a top ring 301A for holding a semiconductor wafer and pressing the semiconductor wafer against the polishing table 300A so as to polish the wafer, a polishing liquid supply nozzle 302A for supplying a polishing liquid or a dressing liquid (e.g., water) onto the polishing table 300A, a dresser 303A for dressing the polishing table 300A, and an atomizer 304A having one or more nozzles for ejecting a mixture of a liquid (e.g., pure water) and gas (e.g., nitrogen) in an atomized state toward the polishing surface. Similarly, the second polishing unit 30B comprises a polishing table 300B, a top ring 301B, a polishing liquid supply nozzle 302B, a dresser 303B, and an atomizer 304B. The third polishing unit 30C comprises a polishing table 300C, a top ring 301C, a polishing liquid supply nozzle 302C, a dresser 303C, and an atomizer 304C. The fourth polishing unit 30D comprises a polishing table 300D, a top ring 301D, a polishing liquid supply nozzle 302D, a dresser 303D, and an atomizer 304D.

A first linear transporter 5 is disposed between the first polishing unit 30A and second polishing unit 30B of the first polishing section 3a and the cleaning section 4. This first linear transporter 5 is for transferring a wafer bewteen four transferring positions located along the longitudinal direction of the polishing apparatus (hereinafter, these four transferring positions will be referred to as a first transferring position TP1, a second transferring position TP2, a third transferring position TP3, and a fourth transferring position TP4 in the order from the loading/unloading section 2). A reversing machine 31 for reversing a wafer transferred from the transfer robot 22 of the loading/unloading section 2 is disposed above the first transferring position TP1 of the first linear transporter 5, and a vertically movable lifter 32 is disposed below the first transferring position TP1. A vertically movable pusher 33 is disposed below the second transferring position TP2, and a vertically movable pusher 34 is disposed below the third transferring position TP3. A shutter 12 is provided between the third transferring position TP3 and the fourth transferring position TP4.

In the second polishing section 3b, a second linear transporter 6 is disposed adjacent to the first linear transporter 5. This second linear transporter 6 is for transferring a wafer between three transferring positions located along the longitudinal direction of the polishing apparatus (hereinafter, these three transferring positions will be referred to as a fifth transferring position TP5, a sixth transferring position TP6, and a seventh transferring position TP7 in the order from the loading/unloading section 2). A pusher 37 is disposed below the sixth transferring position TP6 of the second linear transporter 6, and a pusher 38 is disposed below the seventh transferring position TP7. A shutter 13 is provided between the fifth transferring position TP5 and the sixth transferring position TP6.

As can be understood from the fact that slurry is used during polishing, the polishing section 3 is the dirtiest area. Therefore, gas is discharged from surrounding spaces of the respective polishing tables so as to prevent particles from escaping out of the polishing section 3. Pressure in the interior of the polishing section 3 is set to be lower than pressures in the exterior of the apparatus, the cleaning section 4, and the loading/unloading section 2, whereby scattering of particles is prevented. Typically, discharge ducts (not shown in the drawings) are provided below the polishing tables, respectively, and filters (not shown in the drawings) are provided above the polishing tables, so that downward flows of clean air are formed from the filters to the discharge ducts.

The polishing unit 30A, the polishing unit 30B, the polishing unit 30C, and the polishing unit 30D are separated and hermetically isolated by partitions, and the gas is discharged separately from the polishing unit 30A, the polishing unit 30B, the polishing unit 30C, and the polishing unit 30D. Therefore, a semiconductor wafer is processed in the hermetically isolated polishing units 30A, 30B, 30C, and 30D, and is not affected by an atmosphere of slurry. As a result, polishing can be performed under good conditions. As shown in FIG. 1, the partitions between the polishing units 30A, 30B, 30C, and 30D have openings, respectively, that allow the linear transporters 5 and 6 to move therethrough. Shutters may be provided respectively on these openings, and the shutters may be operable to be opened only when a wafer is transferred therethrough.

The cleaning section 4 is an area where a polished semiconductor wafer is cleaned. The cleaning section 4 comprises a reversing machine 41 for reversing a wafer, four cleaning devices 42-45 for cleaning a semiconductor wafer which has been polished, and a transfer unit 46 for transferring a wafer between the reversing machine 41 and the cleaning devices 42-45. The reversing machine 41 and the cleaning devices 42-45 are arranged in series along the longitudinal direction of the polishing apparatus. A filter fan unit (not shown in the drawings), having a clean air filter, is provided above the cleaning devices 42-45. This filter fan unit serves to remove particles from air to produce clean air, and to form downward flow of the clean air at all times. Further, pressure in the cleaning section 4 is kept higher than that in the polishing section 3, so that particles in the polishing section 3 is prevented from flowing into the cleaning section 4.

As shown in FIG. 1, a swing transporter (wafer transfer mechanism) 7 is provided between the first linear transporter 5 and the second linear transporter 6. This swing transporter 7 is for transferring a wafer between the first linear transporter 5, the second linear transporter 6, and the reversing machine 41 in the cleaning section 4. The swing transporter 7 is operable to transfer a wafer from the fourth transferring position TP4 of the first linear transporter 5 to the fifth transferring position TP5 of the second linear transporter 6, from the fifth transferring position TP5 of the second linear transporter 6 to the reversing machine 41, and from the fourth transferring position TP4 of the first linear transporter 5 to the reversing machine 41.

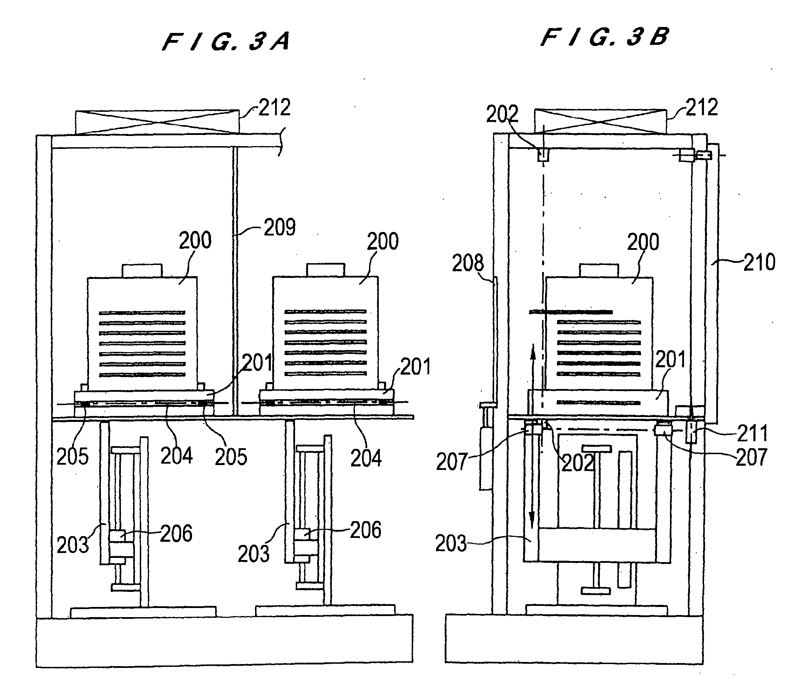

The front loading units 20 of the loading/unloading sections 2 will be described below. FIGS. 3A and 3B are views showing the front loading units 20. FIG. 3A is a front view, and FIG. 3B is a side view. As shown in FIGS. 3A and 3B, each of the front loading units 20 has a loading/unloading stage 201 for mounting a wafer cassette 200 on the apparatus. The loading/unloading stage 201 has a positioning mechanism having a block that is shaped so as to correspond to a shape of a lower surface of the wafer cassette 200. Thus, the cassette is placed in the same position every time. The presence of the wafer cassette 200 is detected by a button-type sensor when the wafer cassette 200 is placed in a proper position. Transmission optical sensors 202 are disposed above and below the cassette 200. Locations of the transmission optical sensors 202 are such that, when a wafer projects from the cassette 200 by a predetermined distance, light between the transmission optical sensors 202 is blocked by the wafer. Thus, based on the light transmission, the transmission optical sensors 202 detect projection of the wafer and determine whether wafers are properly received in respective slots of the cassette 200. If projection of a wafer is detected, then an interlocking mechanism is operated so as not to allow the transfer robot 22, a searching mechanism 203, and the like to access the front loading unit 20. Projection of the wafer may be detected based on analysis of an image obtained by a CCD camera. Alternatively, a reflection-type sensor, which emits light to an edge portion of the wafer and detects reflected light from the wafer, may be used so as to detect projection of a wafer.

Dummy wafer stations 204 are disposed below the respective loading/unloading stages 201. Each of the dummy wafer stations 204 can receive one or more wafers placed thereon. For example, a dummy wafer, used for stabilizing the polishing surface before a product wafer is processed, or a QC (Quality Control) wafer, used for checking conditions of the polishing apparatus, is stored in the dummy wafer stations 204. The dummy wafer station 204 has sensors 205 provided therein for detecting the presence of a wafer, so that the sensors 205 can detect whether a wafer is held in the dummy wafer station 204. When no cassette 200 is placed on the loading/unloading stage 201, the loading/unloading stage 201 located above the station may be elevated to allow a wafer to be placed manually on the dummy wafer station 204. Typical steps of mounting a wafer on the dummy wafer station are as follows. The cassette 200 having wafers inserted therein is placed on any one of the loading/unloading stages 201, and then searching of the wafers is performed. Thereafter, a control panel sends commands indicating which wafer is to be delivered to which of the dummy wafer stations 204. The selected wafer is delivered from the cassette 200 to the dummy wafer station 204 by the transfer robot 22, which can access both the cassette 200 and the dummy wafer station 204. Alternatively, a dummy wafer may be placed on one of the front loading units 20, which then serves as a dummy wafer station.

Wafer searching mechanisms 203 are disposed below the respective loading/unloading stages 201 (if dummy wafer stations are provided, the wafer searching mechanisms 203 are disposed below the dummy wafer stations). Each of the wafer searching mechanisms 203 is vertically movable by a driving source (pulse motor) 206 and has wafer searching sensors 207 mounted on tip ends thereof. When the wafer searching mechanisms 203 are not in a wafer searching operation, the wafer searching mechanisms 203 are on standby within the apparatus in order not to interfere with other components in operation. The wafer searching sensors 207 are disposed in confronting relation to each other such that light, traveling between the wafer searching sensors 207, passes horizontally through the cassette 200 as viewed from a side of the front loading units 20. A wafer searching operation is performed as follows. The wafer searching mechanism 203 moves upwardly from a position below the dummy wafer station 204 to a position above a final slot in the cassette 200 and then moves downwardly to the position below the dummy wafer station 204. During this movement, the wafer searching sensors 207 count the number of times the light is interrupted by wafers, thereby counting the number of wafers. At this time, the wafer searching mechanism 203 determines the positions of the wafers based on pulses of the pulse motor 206 as a driving source to thereby determine which slots in the wafer cassette 200 hold the wafers. The wafer searching mechanism 203 also has an oblique wafer detecting function, which detects an obliquely inserted wafer based on interruption of the light between the wafer searching sensors 207. More specifically, when intervals of light interruption are greater than preset intervals each corresponding to a distance between the slots in the cassette 200, the wafer searching mechanism 203 determines that a wafer is obliquely inserted.

Further, a shutter 208 is disposed between an opening portion of the wafer cassette and the apparatus, and is vertically moved by an air cylinder. The shutter 208 separates the cassette installation area and the interior of the apparatus. The shutter 208 is closed except when the transfer robot 22 transfers a wafer to and from the cassette. Partition walls 209 are provided between the adjacent loading/unloading stages 201 arrayed in front of the apparatus. Thus, an operator can access the cassette, storing processed wafers, so as to replace it without inadvertently touching the adjacent cassette which is in operation.

Doors 210 are provided in front of the respective front loading units 20 for separating the interior of the apparatus from the exterior of the apparatus. Each of the doors 210 has a locking mechanism and a sensor 211 for detecting whether the door 210 is opened or closed. When the apparatus is in operation, the doors 210 are locked by the locking mechanisms to protect the cassette and forestall danger to the operator. If any one of the doors 210 is left opened for a certain period of time, then an alarm is issued.

The following two methods may be used in order to place the cassette on one of the front loading units 20.
(1) The cassette 200 having wafers therein is placed directly onto the front loading unit 20. This process is used when a chamber of a clean room facing the front loading units 20 is relatively clean, e.g., it has a clean room environment of at most class 100.
(2) When a chamber of a clean room facing the front loading units 20 is relatively dirty, e.g., it has a clean room environment of not less than class 1000, the cassette 200 is housed in a container, which is controlled at a clean room environment of about class 100, and delivered in the clean room and placed on the front loading unit 20.

In the case of (1), it is desirable that a filter fan unit 212 is mounted above the front loading units 20 for keeping the cassette installation sites clean.

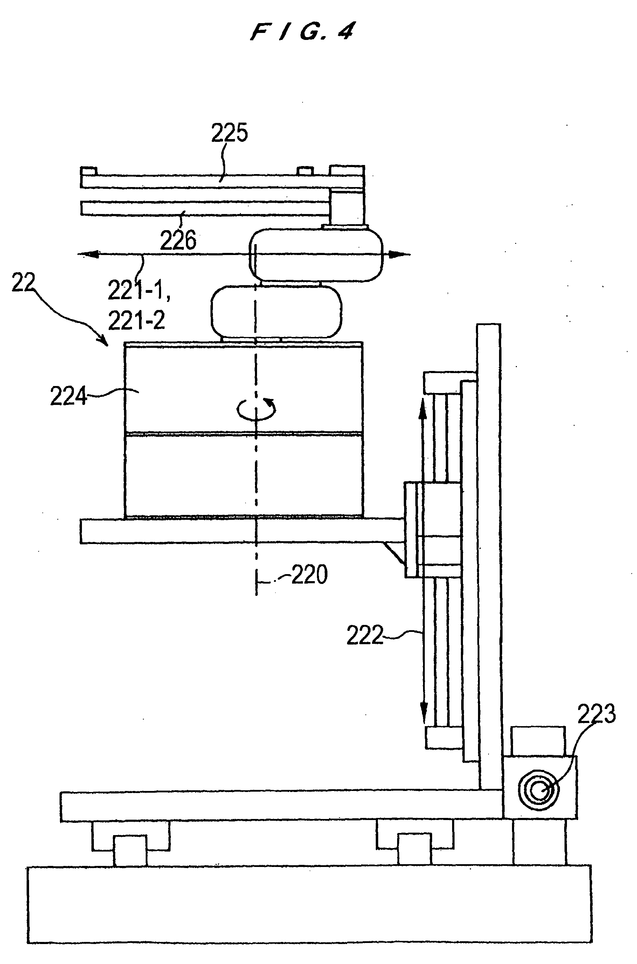

Next, the transfer robot 22 in the loading/unloading section 2 will be described. FIG. 4 is a side view of the transfer robot 22. As shown in FIG. 4, the transfer robot 22 has a θ-axis 220 for rotation, an R1-axis 221-1 for extension and contraction of an upper hand, an R2-axis 221-2 for extension and contraction of a lower hand, a Z-axis 222 for movement in a vertical direction, and an X-axis 223 for movement in a direction in which the cassettes are arrayed. The Z-axis 222 of the robot may be incorporated in a robot body 224.

Each of the upper and lower hands has a vacuum line and can serve as a vacuum attraction-type hand. The attraction-type hand can accurately transfer a wafer irrespective of positional deviation of the wafer in the cassette. Further, the hands can employ a recess support-type hand for supporting a peripheral edge of a wafer. The recess support-type hand can transfer a wafer while maintaining cleanliness of the reverse face of the wafer because it does not collect dusts unlike the attraction-type hand. Therefore, the recess support-type hand is preferably used during a transferring process which is between the time when a wafer is removed from the cleaning device 45 and the time when the wafer is housed in the wafer cassette on the front loading unit 20, i.e., the recess support-type hand is preferably used to transfer a wafer which has been cleaned. Further, when the upper hand comprises a recess support-type hand, a cleaned wafer can be prevented from being further contaminated. FIG. 4 shows that the upper hand comprises a recess support-type hand 225 and the lower hand comprises an attraction-type hand 226.

In the case of using the vacuum attraction-type hand, the presence of the wafer on the hand can be detected by using a vacuum switch. In the case of using the recess support-type hand, the presence of the wafer on the hand can be detected by using a proximity sensor, such as a reflection-type sensor or a capacitance-type sensor.

In the present embodiment, the upper hand 225 can access the cleaning device 45 and the front loading units 20, and the lower hand 226 can access the front loading units 20 and the reversing machine 31 in the polishing section 3.

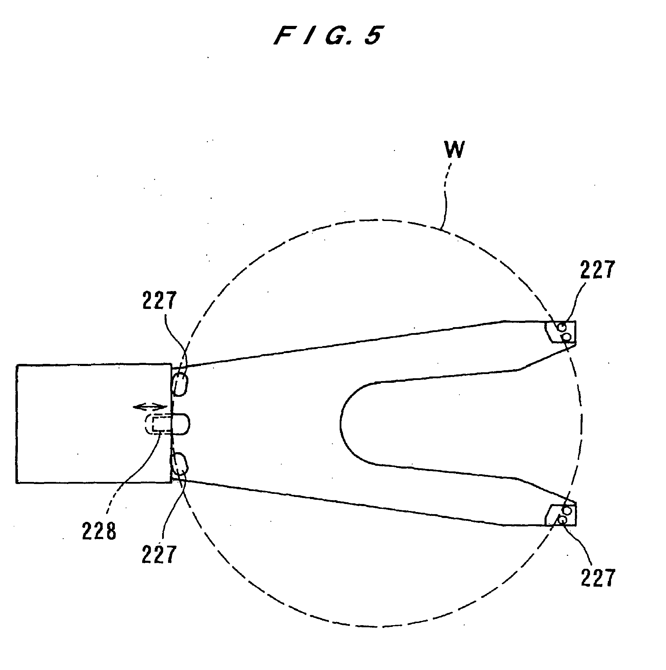

FIG. 5 is a plan view showing a hand of a transfer robot according to another embodiment of the present invention. The hand shown in FIG. 5 has a plurality of supports 227 for supporting a peripheral portion of a wafer W and a movable clamp 228 provided at a base portion of the hand. When the movable clamp 228 moves toward the center of the wafer W, the wafer is supported and held by the supports 227. The presence of the wafer on the hand can be detected by measuring a stroke of the movable clamp 228.

As shown in FIG. 1, a film thickness measurement device (In-line Thickness Monitor: ITM) 8 for measuring a film thickness of a wafer is provided at a side portion of the loading/unloading section 2. The transfer robot 22 is operable to access the film thickness measurement device 8. The film thickness measurement device 8 receives a wafer from the transfer robot 22 before or after polishing and measures the film thickness of the wafer. Properly adjusting polishing conditions and the like based on measurement results obtained by the film thickness measurement device 8 can enhance a polishing accuracy.

The polishing units 30A, 30B, 30C, and 30D in the polishing section 3 will be described below. These polishing units 30A, 30B, 30C, and 30D have substantially the same structure, and only the first polishing unit 30A will be described below.

The polishing table 300A has a polishing cloth or a grinding stone attached to an upper surface thereof. The polishing cloth or grinding stone forms the polishing surface that is used to polish a semiconductor wafer. During polishing, a polishing liquid is supplied onto the polishing surface of the polishing table 300A from the polishing liquid supply nozzle 302A. A semiconductor wafer is pressed against the polishing surface by the top ring 301A, whereby polishing is performed. One or more polishing units may have a belt or tape with a polishing surface, so that a combination of both the polishing surface of the belt or tape and the polishing surface in the form of a table can be used.

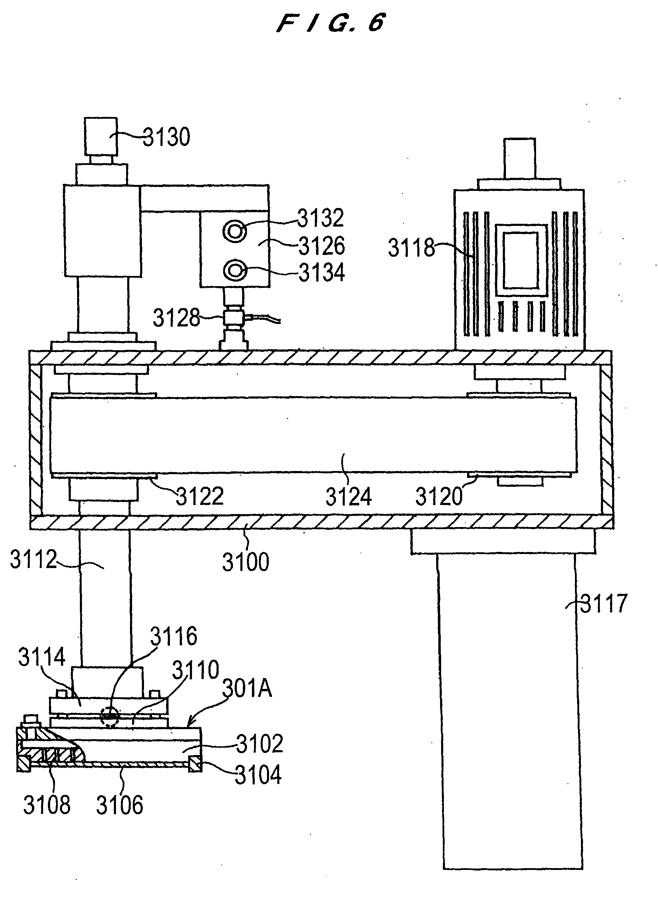

FIG. 6 is a side view, partly in cross section, showing a structure of the top ring 301A of the first polishing unit 30A. The top ring 301A is supported by a top ring head 3100 that allows the top ring 301A to perform several movements, such as rotation, pressing, and swinging. The top ring 301A has a top ring body 3102 for holding an upper surface of the wafer and pressing the wafer against the polishing surface of the polishing table 300A, a guide ring 3104 for retaining a periphery of the wafer, and a backing film 3106, serving as a cushioning member, interposed between the top ring 301A and the wafer. The top ring body 3102 is made of a rigid material, such as ceramics or metal having corrosion resistance and stiffness (e.g., stainless steel). The top ring body 3102 has a flat finished wafer-pressing surface so that the entire surface of the wafer can be pressed uniformly against the polishing surface. This wafer-pressing surface may be a slightly concave or convex surface depending on the type of wafer to be polished.

The guide ring 3104 has an inner diameter slightly larger than the diameter of the wafer so that the periphery of the wafer is retained by the guide ring 3104, and the wafer is inserted into the guide ring 3104. The top ring body 3102 has a plurality of through-holes 3108 which extend from the wafer-pressing surface to a surface opposite to the wafer-pressing surface. Clean air or nitrogen gas having positive pressure is supplied to the wafer-pressing surface through the through-holes 3108 so as to selectively and locally press certain areas of the wafer against the polishing surface. Further, negative pressure can be developed in the through-holes 3108 so as to attract the wafer. Thus, the wafer is attracted to and transferred by the top ring body 3102. Further, clean air or nitrogen gas is ejected toward the wafer through the through-holes 3108 so as to release the wafer from the top ring body 3102. Pure water mixed with the air or gas may be used to enhance a wafer releasing force in order to reliably release the wafer.

The top ring 301A has an attachment flange 3110 mounted on an upper surface thereof, and the attachment flange 3110 has a hemispherical hole defined centrally on an upper surface thereof. A drive flange 3114, fixed to a top ring drive shaft 3112, is disposed above the attachment flange 3110. The drive flange 3114 also has an identical hemispherical hole defined on a lower surface thereof. A hard ball 3116 made of, for example, ceramics is received in both the hemispherical holes, so that a downward pressing force applied to the drive flange 3114 is transmitted via the ball 3116 to the attachment flange 3110.

The top ring head 3100 is configured to support the top ring 301A via the top ring drive shaft 3112 comprising a spline shaft. The top ring head 3100 is supported by a swing shaft 3117. The swing shaft 3117 is rotated by a motor (not shown) coupled to a lower end of the swing shaft 3117 so as to allow the top ring head 3100 to swing. This swinging motion can move the top ring 301A to a polishing position, a maintenance position, and a wafer receiving/delivering position. A motor 3118 is provided above the swing shaft 3117 and on an upper surface of the top ring head 3100. This motor rotates a driving pulley 3120, fixed to an end of a shaft of the motor 3118, to thereby rotate a driven pulley 3122, fixed to a circumferential surface of the top ring drive shaft 3112, via a belt 3124. Rotation of the driven pulley 3122 rotates the top ring drive shaft 3112. Rotation of the top ring drive shaft 3112 is transmitted to the top ring 301A, whereby the top ring 301A rotates.

A cylinder 3126 is fixed to the upper surface of the top ring head 3100 such that a rod of the cylinder 3126 extends downwardly. The top ring head 3100 and the rod of the cylinder 3126 are flexibly coupled to one another. By controlling pressure of air supplied to the cylinder 3126, a force to elevate or lower the top ring drive shaft 3112, i.e., a force to press the top ring 301A against the polishing surface, can be controlled. A tensile/compressive load measuring device (load cell) 3128 is disposed between the cylinder 3126 and the top ring head 3100. This tensile/compressive load measuring device 3128 measures a vertical thrust force generated by the cylinder 3126. Since the thrust force is equal to the force to press a wafer, a feedback circuit may be provided utilizing the measured thrust force for the purpose of controlling the pressing force applied to the wafer. The body of the cylinder 3126 and the top ring drive shaft 3112, which is a spline shaft, are coupled to one another with the top ring drive shaft 3112 being rotatable. When the cylinder 3126 is operated in a vertical direction, the top ring drive shaft 3112 is simultaneously moved in a vertical direction. The top ring drive shaft 3112 has a through-hole defined therein with a tube (not shown) disposed in the through-hole. Since the top ring drive shaft 3112 and the top ring 301A are to rotate, a rotary joint 3130 is mounted on an upper end of the tube. Gas, such as vacuum, nitrogen gas, or clean air and/or a liquid, such as pure water, is supplied via the rotary joint 3130 to the top ring body 3102. The cylinder 3126 may be mounted directly on the spline shaft. In such a case, the load measuring device 3128 is mounted on a junction between the cylinder 3126 and the spline shaft.

The top ring 301A, having the above structure, attracts the wafer, which has been transported to the pusher 33, with vacuum suction, and holds the wafer within the guide ring 3104 of the top ring 301A. Thereafter, the top ring 301A is swung from a position above the pusher 33 to a position above the polishing surface on the polishing table 300A. After the top ring 301A is moved to the position above the polishing table 300A, the top ring 301A is rotated at a predetermined rotational speed and then lowered by the cylinder 3126 to bring the wafer into contact with the upper surface of the polishing table 300A. When the top ring 301A is lowered to the upper surface of the polishing table 300A, a sensor 3132 for detecting the lower end of the stroke of the cylinder 3126 generates a signal indicating that the downward movement of the cylinder 3126 is completed. Upon receiving the signal, the cylinder 3126 is supplied with air having pressure corresponding to a desired pressing load to thereby press the top ring 301A against the polishing table 300A, whereby the pressing force is applied to the wafer. At the same time, a vacuum line, which is for developing negative pressure to attract the wafer, is cut off. At this time, depending on a type of film to be polished on the wafer, negative pressure may remain or be cut off, or a valve may be operated to control the pressure of the gas so as to apply positive pressure to the wafer to control a polished profile of the wafer. This pressure is applied only to the through-holes 3108 defined in the wafer-pressing surface of the top ring 301A. Therefore, depending on areas of the wafer to which the pressure is to be applied, the diameters, number, and positions of the through-holes 3108 are changed so as to achieve a desired polished profile.

After the desired polishing process is completed (the completion of the polishing process is controlled based on a period of time or a film thickness), the top ring 301A attracts the wafer with vacuum suction. The top ring 301A is swung with the wafer kept in contact with the polishing cloth to a position where about 40% of the surface of the wafer projects from the periphery of the polishing table 300A while the center of the wafer is located on the polishing table 300A and located near the periphery of the polishing table 300A as close as possible. Thereafter, the cylinder 3126 is operated to elevate the top ring 301A holding the wafer. Depending on the polishing cloth, a surface tension between slurry on the polishing pad and the wafer may be stronger than the suction force of the top ring. In such a case, the wafer may be left on the polishing cloth when the top ring is elevated from the polishing cloth. In order to reduce such a surface tension, the wafer is moved so as to project from the polishing table, and then the top ring 301A is elevated. If not less than 40% of the surface area of the wafer projects from the polishing table, then the top ring would be tilted to cause the wafer to hit the edge of the polishing table 300A and the wafer would be cracked. Therefore, it is desirable that about 40% of the surface area of the wafer projects from the polishing table. In other words, it is important that the center of the wafer is located on the polishing table 300A.

When elevation of the top ring 301A is completed, a sensor 3134 for detecting an upper stroke end point of the cylinder 3126 is operated to detect the completion of the elevating action. Thereafter, the top ring 301A is swung to a position above the pusher 33, and transfers the wafer to the pusher 33. After the wafer is transferred to the pusher 33, a cleaning liquid is ejected downwardly, horizontally, or upwardly toward the top ring 301A to clean the wafer-holding surface of the top ring 301A, the polished wafer, and surrounding portions thereof. Supply of the cleaning liquid may be continued until the next wafer is transferred to the top ring 301A so as to prevent the top ring from being dried. Cleaning water may be intermittently ejected for the purpose of reducing a running cost. When the wafer is being polished, a polishing time may be divided into a plurality of steps, and the pressing force and rotational speed of the top ring and a manner of holding the wafer may be changed in each of the steps. It is also possible to change a type, an amount, a concentration, and a temperature of the polishing liquid to be used, and to change a timing of supplying the polishing liquid.

A current, supplied to the motor for rotating the top ring, may be monitored during the polishing process, so that a torque of the motor can be calculated based on the monitored current. When polishing of a wafer reaches an end point, friction between the wafer and the polishing cloth is changed. Therefore, an end point of polishing of the wafer may be detected based on a change in torque of the motor. Similarly, the current supplied to the motor for rotating the polishing table 300A may be monitored, and a change in torque may be calculated based on the monitored current so as to detect an end point of polishing of the wafer. Further, vibrations of the top ring may be measured during polishing so as to detect an end point of polishing of the wafer based on detected inflection points of a vibration waveform. Furthermore, an electrostatic capacitance may be measured so as to detect an end point of the polishing process. Each of these four types of detection is a method of detecting the polishing end point based on differences in surface irregularities or type of films between before and after polishing, or based on the thickness of the remaining film. After the surface of the polished wafer is cleaned, the polishing amount may.be measured to determine if polishing is insufficient. In a case of insufficient polishing, the wafer may be polished again.

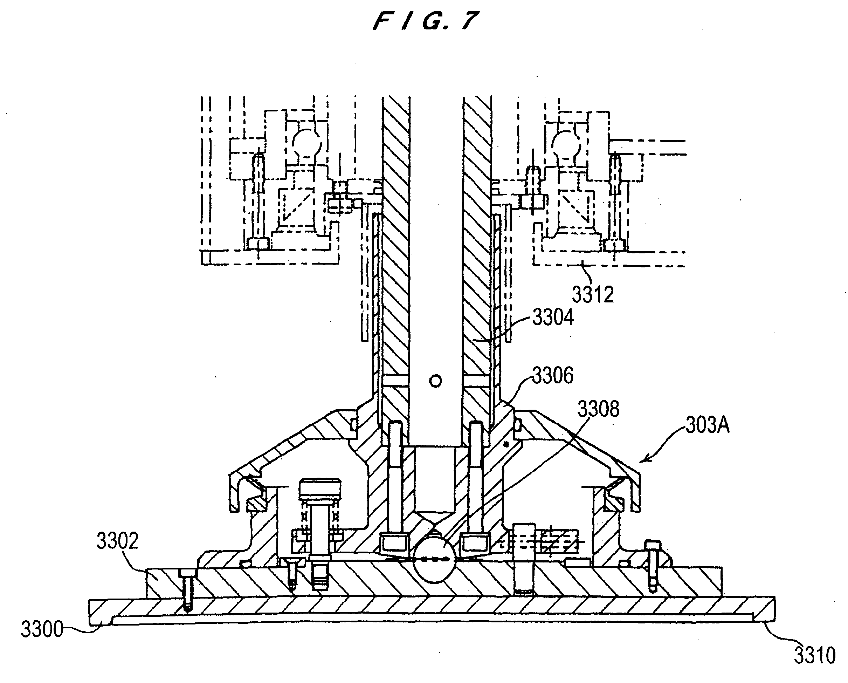

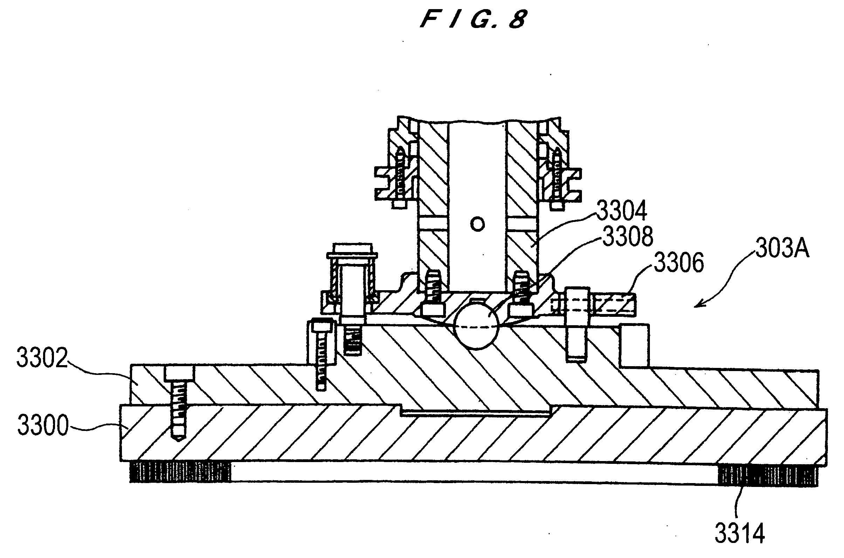

FIGS. 7 and 8 are vertical cross-sectional views each showing the dresser 303A. FIG. 7 shows a diamond dresser, and FIG. 8 shows a brush dresser. As shown in FIG. 7, the dresser 303A has a dresser plate 3300 having a dressing surface for dressing the polishing cloth. The dresser plate 3300 is fixed to an attachment flange 3302 having a hemispherical hole defined centrally on an upper surface thereof. A drive flange 3306, fixed to a dresser drive shaft 3304, is disposed above the attachment flange 3302. The drive flange 3306 also has an identical hemispherical hole. A hard ball 3308 made of, for example, ceramics is received in both the hemispherical holes. A downward pressing force applied to the drive flange 3306 is transmitted via the ball 3308 to the dresser plate 3300. Diamond particles 3310 for conditioning a shape of the polishing pad and dressing the polishing pad are electrodeposited on a lower surface of the dresser plate 3300. Alternatively, a number of hard protrusions of, for example, ceramics may be provided on the dresser plate 3300 instead of the diamond particles. The diamond particles or hard protrusions can be replaced merely by replacing the dresser plate 3300 so as to readily perform other types of dressing processes. In either case, because a surface configuration of the dresser plate 3300 reflects a surface configuration of the polishing pad to be dressed, the dressing surface of the dresser is finished to a flat surface.

The dresser drive shaft 3304 is supported by a dresser head 3312. The dresser head 3312 has basically the same function as the top ring head 3100. Specifically, the dresser drive shaft 3304 is rotated by a motor and vertically moved by a cylinder. The details of the structure of the dresser head 3312 are substantially the same as those of the top ring head 3100, and are thus not further illustrated in the drawings.

FIG. 8 shows a brush dresser having a brush 3314, instead of the diamond particles 3310, mounted on the lower surface of the dresser plate 3300. Other structural details of the brush dresser are substantially the same as those of the diamond dresser shown in FIG. 7.

With this structure, a shape of the polishing cloth is conditioned or the polishing cloth is dressed as follows. The dresser 303A is swung from a cleaning position to a position above a dressing position on the polishing table 300A. After the swing motion is completed, the dresser 303A is rotated at a predetermined rotational speed, and the cylinder for elevating and lowering the dresser is operated to lower the dresser 303A. When the dresser 303A is brought into contact with the upper surface of the polishing table 300A, a sensor on the cylinder detects a lower stroke end of the cylinder and generates a signal indicating that the dresser 303A has touched the polishing table 300A. Upon receiving the signal, the cylinder applies a pressing force to the dresser 303A to thereby dress the polishing pad on the polishing table 300A at a desired pressing force. After the dresser 303A has dressed the polishing cloth for a desired period of time, the cylinder is operated to elevate the dresser 303A away from the polishing table 300A. Thereafter, the dresser 303A is moved to the cleaning position, where the dresser 303A is immersed in water retained in a cleaning container (not shown), whereby the dresser is cleaned. The dresser may be cleaned by being immersed in water stored in a vessel, by a spray ejected from a spray nozzle, or by being rotated and pressed against a brush provided on a bottom of the water vessel. An ultrasonic element may be provided in the vessel so as to clean the dresser by vibrational energy of the ultrasonic element.

Further, the first polishing unit 30A has, in addition to the mechanical dresser 303A, an atomizer 304A as a non-contact type dresser using fluid pressure. This atomizer mainly serves to wash away polishing wastes and slurry particles which have been accumulated and stuck on the polishing surface. A combination of cleaning of the polishing surface by the atomizer using fluid pressure and dressing of the polishing surface by the dresser 303A using a mechanical contact can achieve more desirable dressing, i.e., can regenerate the polishing surface more effectively. Conditioning of the polishing surface by the atomizer is usually performed after dressing by a contact type dresser (e.g. diamond dresser).

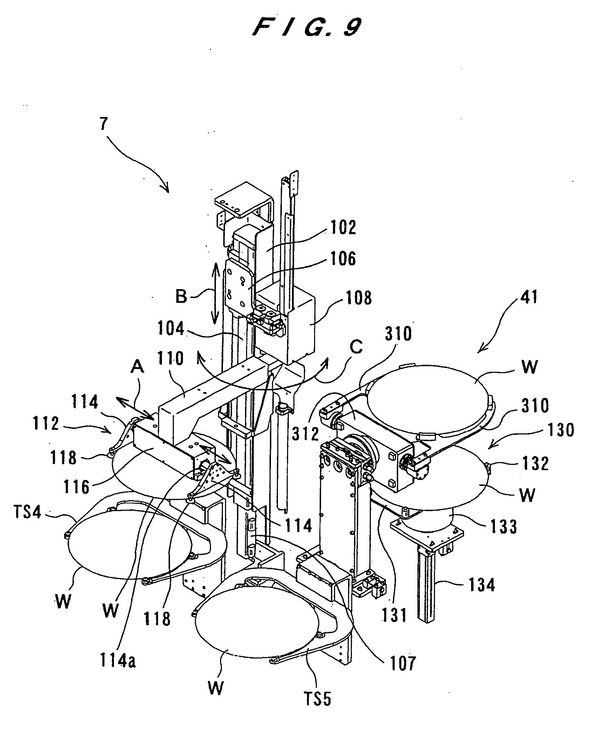

Next, the swing transporter 7 will be described. FIG. 9 is a perspective view showing the swing transporter 7 and the reversing machine 41 in the cleaning section 4. As shown in FIG. 9, the swing transporter 7 according to the present embodiment is installed on a frame 102 of a casing of the first polishing section 3a. This swing transporter 7 comprises a robot cylinder 104 provided in the vertically extending frame 102 having a U-shaped cross section, a base bracket 106 adapted to vertically move on the robot cylinder 104, a motor 107 for vertically moving the robot cylinder 104, a motor cover 108 attached to the base bracket 106, a swing arm 110 connected to a rotational shaft of a motor housed in the motor cover 108, and a wafer clamp mechanism 112 provided on a tip end of the swing arm 110.

The wafer clamp mechanism 112 comprises a pair of clamp members 114 configured to clamp a periphery of a wafer W from both sides of the wafer W, and an opening-closing mechanism 116 operable to extend and contract a rod 114a of the clamp members 114 in a radial direction (indicated by arrow A) of the wafer W. The clamp members 114 are arranged symmetrically about a center of the wafer W so as to face one another. Each of the clamp members 114 has two circular pieces (chucking mechanisms) 118 on both end portions thereof. These circular pieces 118 are to be brought into point contact with the periphery of the wafer W. The circular pieces 118 extend downwardly from the both end portions of the clamp member 114.

The opening-closing mechanism 116 is composed of, for example, an air cylinder. This opening-closing mechanism 116 is operable to move the clamp members 114 toward one another to thereby allow the clamp members 114 to hold the wafer W, and to move the clamp members 114 away from one another to thereby allow the clamp members 114 to release the wafer W. In this embodiment, two circular pieces 118 are provided on each of the clamp members 114. However, the present invention is not limited to this arrangement. For example, three or more circular pieces 118 may be provided on each of the clamp members 114.

As described above, since the wafer clamp mechanism 112 of the swing transporter 7 according to this embodiment is such that one pair of clamp members 114 are linearly moved in directions opposite to one another to clamp and release the wafer W, the wafer clamp mechanism 112 can reliably hold the wafer W. More specifically, just by changing a stroke of the opening-closing mechanism 116, the wafer clamp mechanism 112 can hold wafers W of various sizes without changing its structure. Further, because the circular pieces 118 are provided so as to extend downwardly from the both end portions of each of the clamp members 114, no component, other than the circular pieces 118, is located below the wafer W. This arrangement does not cause a liquid on upper surfaces of robot hands to touch a lower surface of a wafer, unlike a conventional wafer transfer mechanism.

A ball screw and a slide guide are provided in the robot cylinder 104, so that the base bracket 106 on the robot cylinder 104 is moved vertically (indicated by arrow B) by the motor 107. With this arrangement, the wafer clamp mechanism 112 is vertically moved together with the base bracket 106. The robot cylinder 104 and the base bracket 106 constitute a vertically moving mechanism for vertically moving the wafer clamp mechanism 112 along the frame 102.

The swing arm 110 is driven by the motor in the motor cover 108 so as to swing about a rotational shaft of the motor (in a direction indicated by arrow C). Therefore, the wafer clamp mechanism 112 is moved between the first linear transporter 5, the second linear transporter 6, and the reversing machine 41 of the cleaning section 4. The motor in the motor cover 108 and the swing arm 110 constitute a swing mechanism for swinging the wafer clamp mechanism 112 about the rotational shaft of the motor 108 located next to the frame 102. Although this embodiment employs the structure such that the wafer clamp mechanism 112 swings about the rotational shaft of the motor in the motor cover 108 located next to the frame 102, the present invention is not limited to this structure. For example, the wafer clamp mechanism 112 may swing about the frame 102.

Clamp of the wafer W is performed as follows. With the clamp members 114 opened, the base bracket 106 is lowered until the circular pieces 118 on the clamp members 114 are positioned below the wafer W. Then, the opening-closing mechanism 116 moves the clamp members 114 in directions toward one another until innermost circumferential portions of the circular pieces 118 are positioned inwardly of the periphery of the wafer W. In this state, the base bracket 106 is moved upwardly to thereby elevate the wafer W with the circular pieces 118 clamping the wafer W. In this embodiment, because the circular pieces 118 and the wafer W are brought into point contact with one another, a contact area of the wafer W can be minimized. As a result, an amount of unwanted particles, attached to the surface of the wafer W upon wafer clamping, can be reduced.

The swing transporter 7 according to this embodiment does not require arms to extend and contract like a conventional transfer robot. Instead, because the swing transporter 7 is composed of the vertically moving mechanism, the swing mechanism, and the wafer clamp mechanism, the structure of the wafer transfer mechanism can be simple, and operations thereof require a small force. As a result, the wafer can be quickly transferred. Further, because the frame of the processing section, such as the polishing section, is used to constitute the swing transporter 7, a space for allowing the arms to extend and contract is not required. Therefore, the wafer transfer mechanism can be small, and thus requires a small installation area. Furthermore, because the swing transporter 7 is fixed to the frame of the processing section, stiffness of the swing transporter 7 is enhanced.

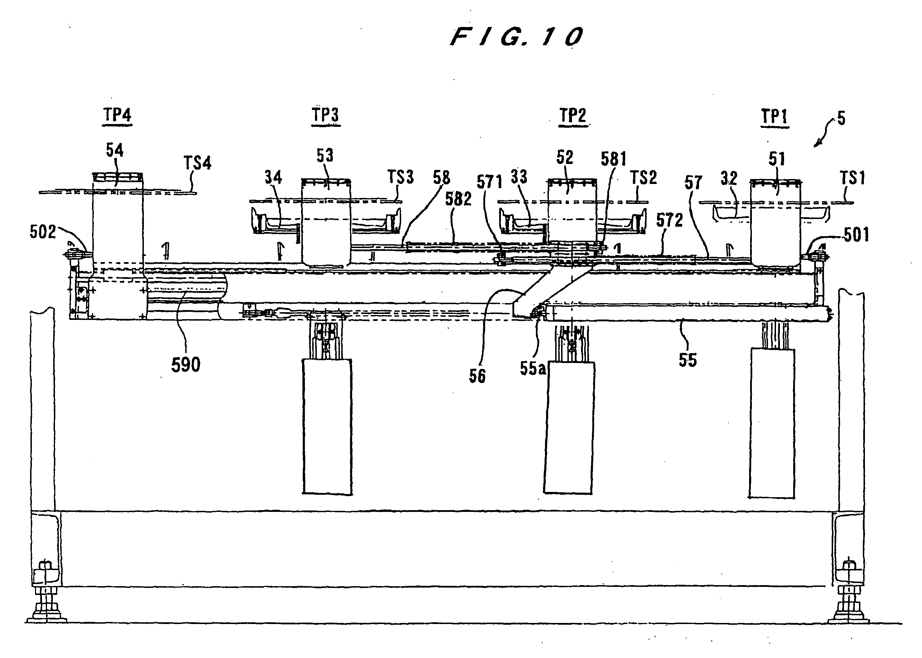

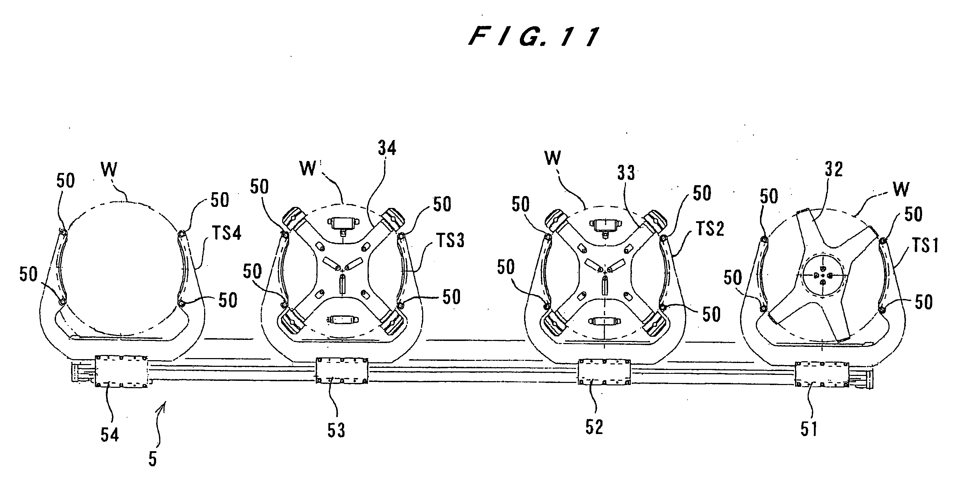

The first linear transporter 5 in the first polishing section 3a will be described below. FIG. 10 is a front view of the first linear transporter 5, and FIG. 11 is a plan view of FIG. 10. As shown in FIGS. 10 and 11, the first linear transporter 5 has four transfer stages TS1, TS2, TS3, and TS4, which are linearly movable in a reciprocating manner. These transfer stages have a two-line structure including an upper line and a lower line. Specifically, the first transfer stage TS 1, the second transfer stage TS2, and the third transfer stage TS3 are disposed on the lower line, and the fourth transfer stage TS4 is disposed on the upper line.

Although the lower transfer stages TS1, TS2, and TS3 and the upper transfer stage TS4 move on the same axis in the plan view shown in FIG. 11, the lower transfer stages TS1, TS2, and TS3 and the upper transfer stage TS4 can freely move without interfering with each other because they are provided at different heights. The first transfer stage TS1 transfers a wafer between the first transferring position TP1, at which the reversing machine 31 and the lifter 32 are disposed, and the second transferring position (i.e., wafer receiving/delivering position) TP2 at which the pusher 33 is disposed. The second transfer stage TS2 transfers a wafer between the second transferring position TP2 and the third transferring position (i.e., wafer receiving/delivering position) TP3 at which the pusher 34 is disposed. The third transfer stage TS3 transfers a wafer between the third transferring position TP3 and the fourth transferring position TP4. The fourth transfer stage TS4 transfers a wafer between the first transferring position TP1 and the fourth transferring position TP4.

As shown in FIG. 11, each of the transfer stages TS 1, TS2, TS3, and TS4 has four pins 50 fixed thereto, and a wafer is supported on the transfer stage with a periphery of the wafer guided and positioned by the pins 50. The pins 50 are made of resin, such as polypropylene (PP), polychlorotrifluoroethylene (PCTFE) or polyetheretherketone (PEEK). Each of the transfer stages has a sensor (not shown), such as a transmission type sensor, for detecting the presence of a wafer on the transfer stage.

The transfer stages TS 1, TS2, TS3, and TS4 are supported by support members 51, 52, 53, and 54, respectively. As shown in FIG. 10, a connection member 56, connected to a rod 55a of an air cylinder (driving mechanism) 55, is mounted on a lower portion of the support member 52 of the second transfer stage TS2 (driving transfer stage). A shaft 57 and a shaft 58 extend through the support member 52 of the second transfer stage TS2. One end of the shaft 57 is connected to the support member 51 of the first transfer stage TS1 (driven transfer stage), and another is provided with a stopper 571. One end of the shaft 58 is connected to the support member 53 of the third transfer stage TS3 (driven transfer stage), and another is provided with a stopper 581. A spring 572 is provided on the shaft 57 at a position between the support member 51 of the first transfer stage TS 1 and the support member 52 of the second transfer stage TS2. Similarly, a spring 582 is provided on the shaft 58 at a position between the support member 52 of the second transfer stage TS2 and the support member 53 of the third transfer stage TS3. Mechanical stoppers 501 and 502, which are to come into contact with the support member 51 of the first transfer stage TS1 and the support member 53 of the third transfer stage TS3, respectively, are provided at both ends of the first linear transporter 5.

When the air cylinder 55 is operated so as to extend and contract the rod 55a, the connection member 56 connected to the rod 55a is moved, so that the second transfer stage TS2 is moved together with the connection member 56. Since the support member 51 of the first transfer stage TS1 is coupled to the support member 52 of the second transfer stage TS2 via the shaft 57 and the spring 572, the first transfer stage TS1 is also moved together with the second transfer stage TS2. Further, since the support member 53 of the third transfer stage TS3 is coupled to the support member 52 of the second transfer stage TS2 via the shaft 58 and the spring 582, the third transfer stage TS3 is moved together with the second transfer stage TS2. Thus, the first transfer stage TS1, the second transfer stage TS2, and the third transfer stage TS3 are simultaneously moved together with each other forward and backward along a linear line by operation of the air cylinder 55.

When the first transfer stage TS1 is about to move across the first transferring position TP1, the mechanical stopper 501 restricts movement of the support member 51 of the first transfer stage TS 1, and the spring 571 absorbs further movement of the first transfer stage TS1, so that the first transfer stage TS1 cannot move across the first transferring position TP1. Therefore, the first transfer stage TS1 is accurately positioned at the first transferring position TP1. Similarly, when the third transfer stage TS3 is about to move across the fourth transferring position TP4, the mechanical stopper 502 restricts movement of the support member 53 of the third transfer stage TS3, and the spring 582 absorbs further movement of the third transfer stage TS3, so that the third transfer stage TS3 cannot move across the fourth transferring position TP4. Therefore, the third transfer stage TS3 is accurately positioned at the fourth transferring position TP4.

In a case where the respective transfer stages have different strokes of movement, the movement of the respective transfer stages can be controlled by air cylinders provided in the respective transfer stages. However, such air cylinders cause the apparatus to be large in size. In the present embodiment, the air cylinder 55 has the stroke equal to the longest movement distance of the transfer stage, and the springs 572 and 582 absorb excessive strokes of the other transfer stages. Therefore, even if the transfer stages TS 1, TS2, and TS3 have different strokes, these three transfer stages TS1, TS2, and TS3 can simultaneously be moved by the single air cylinder 55.

The first linear transporter 5 has an air cylinder 590 for linearly moving the fourth transfer stage TS4 on the upper line in a reciprocating manner. The fourth transfer stage TS4 is controlled by the air cylinder 590 so as to move simultaneously with the lower transfer stages TS1, TS2, and TS3 in a direction opposite to the movement direction of the transfer stages TS1, TS2, and TS3. The shutter 12 is opened only when the third transfer stage TS3 or the fourth transfer stage TS4 is moved from the fourth transferring position TP4 or the fourth transferring position TP4 to the third transferring position TP3. Therefore, a minimal amount of gas can flow from the polishing section 3a in a dirty environment to the cleaning section 4 in a clean environment. Accordingly, contamination of the wafer and the cleaning section 4, which performs cleaning and drying of the wafer, can be prevented, and throughput is increased compared with the conventional polishing apparatus.

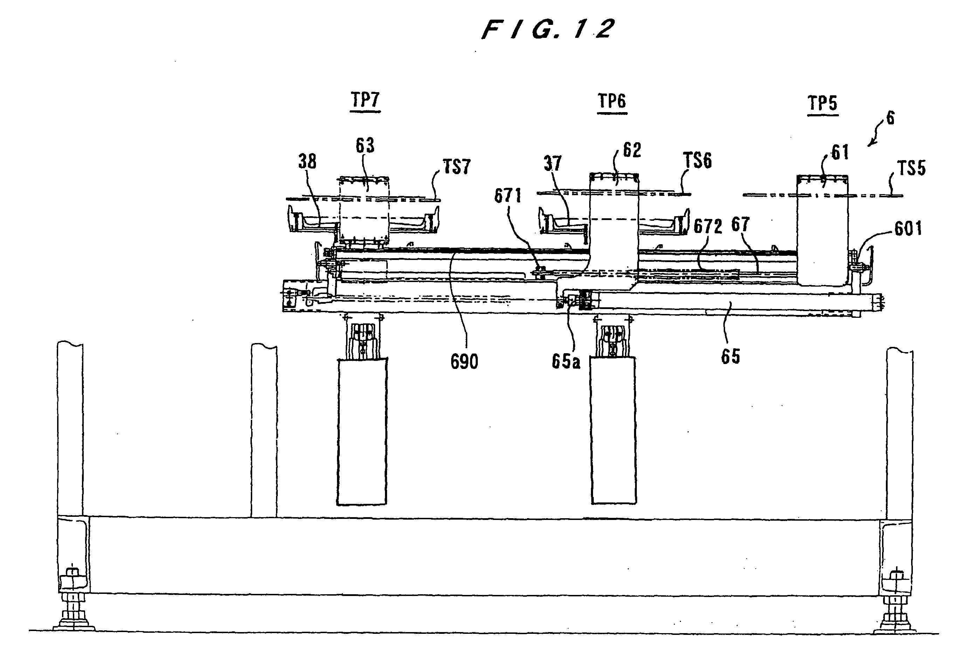

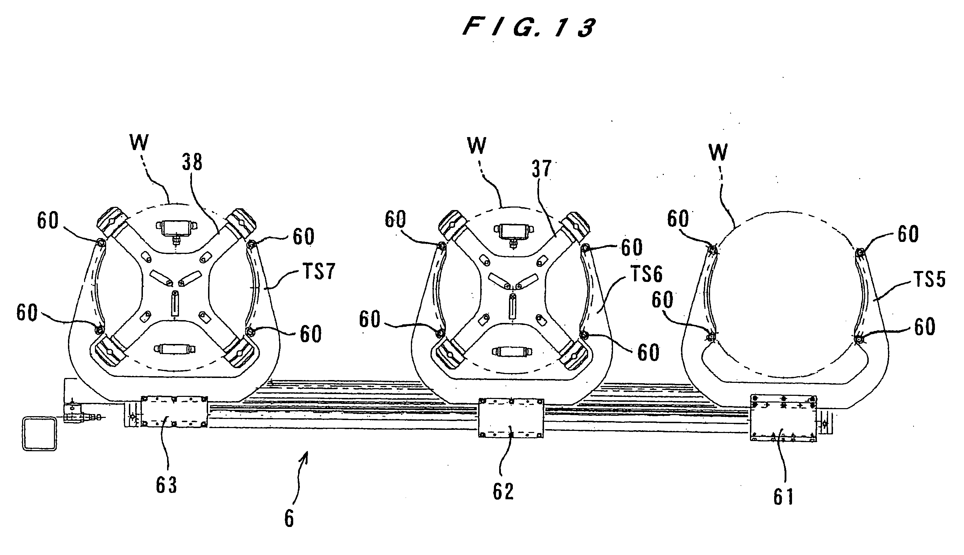

The second linear transporter 6 in the second polishing section 3b will be described below. FIG. 12 is a front view showing the second linear transporter 6, and FIG. 13 is a plan view of FIG. 12. As shown in FIGS. 12 and 13, the second linear transporter 6 has three transfer stages TS5, TS6, and TS7, which are linearly movable in a reciprocating manner. These transfer stages have a two-line structure including an upper line and a lower line. Specifically, the fifth transfer stage TS5 and the sixth transfer stage TS6 are disposed on the upper line, and the seventh transfer stage TS7 is disposed on the lower line.

Although the upper transfer stages TS5 and TS6 and the lower transfer stage TS7 move on the same axis in the plan view shown in FIG. 13, the upper transfer stages TS5 and TS6 and the lower transfer stage TS7 can freely move without interfering with each other because they are provided at different heights. The fifth transfer stage TS5 transfers a wafer between the fifth transferring position TP5 and the sixth transferring position (i.e., wafer receiving/delivering position) TP6 at which the pusher 37 is disposed. The sixth transfer stage TS6 transfers a wafer between the sixth transferring position TP6 and the seventh transferring position (i.e., wafer receiving/delivering position) TP7 at which the pusher 38 is disposed. The seventh transfer stage TS7 transfers a wafer between the fifth transferring position TP5 and the seventh transferring position TP7.

As shown in FIG. 13, each of the transfer stages TS5, TS6, and TS7 has four pins 60 fixed thereto, and a wafer is supported on the transfer stage with a periphery of the wafer guided and positioned by the pins 60. The pins 60 are made of resin, such as polypropylene (PP), polychlorotrifluoroethylene (PCTFE) or polyetheretherketone (PEEK). Each of the transfer stages has a sensor (not shown), such as a transmission type sensor, for detecting the presence of a wafer on the transfer stage.

The transfer stages TS5, TS6, and TS7 are supported by support members 61, 62, and 63, respectively. As shown in FIG. 12, a rod 65a of an air cylinder (driving mechanism) 65 is connected to a lower portion of the support member 62 of the sixth transfer stage TS6 (driving transfer stage). A shaft 67 extends through the support member 62 of the sixth transfer stage TS6. One end of the shaft 67 is connected to the support member 61 of the fifth transfer stage TS5 (driven transfer stage), and another is provided with a stopper 671. A spring 672 is provided on the shaft 67 at a position between the support member 61 of the fifth transfer stage TS5 and the support member 62 of the sixth transfer stage TS6. Mechanical stopper 601, which is to come into contact with the support member 61 of the fifth transfer stage TS5, is provided at an end of the second linear transporter 6 so as to face the fifth transfer stage TS5.

When the air cylinder 65 is operated to extend and contract the rod 65a, the sixth transfer stage TS6, connected to the rod 65a, is moved. Since the support member 61 of the fifth transfer stage TS5 is coupled to the support member 62 of the sixth transfer stage TS6 via the shaft 67 and the spring 672, the fifth transfer stage TS5 is also moved' together with the sixth transfer stage TS6. Thus, the fifth transfer stage TS5 and the sixth transfer stage TS6 are linearly moved integrally and simultaneously in a reciprocating manner by operation of the air cylinder 65.

When the fifth transfer stage TS5 is about to move across the fifth transferring position TP5, the mechanical stopper 601 restricts movement of the support member 61 of the fifth transfer stage TS5, and the spring 672 absorbs further movement of the fifth transfer stage TS5, so that the fifth transfer stage TS5 cannot move across the fifth transferring position TP5. Therefore, the fifth transfer stage TS5 is accurately positioned at the fifth transferring position TP5. Thus, in the second linear transporter 6, as with the first linear transporter 5, two transfer stages TS5 and TS6 can simultaneously be moved by the single air cylinder 65.

The second linear transporter 6 has an air cylinder 690 for linearly moving the seventh transfer stage TS7 on the lower line in a reciprocating manner. The seventh transfer stage TS7 is controlled by the air cylinder 690 so as to move simultaneously with the upper transfer stages TS5 and TS6 in a direction opposite to the movement direction of the transfer stages TS5 and TS6. The shutter 13 is opened only when the fifth transfer stage TS5 or the seventh transfer stage TS7 is moved from the fifth transferring position TP5 or the fifth transferring position TP5 to the sixth transferring position TP6. Therefore, a minimal amount of gas can flow from the polishing section 3a in a dirty environment to the cleaning section 4 in a clean environment. Accordingly, contamination of the wafer and the cleaning section 4, which performs cleaning and drying of the wafer, can be prevented, and throughput is increased compared with the conventional polishing apparatus.

Although the linear transporters 5 and 6 are actuated by the air cylinders 55, 590, 65, and 690, they may be actuated by, for example, motors using ball screws.

Next, the reversing machine 31 in the first polishing section 3a will be described below. The reversing machine 31 in the first polishing section 3a is disposed in a position such that a hand of the transfer robot 22 in the loading/unloading section 2 can access. This reversing machine 31 is operable to receive a non-polished wafer from the transfer robot 22, turn the wafer upside down, and deliver the wafer to the lifter 32.

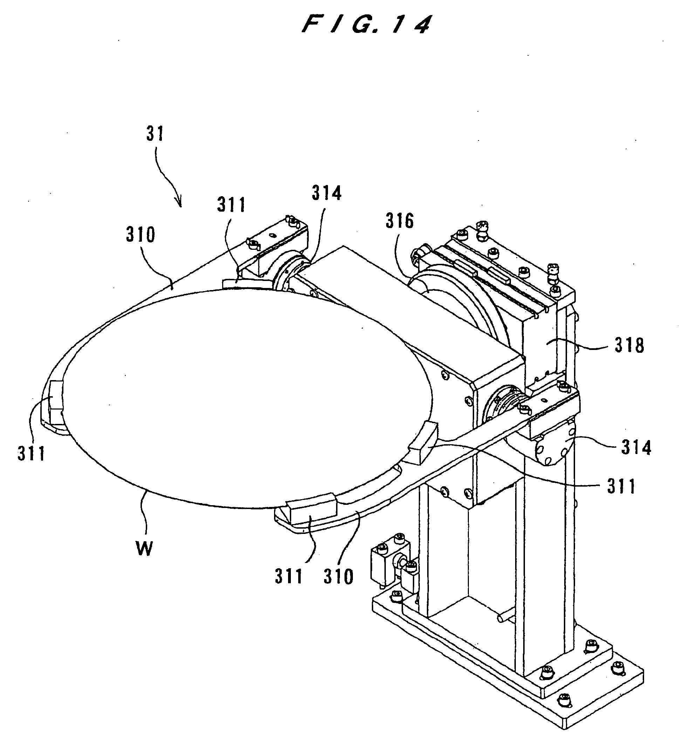

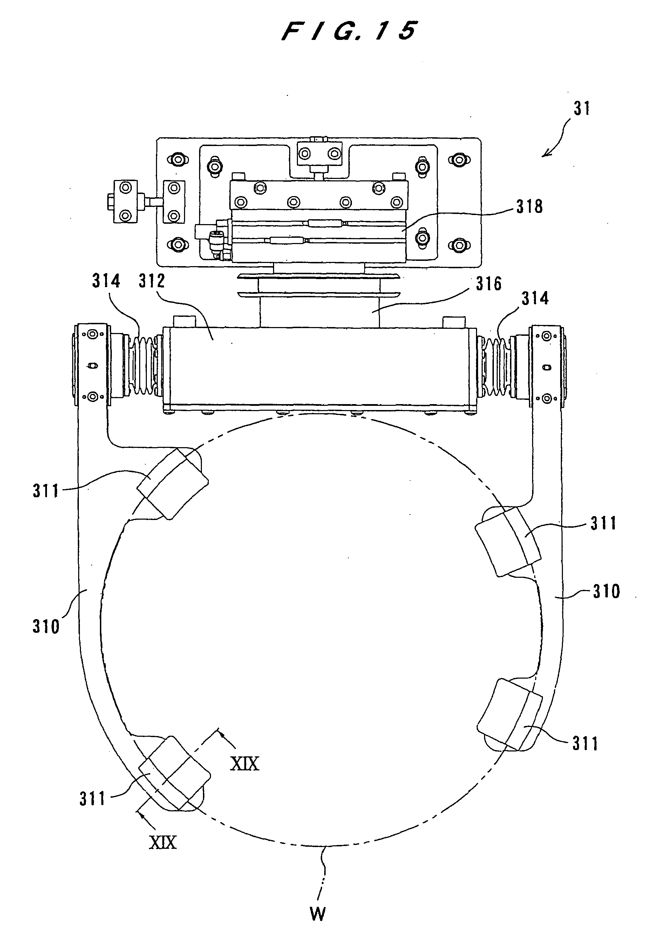

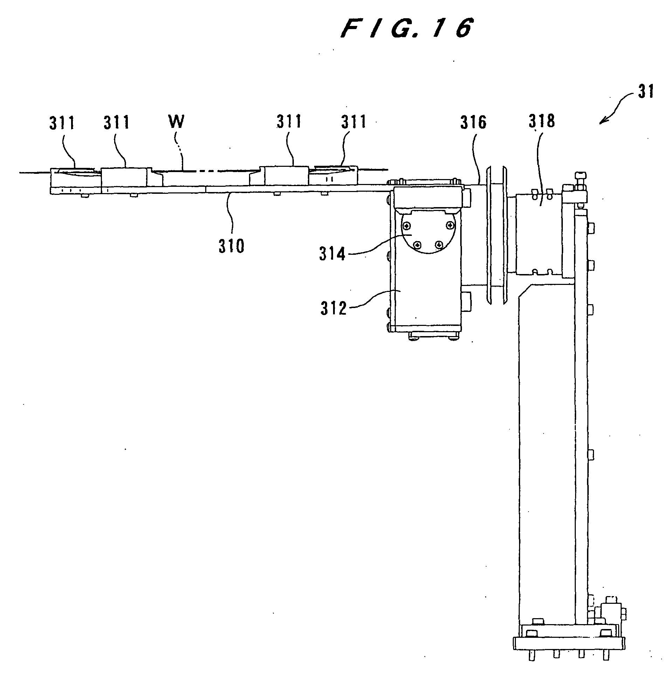

FIG. 14 is a perspective view showing the reversing machine 31, FIG. 15 is a plan view of FIG. 14, and FIG. 16 is a side view of FIG. 14. As shown in FIGS. 14 through 16, the reversing machine 31 comprises a pair of circular arc holding members 310 configured to clamp a periphery of a wafer W from both sides of the wafer W, shafts 314 connected to the holding members 310, and an opening-closing mechanism 312 for moving the shafts 314 in axial directions thereof to thereby open and close the holding members 310. The holding members 310 are arranged symmetrically about a center of the wafer W so as to face one another. Each of the holding members 310 has two chucking members 311 on both end portions thereof. These chucking members 311 are to be brought into line contact with the periphery of the wafer W. In this embodiment, two chucking members 311 are provided on each of the holding members 310. However, the present invention is not limited to this arrangement. For example, three or more chucking members 311 may be provided on each of the holding members 310.

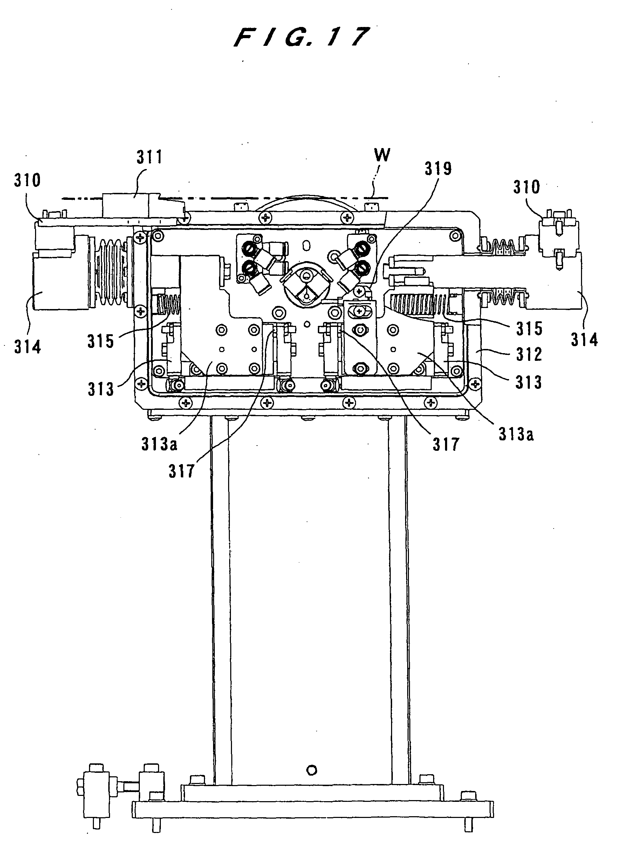

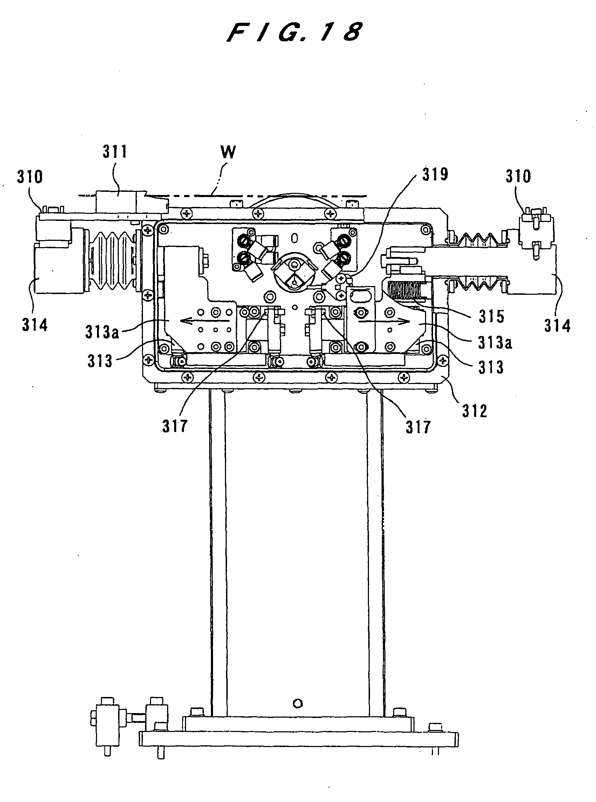

FIG. 17 is a vertical cross-sectional view showing the opening-closing mechanism 312 of the reversing machine 31. As shown in FIG. 17, the opening-closing mechanism 312 comprises compression springs 315 configured to push the shafts 314 and the holding members 310 in closing directions, and slide-type air cylinders 313 connected respectively to the shafts 314. This opening-closing mechanism 312 is operated such that the compression springs 315 move the holding members 310 in directions toward one another, whereby the holding members 310 hold the wafer W. When holding the wafer W, movable members 313a of the air cylinders 313 are brought into contact with mechanical stoppers 317. Further, the opening-closing mechanism 312 is operated such that the air cylinders 313 move the holding members 310 in directions away from one another, whereby the holding members 310 release the wafer W. FIG. 18 shows this state.

More specifically, when holding the wafer W, one of the air cylinders 313 is pressurized, and another is closed only by the force of the compression spring 315. In this state, only the movable member 313a of the pressurized air cylinder 313 is pressed against the mechanical stopper 317, and is thus fixed in position. At this time, a position of the holding member 310 connected to another air cylinder 313, biased by the compression spring 315, is detected by a sensor 319. In a case of no wafer W, the non-pressurized air cylinder 313 is in its full-stroke position. In this position, the sensor 319 shows no response, and hence it is determined that the wafer W is not held.

As described above, use of the compression springs 315 for holding the wafer W and use of the air cylinders 313 for releasing the wafer W can prevent the wafer W from being damaged by air pressure of the air cylinders 313.

As shown in FIGS. 14 through 16, the opening-closing mechanism 312 is connected to a rotational shaft 316 rotatable about an axis perpendicular to a central axis of the wafer W. This rotational shaft 316 is coupled to a reversing mechanism 318, so that the rotational shaft 316 is rotated by the reversing mechanism 318. With this arrangement, when the reversing mechanism 318 rotates the opening-closing mechanism 312 and the holding members 310 about the rotational shaft 316, the wafer W, held by the holding members 310, is turned upside down.

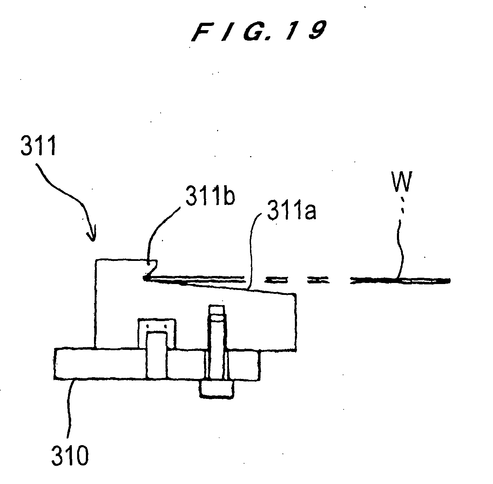

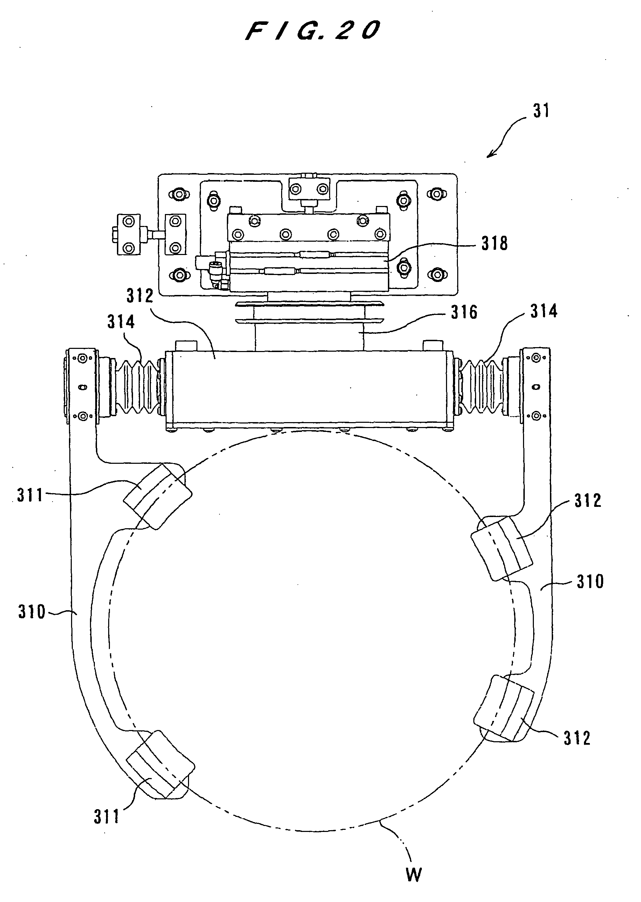

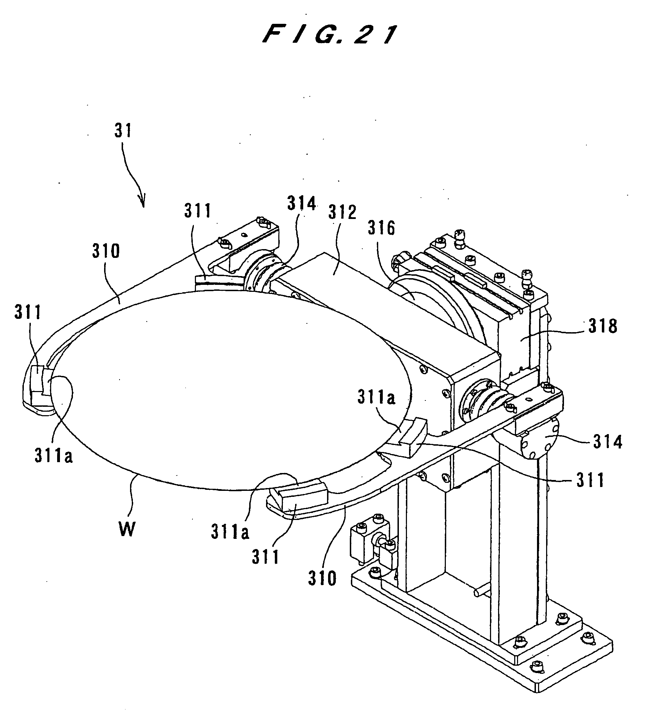

FIG. 19 is a cross-sectional view taken along line XIX-XIX shown in FIG. 15. As shown in FIG. 19, the chucking member 311 of the reversing machine 31 has a slope (lower projection) 311a which is gradually inclined with an upward gradient toward the periphery of the wafer W, and a projection (an upper projection) 311b provided at an outermost periphery of the slope 311a. These slope 311a and the projection 311b form a groove for holding the periphery of the wafer W. Further, the slope 311 a and the projection 311b are used in receiving/delivering and positioning the wafer W. More specifically, when receiving the wafer W from the transfer robot 22, as shown in FIG. 20, the opening-closing mechanism 312 is operated so as to move the holding members 310 in the directions away from one another to open the holding members 310. In this state, the transfer robot 22 releases the wafer W, and the periphery of the wafer W is placed onto the slopes 311a of the chucking members 311 (see FIG. 21). After the wafer W is placed on the slopes 311a, the opening-closing mechanism 312 is operated so as to move the holding members 310 in the directions toward one another to thereby close the holding members 310. When the holding members 310 are being closed, the periphery of the wafer W slides on the slopes 311a until the wafer W is positioned by the projections 311b at the outermost periphery of the slopes 311a. FIGS. 14 and 15 show a state in which the wafer has been positioned in this manner.

As described above, the reversing machine 31 according to this embodiment can perform positioning of the wafer W using the slopes 311a and the projections 31 1b of the holding members 310. Therefore, when the transfer robot 22 transfers the wafer W to the reversing machine 31, the transfer robot 22 is not required to perform positioning of the wafer W. More specifically, when the transfer robot 22 reaches a position above the reversing machine 3 1, the transfer robot 22 just releases the wafer W to the reversing machine 31 without performing positioning of the wafer W. Accordingly, after releasing the wafer W, the transfer robot 22 can quickly move on to the next operation. As a result, the transfer robot 22 requires less time for transferring the wafer W, and hence a throughput is increased.

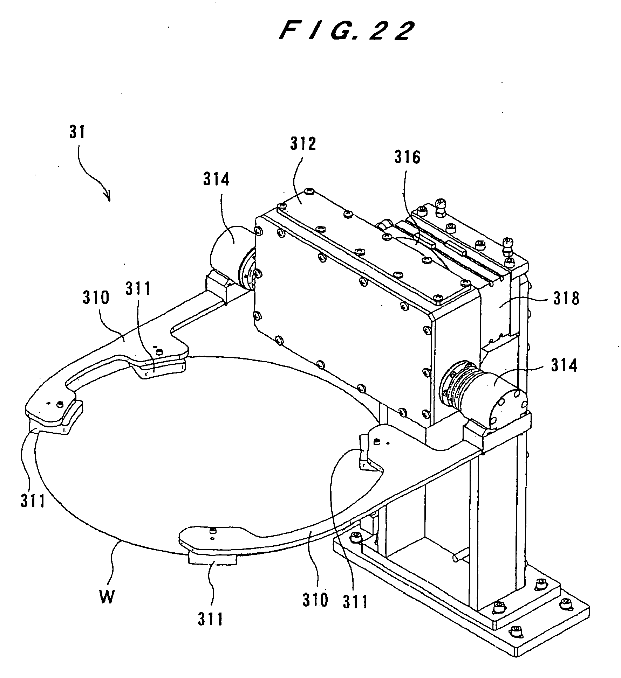

After the wafer W is held by the reversing machine 31 in this manner, the reversing mechanism 318 is operated such that the opening-closing mechanism 312 and the holding members 310 rotate about the rotational shaft 316 as shown in FIG. 22, whereby the wafer W is turned through 180 degrees. After the wafer W is turned, the opening-closing mechanism 312 is operated so as to move the holding members 310 in the directions away from one another, whereby the wafer W is transferred from the reversing machine 31 to the lifter 32.

Furthermore, as described above, the reversing machine 31 according to this embodiment is operable such that the pair of holding members 310 linearly move in the directions opposite to one another. Therefore, the holding members 310 can reliably hold the wafer W. More specifically, just by changing a stroke of the opening-closing mechanism 312, the reversing machine 31 can hold wafers W of various sizes without changing its structure.

As shown in FIG. 1, a shutter 10 is disposed between the reversing machine 31 and the transfer robot 22. When transferring the wafer, the shutter 10 is opened, and the wafer is delivered between the transfer robot 22 and the reversing machine 31. When the wafer is not transferred, the shutter 10 is closed. The shutter 10 has a waterproof mechanism, so that the wafer and the chucking members 311 fixed to the holding members 310 can be cleaned. Nozzles (not shown) may be provided around the reversing machine 31 for preventing the wafer from being dried. If the wafer stays in the reversing machine 31 for a long period of time, pure water is ejected from the nozzles so as to prevent the wafer from being dried.

The reversing machine 41 of the cleaning section 4 is disposed in a position such that the clamp members 114 of the swing transporter 7 can reach. This reversing machine 41 serves to receive a polished wafer from the clamp members 114 of the swing transporter 7, invert the wafer, and deliver the wafer to the transfer unit 46. The structure of the reversing machine 41 is basically the same as that of the above-described reversing machine 31 of the first polishing section 3a. The reversing machine 41, as with the reversing machine 31, receives the polished wafer from the swing transporter 7, turns the wafer upside down, and delivers the wafer to the transfer unit 46.

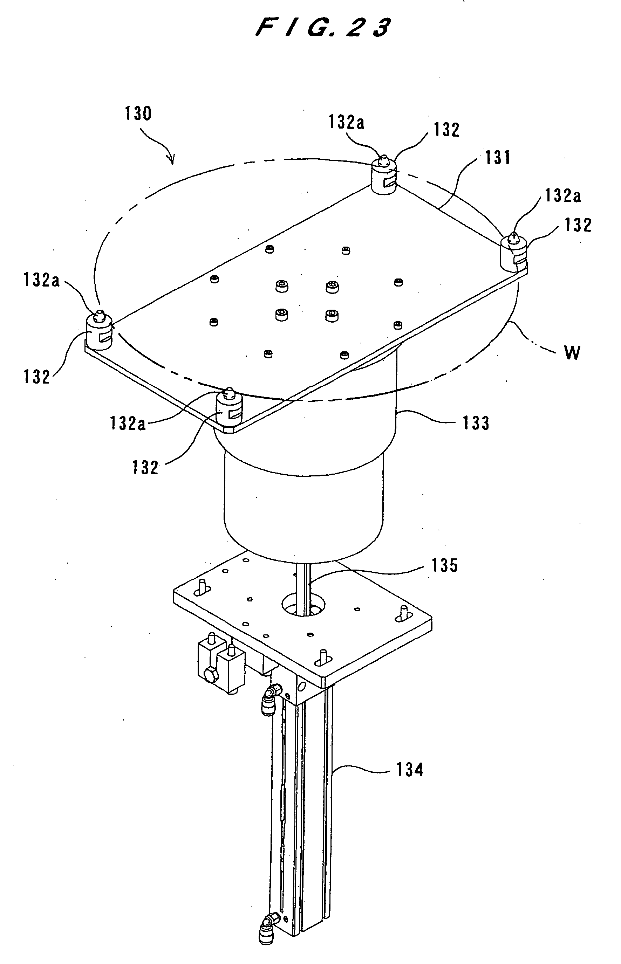

As shown in FIG. 9, the reversing machine 41 of the cleaning section 4 has a temporary stage 130 below the clamp members 114. FIG. 23 is a perspective view showing the temporary stage 130. As shown in FIG. 23, the temporary stage 130 comprises a rectangular base plate 131, column pieces 132 provided on four corners of the base plate 131, a support cylinder 133 that supports the base plate 131, and an air cylinder 134 for vertically moving the support cylinder 133. Hemispherical projections 132a are provided on upper portions of the column pieces 132, respectively, so that positioning of the wafer W is performed by these projections 132a. The support cylinder 133 is coupled to the air cylinder 134 via a rod 135, so that the air cylinder 134 vertically moves the base plate 131 together with the support cylinder 133.

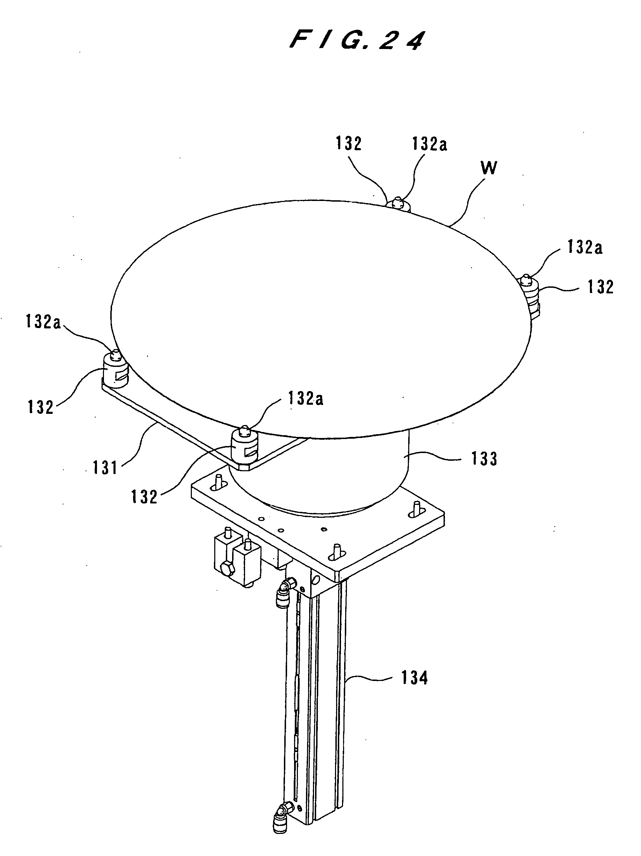

After the wafer W is inverted, the air cylinder 134 of the temporary stage 130 is operated so as to elevate the base plate 131 to a wafer receiving position. After the base plate 131 reaches the wafer receiving position, the opening-closing mechanism 312 is operated to move the holding members 310 away from one another, whereby the wafer W is released from the holding members 310 onto the column pieces 132 on the base plate 131. Thereafter, the air cylinder 134 of the temporary stage 130 is operated so as to lower the base plate 131 to a predetermined position, as shown in FIG. 24. The wafer W on the column pieces 132 of the temporary stage 130 is delivered to the transfer unit 46, which will be described later, and to the cleaning devices 42-45, so that the wafer W is cleaned in the respective cleaning devices.

The temporary stage 130 can be used as a buffer of the wafer prior to cleaning. Therefore, a tact time of processing as a whole can be shortened. The reversing machine 41 may have a cleaning mechanism. With this structure, the reversing machine 41 can perform rough cleaning of the wafer W prior to cleaning in the cleaning devices 42-45.

Above-described reversing operation is performed before and after polishing. When a wafer W that has been polished is reversed (by the reversing machine 41), the wafer W is rinsed with a cleaning liquid during or after reversing operation in order to prevent damage to the wafer W due to a dried abrasive liquid or polishing wastes attached to the wafer W during polishing. Pure water or a chemical liquid is used as the cleaning liquid to rinse the wafer and is ejected at a required flow rate and required pressure from spray nozzles with optimal angles for a predetermined period of time. This rinsing process can effectively improve cleaning performance in the subsequent cleaning process. The cleaning liquid is continuously supplied while the wafer W is waiting on the reversing machine. However, in view of a running cost, the cleaning liquid may be intermittently supplied so that an amount of cleaning liquid used is reduced. When the reversing machine 31 or 41 does not clamp the wafer W, the cleaning liquid may be supplied to the wafer clamp grooves and their surrounding portions so as to prevent back contamination of the wafer W via such portions contacting the wafer W.

Next, the lifter 32 in the first polishing section 3a will be described below. The lifter 32 in the first polishing section 3a is disposed at a position where the transfer robot 22 and the first linear transporter 5 can access. The lifter 32 serves as a receiving/delivering mechanism for receiving and delivering a wafer between the transfer robot 22 and the first linear transporter 5. Specifically, the lifter 32 is operable to deliver a wafer reversed by the reversing machine 31 to the first transfer stage TS 1 or the fourth transfer stage TS4 in the first linear transporter 5.

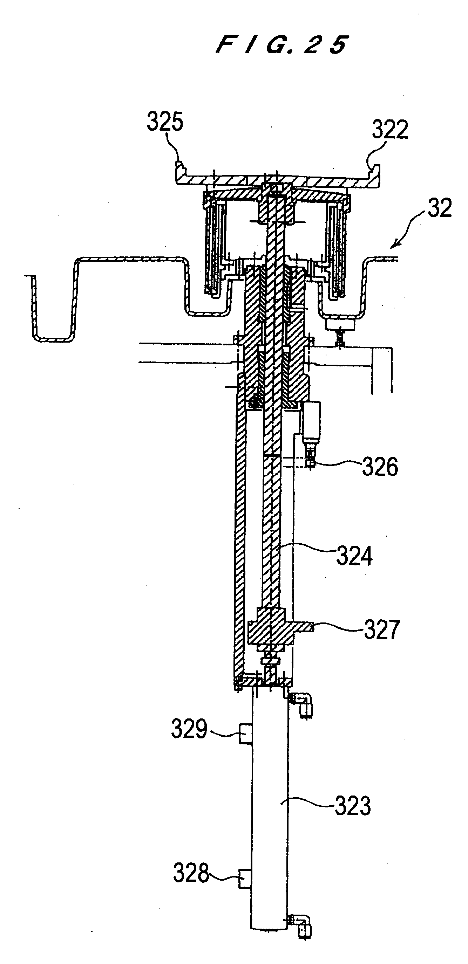

FIG. 25 is a vertical cross-sectional view showing the lifter 32. The lifter 32 comprises a stage 322 on which a wafer is placed, and a cylinder 323 for elevating and lowering the stage 322. The cylinder 323 and the stage 322 are coupled to one another via a slidable shaft 324. The stage 322 has claws 325, which are arranged at angular intervals such that a wafer having an orientation flat can be held and reliably transported. The claws 325 are disposed at positions where they are not aligned with the chucking members 311 in the reversing machine 31. Specifically, a first peripheral edge of the wafer held by the chucking members 311 does not correspond to a second peripheral edge of the wafer held by the claws 325 of the lifter 32. The claws 325, which are used to transfer the wafer to the reversing machine 31 and the first linear transporter 5, have support surfaces for supporting the wafer thereon, and further have tapered surfaces extending upwardly from the support surfaces. The tapered surfaces are for absorbing errors in transferring position and for performing centering of the wafer when the wafer is placed onto the support surfaces.

The wafer support surfaces of the stage 322 are raised by operation of the cylinder 323 to a wafer holding position of the reversing machine 31. A stopper 326 having a shock absorbing function is provided so as to stop elevation of the stage 322. When a stopper base 327, fixed to the shaft of the cylinder 323, contacts the stopper 326, the operation of the air cylinder 323 is stopped, and elevation of the stage 322, connected to the shaft of the cylinder 323, is simultaneously stopped. By adjusting a location of the stopper 326, a height of the stage 322 to be elevated can be adjusted to a desirable transfer position. Sensors 328 and 329 are provided on the cylinder 323 for detecting an upper stroke end and a lower stroke end of the cylinder 323, respectively.

Next, operation of the lifter 32 having the above structure will be described. The wafer to be polished is transferred by the transfer robot 22 to the reversing machine 31. Then, the wafer is reversed so that a pattern surface faces downwardly. The lifter 32 is raised toward the wafer held by the reversing machine 31 and is stopped right below the wafer. When the sensor 329 detects the stop of the lifter 32, the reversing machine 31 releases the wafer by opening the clamps and the wafer is placed onto the stage 322 of the lifter 32. Thereafter, the lifter 32 is lowered with the wafer placed thereon. While the lifter 32 is lowered, the wafer is transferred to the transfer stage TS1 or TS4 of the first linear transporter 5. At this time, the wafer is placed on the pins 50 of the transfer stage. After the wafer is transferred to the first linear transporter 5, the lifter 32 continues to be lowered, and is then stopped at the stroke end of the cylinder 323. The lifter 32 may comprise a ball spline built-in cylinder, as with the pusher 33 which will be described later.

The pushers 33, 34 in the first polishing section 3a and the pushers 37, 38 in the second polishing section 3b will be described below. The pusher 33 in the first polishing section 3a serves to receive a wafer from the transfer stage TS1 of the first linear transporter 5 and deliver the wafer to the top ring 301A of the first polishing unit 30A, and further serves to receive a polished wafer from the first polishing unit 30A and deliver the wafer to the transfer stage TS2 of the first linear transporter 5. The pusher 34 serves to receive a wafer from the transfer stage TS2 of the first linear transporter 5 and deliver the wafer to the top ring 301B of the second polishing unit 30B, and further serves to receive a polished wafer from the second polishing unit 30B and deliver the wafer to the transfer stage TS3 of the first linear transporter 5. The pusher 37 in the second polishing section 3b serves to receive a wafer from the transfer stage TS5 of the second linear transporter 6 and deliver the wafer to the top ring 301C of the third polishing unit 30C, and further serves to receive a polished wafer from the third polishing unit 30C and deliver the wafer to the transfer stage TS6 of the second linear transporter 6. The pusher 38 serves to receive a wafer from the transfer stage TS6 of the second linear transporter 6 and deliver the wafer to the top ring 301D of the fourth polishing unit 30D, and further serves to receive a polished wafer from the fourth polishing unit 30D and deliver the wafer to the transfer stage TS7 of the second linear transporter 6. Thus, the pushers 33, 34, 37, and 38 serve as a receiving/delivering mechanism for receiving and delivering a wafer between the linear transporters 5, 6 and the respective top rings. The pushers 33, 34, 37, and 38 have the same structure, and only the pusher 33 will be described below.

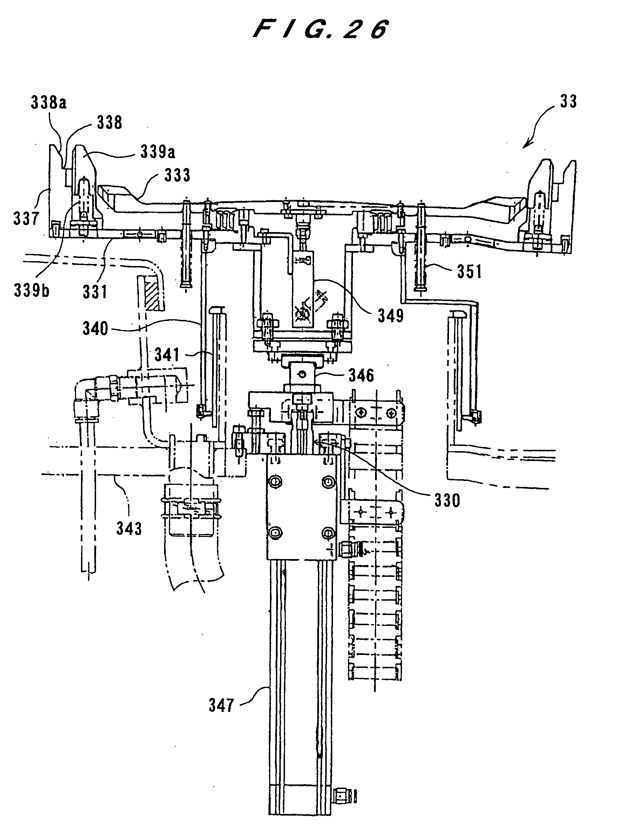

FIG. 26 is a vertical cross-sectional view showing the pusher 33. As shown in FIG. 26, the pusher 33 comprises a guide stage 331 for holding the top ring, and a push stage 333 for holding a wafer. The guide stage 331 has four top ring guides 337 on an outermost periphery thereof. Each of the top ring guides 337 has an upper step 338 which is shaped to access the lower surface of the guide ring 3104 (see FIG. 6) of the top ring. The upper step 338 has a tapered surface 338a (preferably at an angle of 25° to 35°) for introducing the top ring thereon. When a wafer is unloaded, the top ring guide 337 directly receives a wafer edge.

A guide sleeve 340 having a waterproof function is provided at a back side of the guide stage 331. A center sleeve 341 for protecting the pusher from water is installed inwardly of the guide sleeve 340.

In order for the top ring guide 337 to have a positioning mechanism, the top ring guide 337 has a linear way 346 operable to move along X axis and Y axis to thereby perform centering of the guide stage 331. The guide stage 331 is fixed to the linear way 346. This linear way 346 is designed so as to return to a central position by being pressurized. With this structure, centering of the guide stage 331 is achieved. Alternatively, the linear way 346 may be designed so as to return to the central position by a spring installed therein without application of pressure.

The linear way 346 is fixed to a shaft 330, which is couple to a cylinder 347 having a ball spline mechanism. A non-illustrated motor drives the cylinder 347 to thereby vertically move the guide stage 331 via the shaft 330.

The push stage 333 is located above the guide stage 331. An air cylinder 349 is provided at a center of the push stage 333. This air cylinder 349 serves to vertically move the push stage 333 relative to the guide stage 331, so that a wafer is loaded to the top ring 301A. Compression springs 351 for positioning are provided at an edge of the push stage 333.

The pusher 33 has a cleaning nozzle for cleaning the pusher 33 so as to prevent back contamination of the wafer due to the slurry attached to the pusher. The pusher may have a sensor for detecting the presence of a wafer on the pusher.

Operations of the pusher 33 thus constructed will be described below.

### 1) Loading a wafer

A wafer W is transferred to a position above the pusher 33 by the first linear transporter 5. When the top ring 301A is located at a wafer loading position (i.e., the second transferring position) above the pusher 33 and does not hold the wafer, the guide stage 331 and components associated with the guide stage 331 are elevated by the air cylinder 347. While the guide stage 331 is elevated, the guide stage 331 passes through the wafer holding position of the transfer stage of the first linear transporter 5. At this time, the wafer W is centered by the tapered surfaces of the top ring guides 337, and a pattern surface (portion other than an edge portion) of the wafer W is held by the push stage 333.

While the push stage 333 holds the wafer W, the top ring guides 337 are elevated without stop, and the tapered surfaces 338a of the top ring guides 337 guide the guide ring 3104. The center of the top ring guides 337 is aligned with the center of the top ring 301A by the linear way 346 movable in X and Y directions, and the upper steps 338 of the top ring guides 337 contact the lower surface of the guide ring 3104 and elevation of the guide stage 331 is stopped.

When the upper steps 338 of the top ring guides 337 are brought into contact with the lower surface of the guide ring 3104, the guide stage 331 is fixed in position and is not elevated anymore. On the other hand, the push stage 333 is further elevated by the air cylinder 349. The push stage 333 holds the pattern surface (portion other than the edge portion) of the wafer W, and transports the wafer W to the top ring 301A. After the top ring 301A completes the attraction of the wafer W, the pusher is lowered. When lowering of the pusher is completed, the operation of loading of the wafer is completed.

### 2) Unloading a wafer

The wafer W is transported by the top ring 301A to a wafer unloading position located above the pusher. When the transfer stage of the first linear transporter 5 is located above the pusher 33 and does not hold the wafer, the guide stage 331 and the components associated with the guide stage 331 are elevated by the air cylinder 347, and the tapered surfaces 338a of the top ring guides 337 guide the guide ring 3104. The center of the top ring guides 337 is aligned with the center of the top ring 301A by the linear way 346, and the upper steps 338 of the top ring guides 337 are brought into contact with the lower surface of the guide ring 3104 and elevation of the guide stage 331 is stopped.

The air cylinder 349 elevates the push stage 333. The push stage 333 is not raised to a position higher than wafer holding portions of the top ring guides 337. After the elevating operation of the air cylinder 349 is completed, the wafer W is released from the top ring 301A. At this time, the wafer W is centered by the lower tapered surfaces of the top ring guides 337, and the peripheral edge of the wafer W is held by the top ring guides 337. After the wafer W is held by the pusher, the pusher is lowered. While the guide stage 331 is lowered, the guide stage 331, whose central position has moved for centering the top ring, is centered by the guide sleeve 340 and the center sleeve 341. While the guide stage 331 is lowered, the wafer W is transferred from the pusher to the transfer stage of the first linear transporter 5, and the peripheral edge of the wafer W is received by the transfer stage of the first linear transporter 5. When lowering of the guide stage 331 is completed, unloading of the wafer is completed. In order to prevent lateral shift of the wafer, receive portions 339a are provided so as to project by springs therein when the top ring 301A is lowered.

Next, the cleaning devices 42-45 in the cleaning section 4 will be described. The primary cleaning device 42 and the secondary cleaning device 43 may comprise, for example, a roll type cleaning device which rotates and presses upper and lower roll-shaped sponges against front and rear surfaces of a wafer to clean the front and rear surfaces of the wafer. The tertiary cleaning device 44 may comprise, for example, a pencil type cleaning device which rotates and presses a hemispherical sponge against a wafer to clean the wafer. The quaternary cleaning device 45 may comprise, for example, a pencil type cleaning device which rinses and cleans a rear surface of a wafer and rotates and presses a hemispherical sponge against a front surface of the wafer to clean the wafer. The quaternary cleaning device 45 has a stage that chucks and rotates a wafer at a high rotational speed, and thus has a function (spin-drying function) to dry a cleaned wafer by rotating the wafer at a high rotational speed. In the cleaning devices 42-45, a megasonic type cleaning device, which applies ultrasonic waves to a cleaning liquid to clean a wafer, may be provided in addition to the roll type cleaning device or the pencil type cleaning device described above.

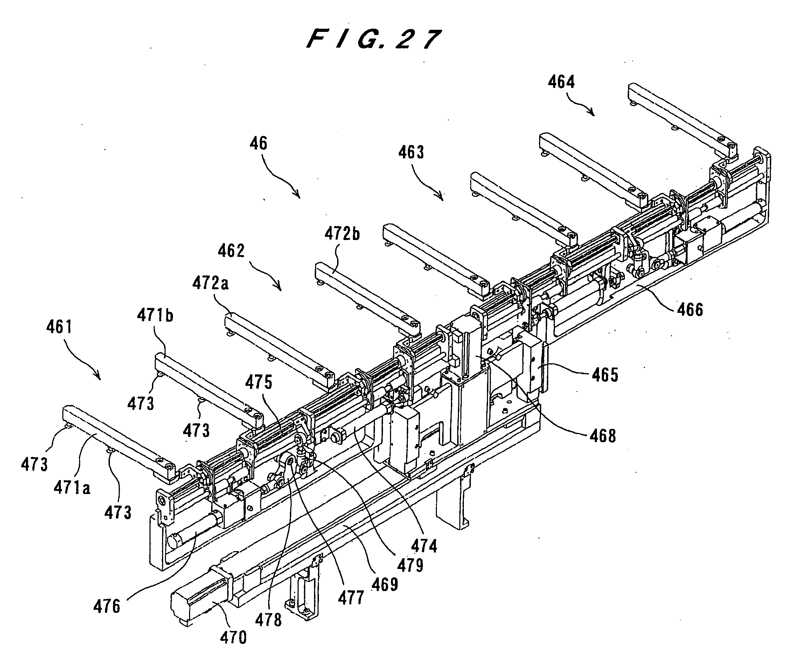

Next, the transfer unit 46 in the cleaning section 4 will be described. FIG. 27 is a perspective view showing the transfer unit 46. As shown in FIG. 27, the transfer unit 46 has four chucking units 461-464 each serving as a wafer clamp mechanism for detachably holding a wafer in the cleaning device. The chucking units 461-464 are mounted on a guide frame 466 extending horizontally from a main frame 465. A vertically extending ball screw (not shown in the drawing) is mounted on the main frame 465. The chucking units 461-464 are vertically moved by a motor 468 coupled to the ball screw. Thus, the motor 468 and the ball screw constitute a vertically moving mechanism for vertically moving the chucking units 461-464.

A ball screw 469, extending in parallel with the arrangement direction of the cleaning devices 42-45, is mounted on the main frame 465. The main frame 465 and the chucking units 461-464 are horizontally moved by a motor 470 coupled to the ball screw 469. Thus, the motor 470 and the ball screw 469 constitute a moving mechanism for moving the chucking units 461-464 along the arrangement direction of the cleaning devices 42-45 (an arrangement direction of the chucking units 461-464).

The present embodiment uses the same number of chucking units as the number of cleaning devices 42-45. The chucking units 461 and 462 and the chucking units 463 and 464 have basically the same structure and are symmetrical about the main frame 465. Accordingly, only the chucking units 461 and 462 will be described below.

The chucking unit 461 has a pair of arms 471a and 471b operable to be opened and closed for holding a wafer W, and the chucking unit 462 has a pair of arms 472a and 472b. Each of the chucking units has at least three (four in this embodiment) chucking pins 473 on the arms thereof. The chucking pins 473 are shaped to clamp a periphery of a wafer W, so that the chucking unit 462 can transfer the wafer to the next cleaning device.

As shown in FIG. 27, an air cylinder 474 is provided on the guide frame 466 for moving the arms 471 a and 471 b of the chucking unit 461 and the arms 472a and 472b of the chucking unit 462 in directions toward and away from one another. Therefore, when the arms 471a, 471b, 472a, and 472b are closed by the air cylinder 474, these arms 471a, 471b, 472a, and 472b come into contact with edge portions of wafers W from both sides thereof to thereby hold the wafers W. Thus, the air cylinder 474 serves as an opening-closing mechanism for opening and closing the arms of each of the chucking units 461-464, i.e., for moving the arms close to and away from one another. The respective chucking units are operable to detect a stroke of the air cylinder so as to detect the presence of a wafer. A wafer may be held by vacuum suction. In such a case, the presence of a wafer can be detected by measuring vacuum pressure.

The arms 47 1 a and 471b of the chucking unit 461 and the arms 472a and 472b of the chucking unit 462 are mounted on a rotational shaft 475 rotatably supported by the guide frame 466. Further, an air cylinder 476 is provided on the guide frame 466 for rotating the arms 471a, 471b, 472a, and 472b about the rotational shaft 475. The air cylinder 476 has a rod having a tip end connected to a ring member 478 rotatable about a pin 477. This ring member 478 is coupled to the rotational shaft 475 via a rod 479. The air cylinder 476, the ring member 478, and the rod 479 serve as a rotating mechanism for rotating the arms of the respective chucking units 461-464 about the rotational shaft 475.

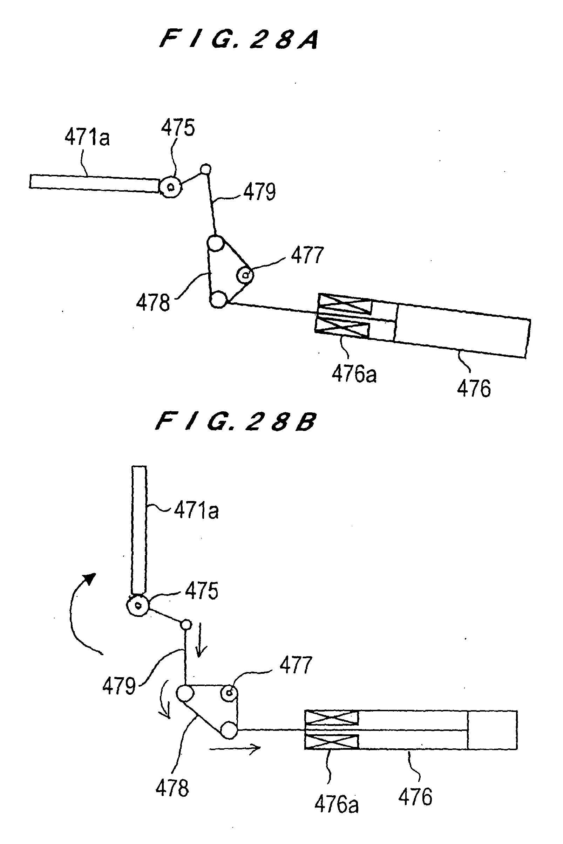

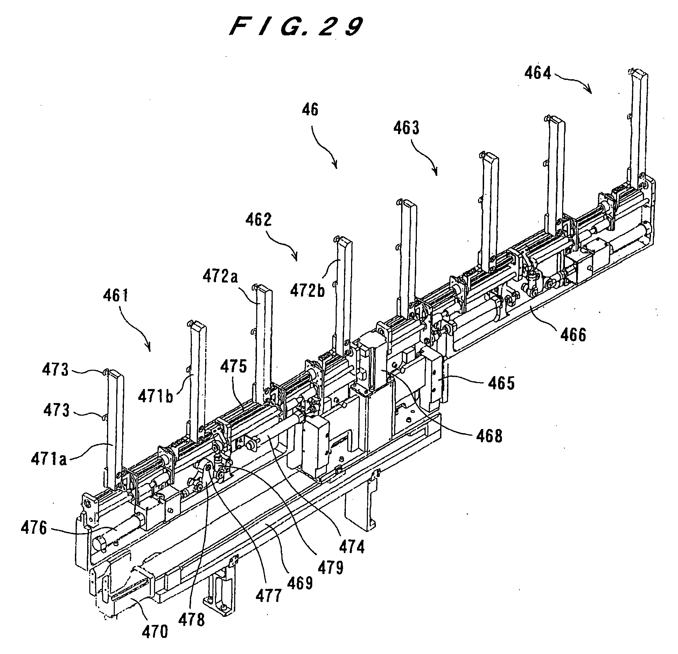

FIGS. 28A and 28B are schematic views each illustrating operation of the air cylinder 476 and operation of the arm 471a. FIG. 28A shows a state in which the arm 471a is lowered. When the air cylinder 476 is operated from this state, the ring member 478 rotates about the pin 477, as shown in FIG. 28B. Thus, the rod 479 moves downwardly and the rotational shaft 475 rotates. With this movement, the arm 471a rotates about the rotational shaft 475. In this embodiment, operation of the air cylinder 476 causes the arms 471a, 471b, 472a, and 472b to rotate through 90 degrees. The air cylinder 476 has a brake 476a. This brake 476a is released before the air cylinder 476 starts its operation. FIG. 29 shows a state in which the air cylinder 476 is operated to rotate (raise) the arms of all of the chucking units 461-464 through 90 degrees.

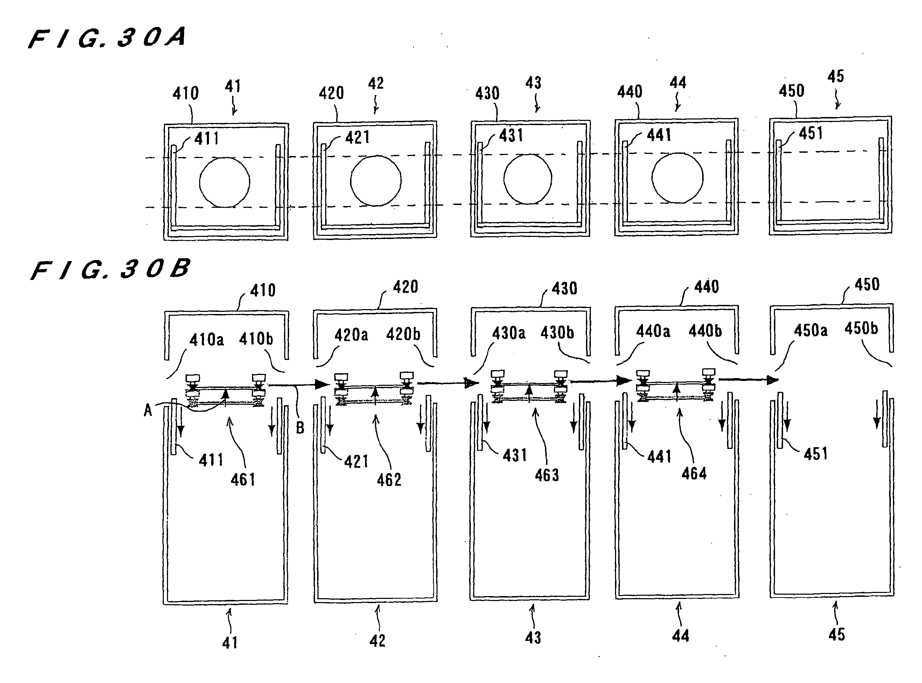

Next, operations of the transfer unit 46 thus constructed will be described. FIGS. 30A and 30B are views explanatory of operation of the transfer unit shown in FIG. 27. FIG. 30A is a horizontal cross-sectional view, and FIG. 30B is a vertical cross-sectional view. As shown in FIGS. 30A and 30B, the reversing machine 41 and the respective cleaning devices 42-45 are partitioned by chambers 410, 420, 430, 440 and 450, which prevent a used liquid from scattering during cleaning. The chambers have openings 410a, 410b, 420a, 420b, 430a, 430b, 440a, 440b, 450a, and 450b for allowing the chucking units of the transfer unit 46 to pass therethrough. Shutters 411, 421, 431, 441 and 451 are provided on the openings.

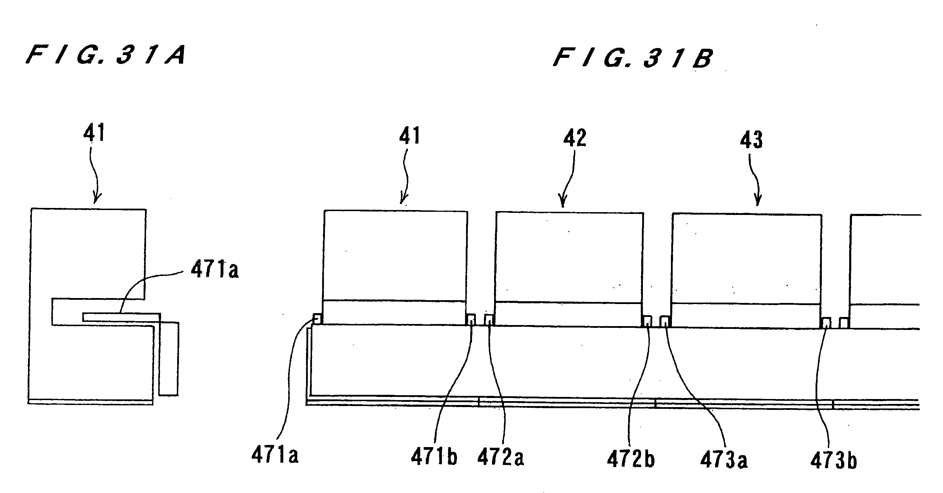

When wafers are not transferred, the above shutters are closed, and the chucking units 461-464 are on standby at a space (standby position) above the reversing machine 41 or the cleaning devices 42-44. At this standby position as shown in FIGS. 31A and 31B, the pair of arms of the chucking unit 461 are located on both sides of the reversing machine 41, the pair of arms of the chucking unit 462 are located on both sides of the primary cleaning device 42, the pair of arms of the chucking unit 463 are located on both sides of the secondary cleaning device 43, and the pair of arms of the chucking unit 464 are located on both sides of the tertiary cleaning device 44.

When wafers are to be transferred, the shutters 411, 421, 431, 441, and 451 are opened and the arms of the respective chucking units are closed. Then, the arms are introduced into the chambers of the reversing machine 41 and the cleaning devices 42-44. Thereafter, the chucking units 461-464 are lowered to positions of the wafers within the chambers by the motor 468 of the transfer unit 46. Then, the arms are closed by operation of the air cylinders 474 of the transfer unit 46 to thereby hold the wafers within the reversing machine 41 or the cleaning devices 41-44.

Thereafter, the chucking units 461-464 are elevated by the motor 468 of the transfer unit 46 to positions at which the openings 410a, 410b, 420a, 420b, 430a, 430b, 440a, 440b, 450a, and 450b are formed, as indicated by vertical arrows A in FIG. 30B. By actuation of the motor 470 of the transfer unit 46, the chucking unit 461 is introduced into the primary cleaning device 42 through the openings 410b and 420a, the chucking unit 462 is introduced into the secondary cleaning device 43 through the openings 420b and 430a, the chucking unit 463 is introduced into the tertiary cleaning device 44 through the openings 430b and 440a, and the chucking unit 464 is introduced into the quaternary cleaning device 45 through the openings 440b and 450a, as indicated by horizontal arrows B in FIG. 30B.

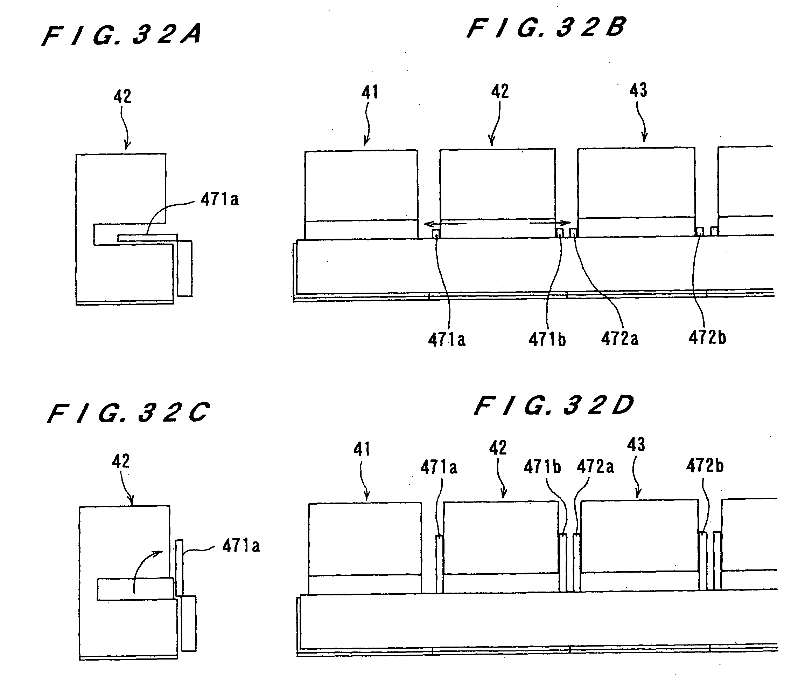

After the wafers are transferred to the cleaning devices 42-45, the chucking units 461-464 are lowered by the motor 468 to wafer holding mechanisms in the cleaning devices. Then, the arms are opened by operation of the air cylinders 474 of the respective chucking units to thereby release the wafers to the wafer holding mechanisms in the cleaning devices. In this state, as shown in FIGS. 32A and 32B, the arms are moved outside the chambers, the shutters 411, 421, 431, 441 and 451 are closed, and then the wafers are cleaned. After cleaning of the wafers are started, the chucking units 461-464 may be elevated by the motor 468 of the transfer unit 46 to the positions where the chucking units 461-464 receive the next wafers.

Thereafter, the air cylinders 476 of the transfer unit 46 are operated to rotate the arms of the chucking units through 90 degrees to thereby raise the arms, as shown in FIGS. 32C and 32D. In this state, the motor 470 of the transfer unit 46 moves the chucking units 461-464 to the reversing machine 41, the primary cleaning device 42, the secondary cleaning device 43, and the tertiary cleaning device 44, respectively. Then, the air cylinders 476 are operated to rotate the arms of the chucking units in the opposite directions through 90 degrees to thereby return the arms back to the positions shown in FIGS. 31A and 31B. At the same time as the shutters 411, 421, 431, 441 and 451 are closed, the arms of the chucking units may be raised via rotation thereof through 90 degrees. Elevation and rotation of the chucking units 461-464 are performed after the chucking units 461-464 are moved to the exteriors of the cleaning devices and before transferring of the next wafers are started.

In this manner, in the present embodiment, semiconductor wafers can be transferred simultaneously from the reversing machine 41 to the primary cleaning device 42, from the primary cleaning device 42 to the secondary cleaning device 43, from the secondary cleaning device 43 to the tertiary cleaning device 44, and from the tertiary cleaning device 44 to the quaternary cleaning device 45, respectively. Further, because the wafers are moved along the arrangement direction of the cleaning devices to the next cleaning devices, a stroke required for transferring the wafers can be minimized, and a wafer transferring time can be shortened.

After the transfer unit 46 terminates transferring of the wafers, the arms are moved outside the chambers, so that the shutters 411, 421, 431, 441 and 451 can be closed. Thus, processing can be performed in the chambers, while the transfer unit 46 can move to a desired standby position. Therefore, the cleaning process can be started quickly, and a tact time can be shortened. Although not shown in the drawings, a standby position at which a wafer is on standby after cleaning may be provided adjacent to the quaternary cleaning device 45 so that the wafer that has been cleaned by the quaternary cleaning device 45 is moved to this standby position by the transfer unit 46.

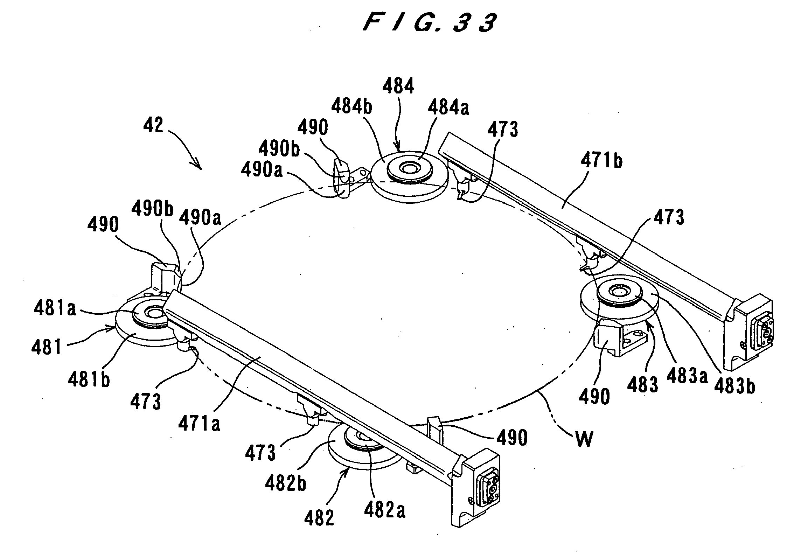

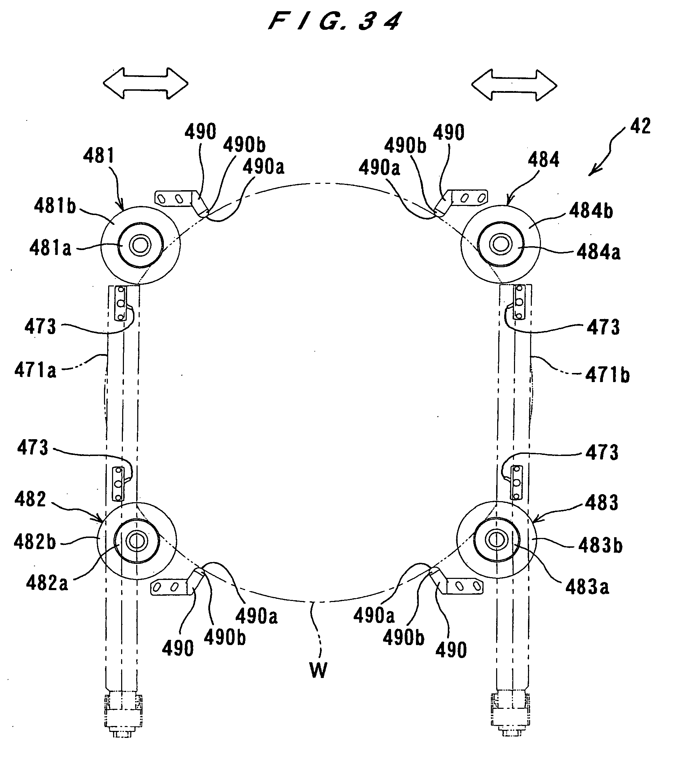

Next, the cleaning devices 42-44 will be described in detail. These cleaning devices 42-44 have the same structure, and only the primary cleaning device 42 will be described below. FIG. 33 is a perspective view showing the primary cleaning device 42, and FIG. 34 is a plan view of the primary cleaning device 42.

As shown in FIGS. 33 and 34, the cleaning device 42 comprises four rollers 481, 482, 483, and 484 for holding and rotating a wafer W, and four positioning guides 490 configured to allow a vertical movement of the wafer W while restricting a horizontal movement of the wafer W. The first roller 481 and the second roller 482 are moved by a non-illustrated driving mechanism (e.g., an air cylinder) in directions as indicated by arrow shown in FIG. 34. Similarly, the third roller 483 and the fourth roller 484 are moved by a non-illustrated driving mechanism in directions as indicated by arrow.

These four rollers 481, 482, 483, and 484 move toward the wafer W and thus come into contact with a periphery of the wafer W to thereby hold the wafer W. More specifically, the first roller 481 and the second roller 482 move toward the wafer W until they are stopped by non-illustrated stoppers at predetermined positions. Then, the third roller 483 and the fourth roller 484 move toward the wafer W until they come into contact with the wafer W, whereby the wafer W is clamped by the four rollers 481, 482, 483, and 484. When, the rollers 481, 482, 483, and 484 move away from the wafer W, clamp of the wafer W is released.

The four rollers 481, 482, 483, and 484 have the same structure as each other. Thus, the first roller 481 will be described in detail below. The roller 481 has a two-step structure comprising a clamp portion 48 1 a and a shoulder portion (support portion) 481b. The shoulder portion 481b has a diameter larger than that of the clamp portion 481a, and the clamp portion 481a is formed on the shoulder portion 481b. The wafer W, which is transferred by the arms 471a and 471b of the transfer unit 46 (see FIG. 27), is first placed onto the shoulder portions 481b, 482b, 483b, and 484b. Then, the rollers 481, 482, 483, and 484 move toward the wafer W, so that the clamp portions 481a, 482a, 483a, and 484a clamp the wafer W.

At least one of the four rollers 481, 482, 483, and 484 is rotated by a non-illustrate rotating mechanism, so that the wafer W is rotated with its periphery clamped by the rollers 481, 482, 483, and 484. While the wafer W is rotated, a rotational center of the wafer W is kept substantially constant, because the first roller 481 and the second roller 482 are fixed in position by the stoppers. Each of the clamp portions 481a, 482a, 483a, and 484a has a groove which is shaped to loosely engage the periphery of the wafer W. Thus, the wafer W does not disengage from the rollers 481, 482, 483, and 484 during rotation of the wafer W. The shoulder portions 481 b, 482b, 483b, and 484b are inclined with a downward gradient toward the periphery thereof. Therefore, while the wafer W is held by the clamp portions 481a, 482a, 483a, and 484a, the wafer W is kept out of contact with the shoulder portions 481b, 482b, 483b, and 484b.

The positioning guides 490 are arranged along the periphery of the wafer W held by the rollers 481, 482, 483, and 484. Each of the positioning guides 490 comprises a vertically extending positioning surface 490a, and a sloping surface 490b inclined downwardly toward the center of the wafer W. The positioning surface 490a has a semicircular horizontal cross section. The positioning guides 490 are located slightly away from the wafer W. A distance between each of the positioning guides 490 and the periphery of the wafer W is in a range of 0.5 to 2 mm. In this embodiment, two pairs of positioning guides 490 are arranged symmetrically about the center of the wafer W. With this arrangement, the wafer W is allowed to move vertically while its horizontal movement is restricted by the positioning guides 490.

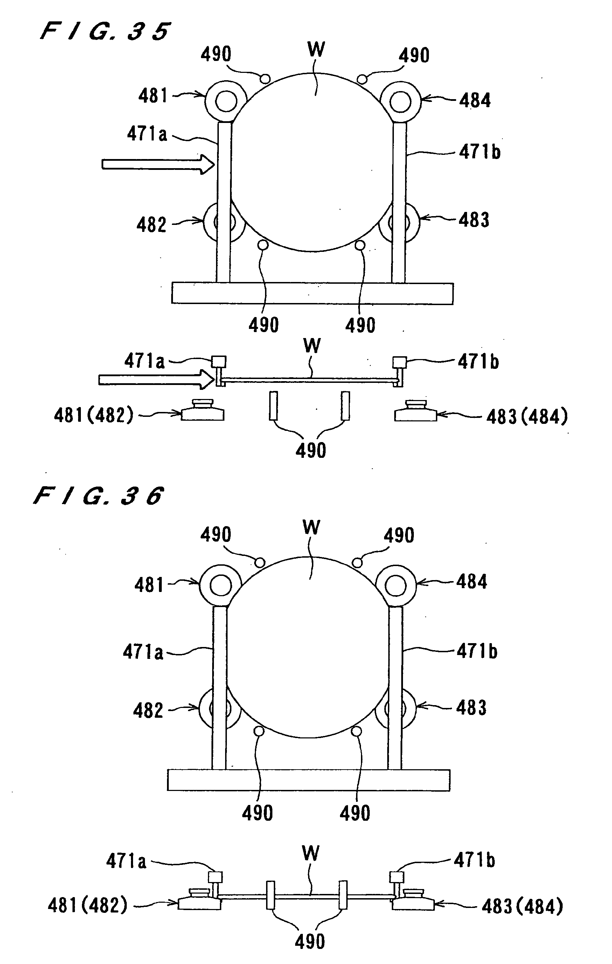

FIGS. 35 through 38 are schematic views each illustrating transferring of the wafer into the cleaning device 42. In FIGS. 35 through 38, upper half shows a plan view, and lower half shows a side view.

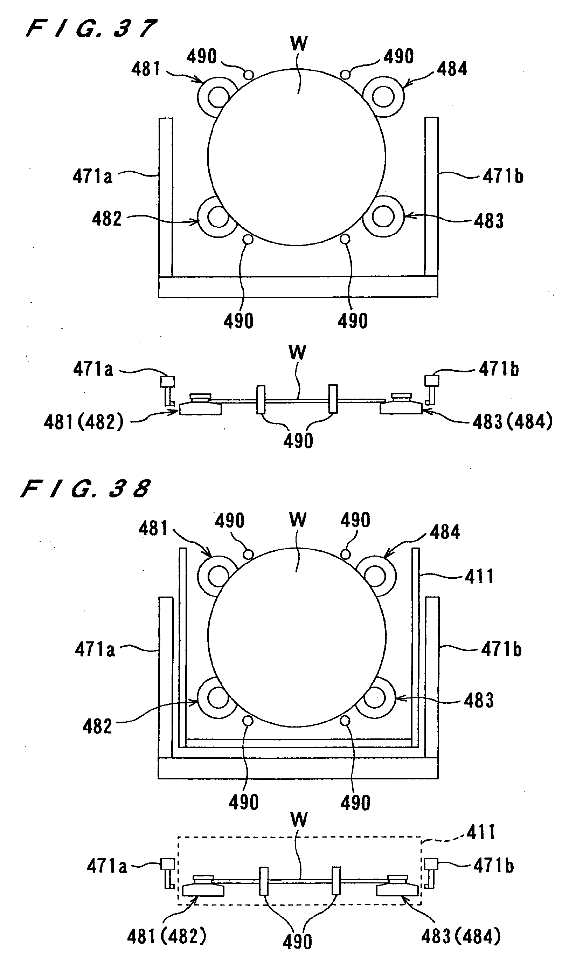

First, the arms 471a and 471b of the transfer unit 46 are moved horizontally and deliver the wafer W into the cleaning device 42 (FIG. 35). Then, the arms 471a and 471b are lowered, and the wafer W is placed onto the shoulder portions 481b, 482b, 483b, and 484b of the rollers 481, 482, 483, and 484 (FIG. 36). At the same time as the arms 471a and 471b are opened, the first and second rollers (positioning rollers) 481 and 482 move toward the wafer W (FIG. 37). At this time, the wafer W moves slightly upwardly along the gradient of the shoulder portions 481b, 482b, 483b, and 484b while the horizontal position of the wafer W is kept substantially constant by the positioning guides 490. Then, the third and fourth rollers (pressing rollers) 483 and 484 move toward the wafer W to thereby hold the wafer W. At this time also, the wafer W moves slightly upwardly along the gradient of the shoulder portions 481b, 482b, 483b, and 484b while the horizontal position of the wafer W is kept substantially constant by the positioning guides 490. At the same time as the wafer W is held by the rollers 481, 482, 483, and 484, the shutter 411 is closed, and then processing of the wafer W is started (FIG. 38). After processing of the wafer W is completed, the same steps are repeated in reverse order, and the wafer W is transferred from the cleaning device 42.

In a conventional structure without the above-mentioned positioning guides, the arms 471a and 471b should wait as they are until the first and second rollers 481 and 482 and the third and fourth rollers483 and 484 move and hold a wafer. Further, when removing the wafer, the arms 471a and 471b should wait as well. As a result, the wafer delivering and removing operations entail a waiting time in the conventional structure. This is because, in order to prevent movement and tilt of the wafer during movement of the rollers, the arms 471a and 471b should wait until the wafer is clamped by the rollers. Such movement and tilt of the wafer are apt to occur particularly when the wafer is removed from the rollers.

According to the present embodiment, because the horizontal position and the attitude of the wafer W are kept substantially constant by the positioning guides 490, the arms 47 1 a and 471b are not requited to wait. Hence, a processing time as a whole of the cleaning device 42 can be shortened. Although four positioning guides 490 are provided in this embodiment, the number of positioning guides 490 is not limited to four, and can be selected from a range between four and eight. Further, the number of rollers is not limited to four. For example, six rollers may be provided. Furthermore, during rotation of the wafer W, the positioning guides 490 may be lowered so as to prevent contact between the periphery of the wafer W and the positioning guides 490.

Operations of polishing wafers with use of the polishing apparatus thus constructed will be described below.

When serial processing is performed, a wafer is transferred on the following route: the wafer cassette of the front loading unit 20 → the transfer robot 22 → the reversing machine 31 → the lifter 32 → the first transfer stage TS1 of the first linear transporter 5 → the pusher 33 → the top ring 301A → the polishing table 300A → the pusher 33 → the second transfer stage TS2 of the first linear transporter 5 → the pusher 34 → the top ring 301B → the polishing table 300B → the pusher 34 → the third transfer stage TS3 of the first linear transporter 5 → the swing transporter 7→ the fifth transfer stage TS5 of the second linear transporter 6 → the pusher 37 → the top ring 301C → the polishing table 300C → the pusher 37 → the sixth transfer stage TS6 of the second linear transporter 6 → the pusher 38 → the top ring 301D → the polishing table 300D → the pusher 38 → the seventh transfer stage TS7 of the second linear transporter 6 → the swing transporter 7 → the reversing machine 41 → the temporary stage 130 → the chucking unit 461 of the transfer unit 46 → the primary cleaning device 42 → the chucking unit 462 of the transfer unit 46 → the secondary cleaning device 43 → the chucking unit 463 of the transfer unit 46 → the tertiary cleaning device 44 → the chucking unit 464 of the transfer unit 46 → the quaternary cleaning device 45 → the transfer robot 22 → the wafer cassette of the front loading unit 20.

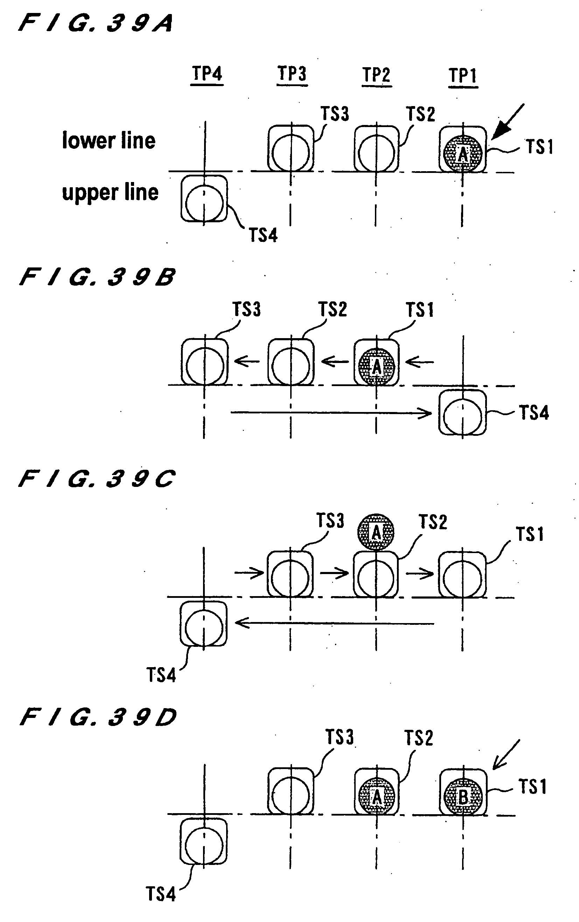

Operations of the linear transporters 5 and 6 will be described below with reference to FIGS. 39 through 45. First, the transfer robot 22 removes a wafer A from the wafer cassette on the front loading unit 20 and transfers the wafer A to the reversing machine 31. The reversing machine 31 chucks the wafer A and then reverses the wafer A through an angle of 180°. Then, the lifter 32 is elevated, so that the wafer A is placed on the lifter 32. Then, the lifter 32 is lowered, so that the wafer A is placed on the first transfer stage TS1 of the first linear transporter 5 (FIG. 39A).

After the wafer A is placed on the first transfer stage TS1 of the first linear transporter 5, the lifter 32 continues to descend down to a position where the first transfer stage TS1 can move without interfering with the lifter 32. When lowering of the lifter 32 is completed, the lower transfer stages TS1, TS2, and TS3 move toward the fourth transferring position TP4, and the upper transfer stage TS4 moves toward the first transferring position TP1. Thus, the wafer A on the first transfer stage TS1 is moved to the wafer receiving/delivering position (second transferring position TP2) for the top ring 301A (FIG. 39B).

Then, the pusher 33, located at the second transferring position TP2, is elevated to transfer the wafer A to the top ring 301A. At this time, the lower transfer stages TS1, TS2, and TS3 move toward the first transferring position TP1, and the upper transfer stage TS4 moves toward the fourth transferring position TP4 (FIG. 39C). The wafer A, delivered to the top ring 301A, is attracted by a vacuum suction mechanism of the top ring 301A, and moved to the polishing table 300A while being attracted by the vacuum suction mechanism. Then, the wafer A is polished by the polishing surface, such as a polishing cloth or a grinding stone, attached to the polishing table 300A. The polished wafer A is moved to a position above the pusher 33 by the swinging motion of the top ring 301A and transferred to the pusher 33. The wafer A is placed onto the second transfer stage TS2 when the pusher 33 is lowered (FIG. 39D). At this time, the next wafer B is placed on the first transfer stage TS1 in the same manner as described above.

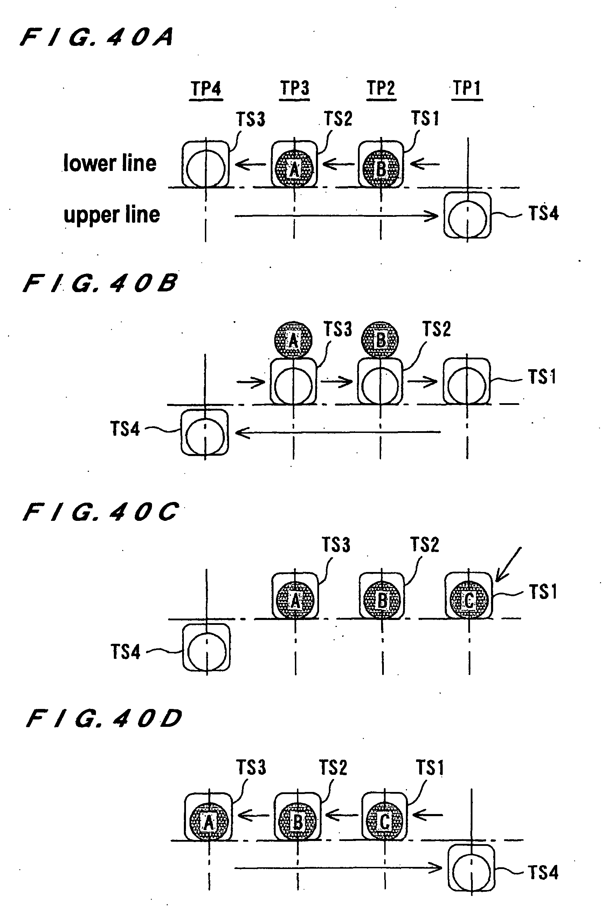

Then, the lower transfer stages TS1, TS2, and TS3 move toward the fourth transferring position TP4, and the upper transfer stage TS4 moves toward the first transferring position TP1. Thus, the wafer A on the second transfer stage TS2 is moved to the wafer receiving/delivering position (third transferring position TP3) for the top ring 301B, and the wafer B on the first transfer stage TS1 is moved to the wafer receiving/delivering position (second transferring position TP2) for the top ring 301A (FIG. 40A).

Then, the pusher 34 located at the third transferring position TP3 and the pusher 33 located at the second transferring position TP2 are elevated to transfer the wafer A and the wafer B to the top ring 301B and the top ring 301A, respectively. At this time, the lower transfer stages TS 1, TS2, and TS3 move toward the first transferring position TP1, and the upper transfer stage TS4 moves toward the fourth transferring position TP4 (FIG. 40B). The wafer A and the wafer B, which have been polished in the respective polishing units, are placed on the third transfer stage TS3 and the second transfer stage TS2 by the pushers 34 and 33, respectively (FIG. 40C). At this time, the next wafer C is placed on the first transfer stage TS 1 in the same manner as described above.

Then, the lower transfer stages TS1, TS2, and TS3 move toward the fourth transferring position TP4, and the upper transfer stage TS4 moves toward the first transferring position TP1. Thus, the wafer A on the third transfer stage TS3 is moved to the fourth transferring position TP4, the wafer B on the second transfer stage TS2 is moved to the wafer receiving/delivering position (third transferring position TP3) for the top ring 301B, and the wafer C on the first transfer stage TS1 is moved to the wafer receiving/delivering position (second transferring position TP2) for the top ring 301A (FIG. 40D).

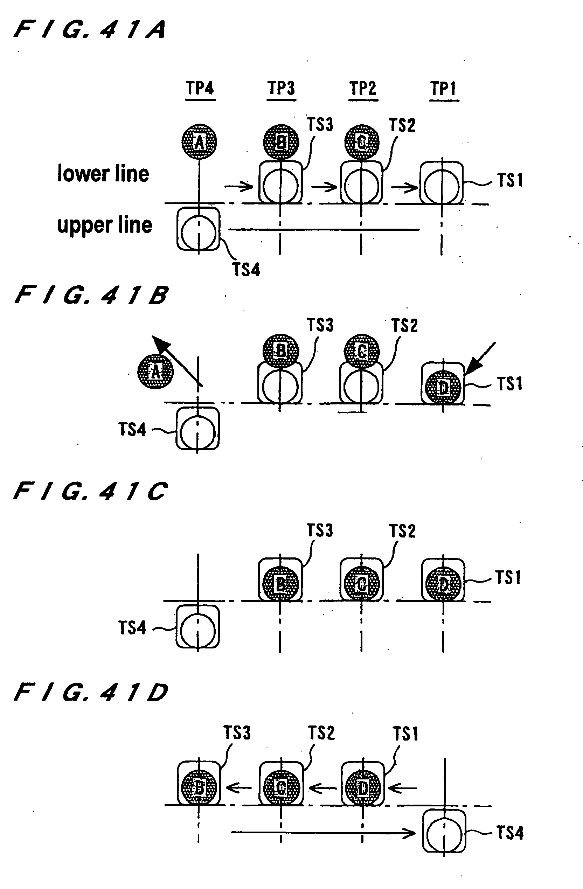

Then, the pusher 34 located at the third transferring position TP3 and the pusher 33 located at the second transferring position TP2 are elevated to transfer the wafer B and the wafer C to the top ring 301B and the top ring 301A, respectively. Further, the wafer clamp mechanism 112 of the swing transporter 7 located at the fourth transferring position TP4 is swung, and the wafer A is transferred to the swing transporter 7. At this time, the lower transfer stages TS 1, TS2, and TS3 move toward the first transferring position TP1, and the upper transfer stage TS4 moves toward the fourth transferring position TP4 (FIG. 41A). The wafer B and the wafer C, which have been polished in the respective polishing units, are placed on the third transfer stage TS3 and the second transfer stage TS2 by the pushers 34 and 33, respectively, and the wafer A is transferred to the second polishing section 3b by the swing transporter 7 (FIG. 41B). At this time, the next wafer D is placed on the first transfer stage TS1 in the same manner as described above (FIGS. 41B and 41C).

Then, the lower transfer stages TS1, TS2, and TS3 move toward the fourth transferring position TP4, and the upper transfer stage TS4 moves toward the first transferring position TP1. Thus, the wafer B on the third transfer stage TS3 is moved to the fourth transferring position TP4, the wafer C on the second transfer stage TS2 is moved to the wafer receiving/delivering position (third transferring position TP3) for the top ring 301B, and the wafer D on the first transfer stage TS1 is moved to the wafer receiving/delivering position (second transferring position TP2) for the top ring 301 A (FIG. 41D).

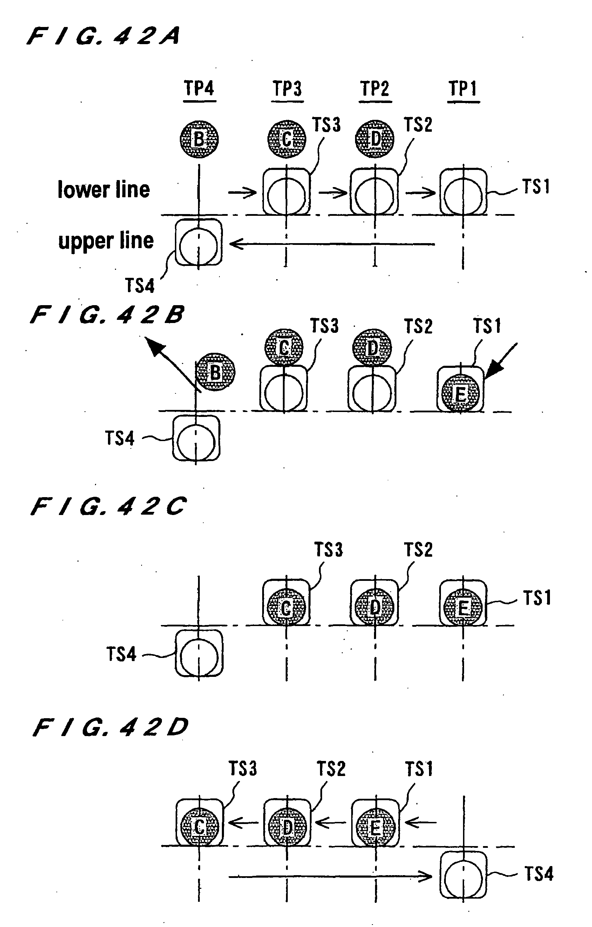

Then, the pusher 34 located at the third transferring position TP3 and the pusher 33 located at the second transferring position TP2 are elevated to transfer the wafer C and the wafer D to the top ring 301B and the top ring 301A, respectively. Further, the wafer clamp mechanism 112 of the swing transporter 7 located at the fourth transferring position TP4 is swung, and the wafer B is transferred to the swing transporter 7. At this time, the lower transfer stages TS1, TS2, and TS3 move toward the first transferring position TP1, and the upper transfer stage TS4 moves toward the fourth transferring position TP4 (FIG. 42A). The wafer C and the wafer D, which have been polished in the respective polishing units, are placed on the third transfer stage TS3 and the second transfer stage TS2 by the pushers 34 and 33, respectively, and the wafer B is transferred to the second polishing section 3b by the swing transporter 7. At this time, the next wafer E is placed on the first transfer stage TS1 in the same manner as described above (FIGS. 42B and 42C).

Then, the lower transfer stages TS1, TS2, and TS3 move toward the fourth transferring position TP4, and the upper transfer stage TS4 moves toward the first transferring position TP1. Thus, the wafer C on the third transfer stage TS3 is moved to the fourth transferring position TP4, the wafer D on the second transfer stage TS2 is moved to the wafer receiving/delivering position (third transferring position TP3) for the top ring 301B, and the wafer E on the first transfer stage TS1 is moved to the wafer receiving/delivering position (second transferring position TP2) for the top ring 301A (FIG. 42D). Thereafter, the processes shown in FIGS. 42A through 42D are repeated.

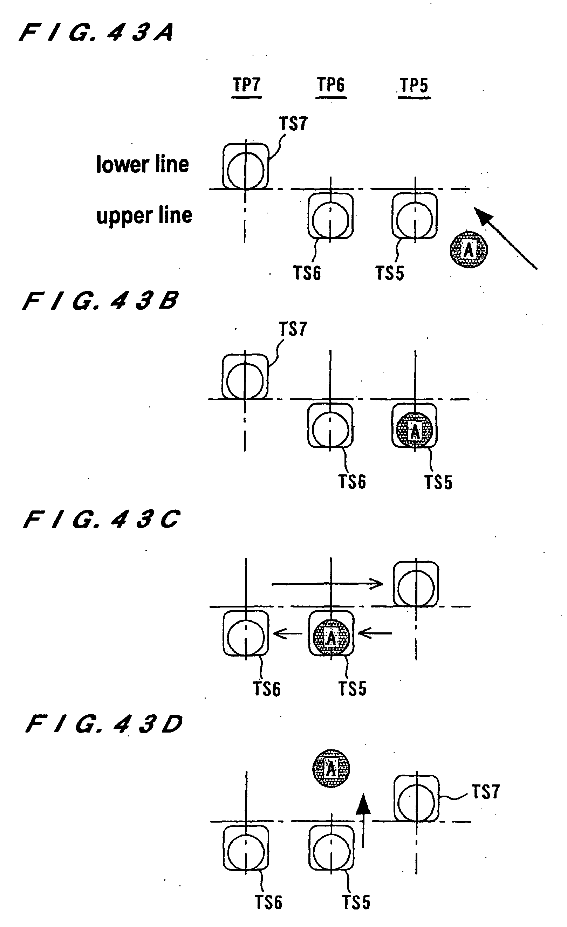

On the other hand, the swing transporter 7, which has received the wafer A, is swung to transfer the wafer A to the fifth transferring position TP5 of the second linear transporter 6 in the second polishing section 3b (FIG. 43A). The wafer A is placed on the fifth transfer stage TS5 of the second linear transporter 6 (FIG. 43B).

After the wafer A is placed on the fifth transfer stage TS5 of the second linear transporter 6, the upper transfer stages TS5 and TS6 move toward the seventh transferring position TP7, and the lower transfer stage TS7 moves toward the fifth transferring position TP5. Thus, the wafer A on the fifth transfer stage TS5 is moved to the wafer receiving/delivering position (sixth transferring position TP6) for the top ring 301C (FIG. 43C).

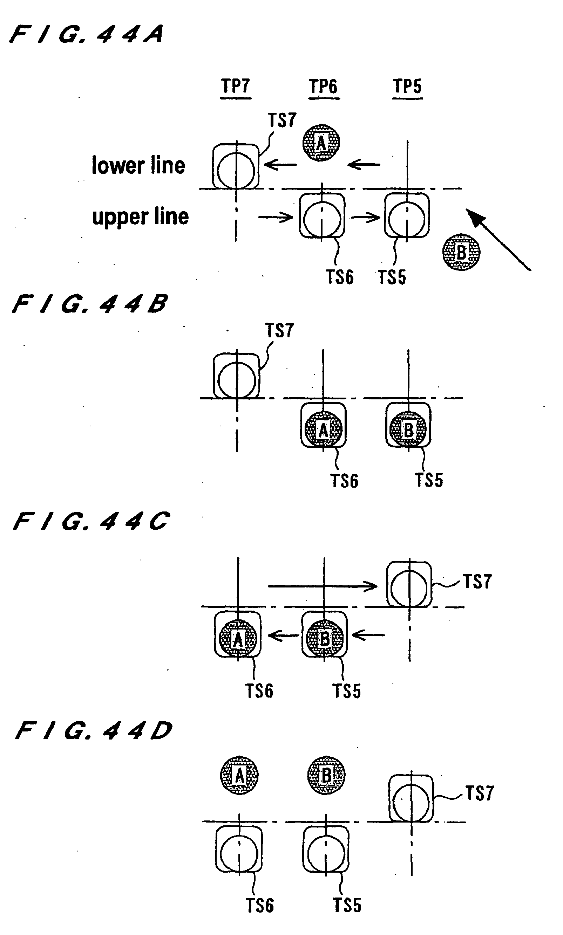

Then, the pusher 37 located at the sixth transferring position TP6 is elevated to transfer the wafer A to the top ring 301C (FIG. 43D). At this time, the upper transfer stages TS5 and TS6 move toward the fifth transferring position TP5, and the lower transfer stage TS7 moves toward the seventh transferring position TP7 (FIG. 44A). Then, the polished wafer A is placed on the sixth transfer stage TS6 (FIG. 44B). At this time, the next wafer B is placed on the fifth transfer stage TS5 in the same manner as described above.

Then, the upper transfer stages TS5 and TS6 move toward the seventh transferring position TP7, and the lower transfer stage TS7 moves toward the fifth transferring position TP5. Thus, the wafer A on the sixth transfer stage TS6 is moved to the wafer receiving/delivering position (seventh transferring position TP7) for the top ring 301D, and the wafer B on the fifth transfer stage TS5 is moved to the wafer receiving/delivering position (sixth transferring position TP6) for the top ring 301C (FIG. 44C).

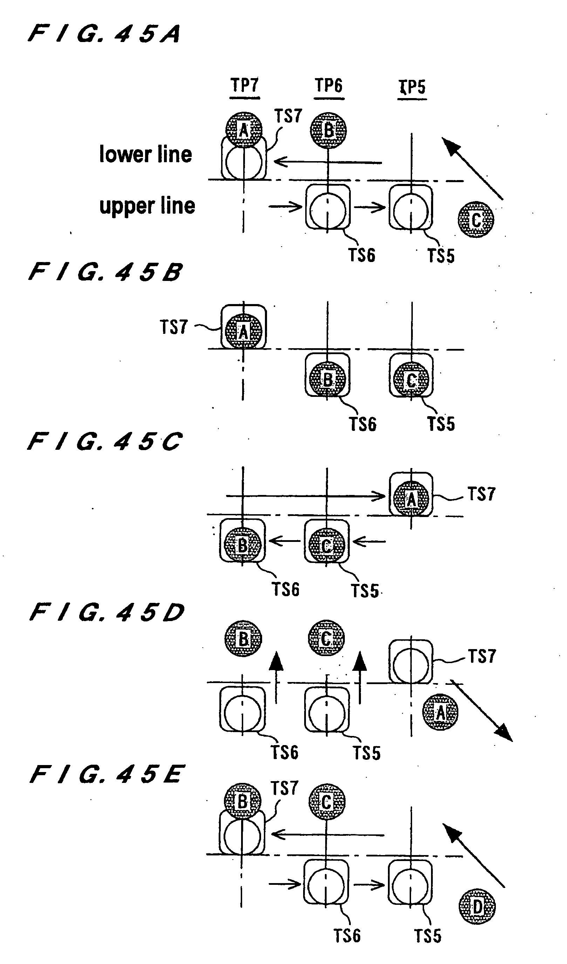

Then, the pusher 38 located at the seventh transferring position TP7, and the pusher 37 located at the sixth transferring position TP6 are elevated to transfer the wafer A and the wafer B to the top ring 301D and the top ring 301C, respectively (FIG. 44D). At this time, the upper transfer stages TS5 and TS6 move toward the fifth transferring position TP5, and the lower transfer stage TS7 moves toward the seventh transferring position TP7 (FIG. 45A). The wafer A and the wafer B, which have been polished in the respective polishing units, are placed on the seventh transfer stage TS7 and the sixth transfer stage TS6 by the pushers 38 and 37, respectively (FIG. 45B). At this time, the next wafer C is placed on the fifth transfer stage TS5 in the same manner as described above.

Then, the upper transfer stages TS5 and TS6 move toward the seventh transferring position TP7, and the lower transfer stage TS7 moves toward the fifth transferring position TP5. Thus, the wafer A on the seventh transfer stage TS7 is moved to the fifth transferring position TP5, the wafer B on the sixth transfer stage TS6 is moved to the wafer receiving/delivering position (seventh transferring position TP7) for the top ring 301D, and the wafer C on the fifth transfer stage TS5 is moved to the wafer receiving/delivering position (sixth transferring position TP6) for the top ring 301C (see FIG. 45C).

Then, the pusher 38 located at the seventh transferring position TP7 and the pusher 37 located at the sixth transferring position TP6 are elevated to transfer the wafer B and the wafer C to the top ring 301D and the top ring 301C, respectively. The wafer clamp mechanism 112 of the swing transporter 7 located at the fifth transferring position is swung, and the wafer A is transferred to the swing transporter 7 (FIG. 45D). At this time, the upper transfer stages TS5 and TS6 move toward the fifth transferring position TP5, and the lower transfer stage TS7 moves toward the seventh transferring position TP7. The next wafer D is prepared by the swing transporter 7 (FIG. 45E). Thereafter, the processes shown in FIGS. 45A through 45E are repeated.

When parallel processing is performed, a wafer is transferred on the following route: the wafer cassette of the front loading unit 20 → the transfer robot 22 → the reversing machine 31 → the lifter 32 → the first transfer stage TS1 of the first linear transporter 5 → the pusher 33 → the top ring 301A → the polishing table 300A → the pusher 33 → the second transfer stage TS2 of the first linear transporter 5 → the pusher 34 → the top ring 301B → the polishing table 300B → the pusher 34 → the third transfer stage TS3 of the first linear transporter 5 →the swing transporter 7 → the reversing machine 41 1 → the temporary stage 130 → the chucking unit 461 of the transfer unit 46 → the primary cleaning device 42 → the chucking unit 462 of the transfer unit 46 → the secondary cleaning device 43 → the chucking unit 463 of the transfer unit 46 → the tertiary cleaning device 44 → the chucking unit 464 of the transfer unit 46 → the quaternary cleaning device 45 → the transfer robot 22 → the wafer cassette of the front loading unit 20.

Another wafer is transferred on the following route: the wafer cassette of the front loading unit 20 → the transfer robot 22 → the reversing machine 31 → the lifter 32 → the fourth transfer stage TS4 of the first linear transporter 5 → the swing transporter 7 → the fifth transfer stage TS5 of the second linear transporter 6 → pusher 37 → the top ring 301C → the polishing table 300C → the pusher 37 → the sixth transfer stage TS6 of the second linear transporter 6 → the pusher 38 → the top ring 301D → the polishing table 300D → the pusher 38 → the seventh transfer stage TS7 of the second linear transporter 6 → the swing transporter 7 → the reversing machine 41 → the temporary stage 130 → the chucking unit 461 of the transfer unit 46 → the primary cleaning device 42 → the chucking unit 462 of the transfer unit 46 → the secondary cleaning device 43 → the chucking unit 463 of the transfer unit 46 → the tertiary cleaning device 44 → the chucking unit 464 of the transfer unit 46 → the quaternary cleaning device 45 → the transfer robot 22 → the wafer cassette of the front loading unit 20.

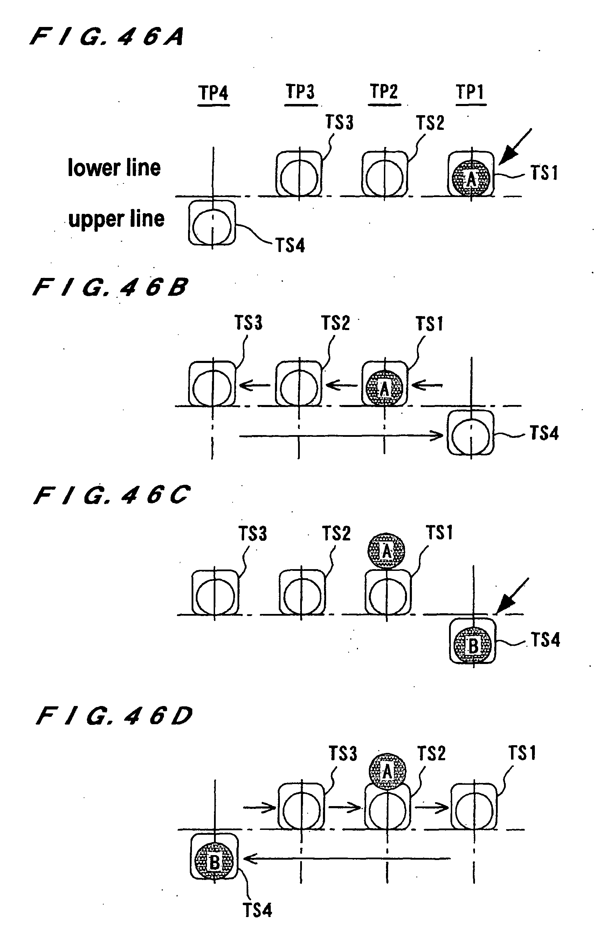

Operations of the linear transporters 5 and 6 will be described below with reference to FIGS. 46 through 51. A wafer A is placed on the first transfer stage TS 1 of the first linear transporter 5 as with serial processing (FIG. 46A). The lower transfer stages TS1, TS2, and TS3 move toward the fourth transferring position TP4, and the upper transfer stage TS4 moves toward the first transferring position TP1. Thus, the wafer A on the first transfer stage TS 1 is moved to the wafer receiving/delivering position (second transferring position TP2) for the top ring 301A (FIG. 46B).

Then, the pusher 33 located at the second transferring position TP2 is elevated to transfer the wafer A to the top ring 301A. At this time, the next wafer B is placed on the fourth transfer stage TS4 (FIG. 46C). The lower transfer stages TS1, TS2, and TS3 move toward the first transferring position TP1, and the upper transfer stage TS4 moves toward the fourth transferring position TP4. Thus, the wafer B on the fourth transfer stage TS4 is moved to the fourth transferring position TP4 (FIG. 46D).

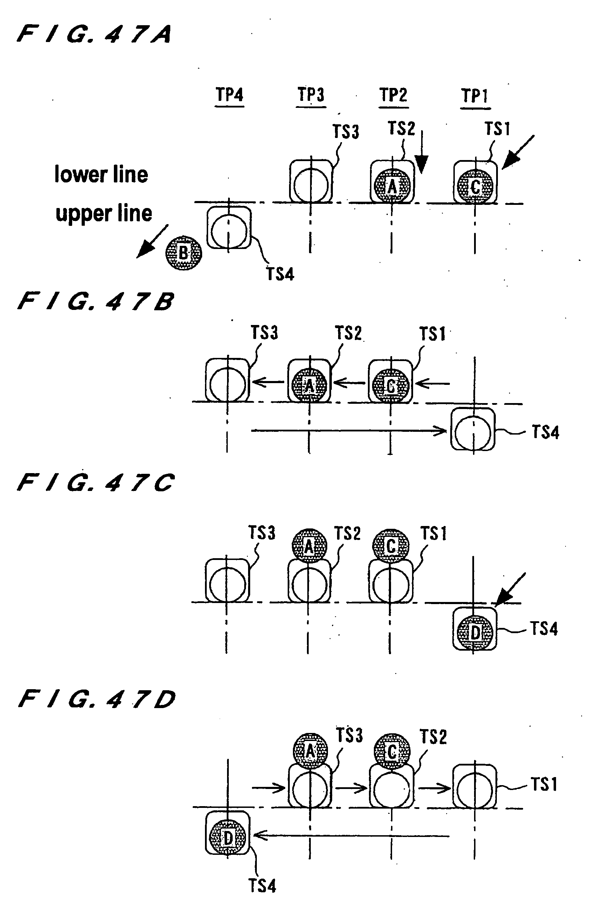

The wafer A, which has been polished, is placed on the second transfer stage TS2 by the pusher 33, and the next wafer C is placed on the first transfer stage TS 1. The wafer clamp mechanism 112 of the swing transporter 7 located at the fourth transferring position TP4 is swung, and the wafer B is transferred to the swing transporter 7 (FIG. 47A). The wafer B is transferred to the second polishing section 3b by the swing transporter 7.

Then, the lower transfer stages TS1, TS2, and TS3 move toward the fourth transferring position TP4, and the upper transfer stages TS4 moves toward the first transferring position TP1. Thus, the wafer A on the second transfer stage TS2 is moved to the wafer receiving/delivering position (third transferring position TP3) for the top ring 301B, and the wafer C on the first transfer stage TS1 is moved to the wafer receiving/delivering position (second transferring position TP2) for the top ring 301A (FIG. 47B).

Then, the pusher 34 located at the third transferring position TP3 and the pusher 33 located at the second transferring position TP2 are elevated to transfer the wafer A and the wafer C to the top ring 301B and the top ring 301A, respectively. Further, the next wafer D is placed on the fourth transfer stage TS4 in the same manner as described above (FIG. 47C). Then, the lower transfer stages TS1, TS2, and TS3 move toward the first transferring position TP1, and the upper transfer stage TS4 moves toward the fourth transferring position TP4. Thus, the wafer D on the fourth transfer stage TS4 is moved to the fourth transferring position TP4 (FIG. 47D).

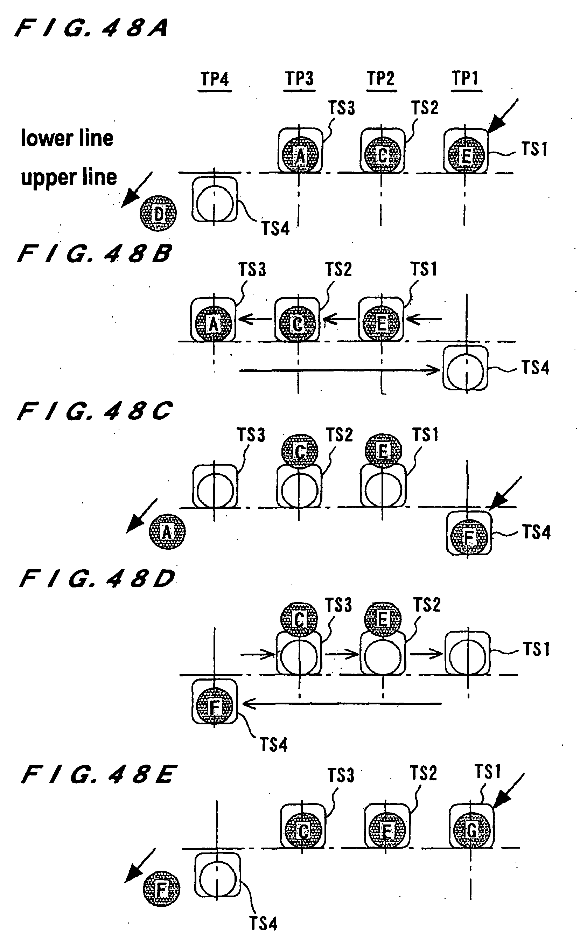

The wafer A and the wafer C, which have been polished in the respective polishing units, are placed on the third transfer stage TS3 and the second transfer stage TS2 by the pushers 34 and 33, respectively, and the next wafer E is placed on the first transfer stage TS 1. Further, the wafer clamp mechanism 112 of the swing transporter 7 located at the fourth transferring position TP4 is swung, and the wafer D is transferred to the swing transporter 7 (FIG. 48A).

Then, the lower transfer stages TS1, TS2, and TS3 move toward the fourth transferring position TP4, and the upper transfer stage TS4 moves toward the first transferring position TP1. Thus, the wafer A on the third transfer stage TS3 is moved to the fourth transferring position TP4, the wafer C on the second transfer stage TS2 is moved to the wafer receiving/delivering position (third transferring position TP3) for the top ring 301B, and the wafer E on the first transfer stage TS1 is moved to the wafer receiving/delivering position (second transferring position TP2) for the top ring 301A (FIG. 48B).

Then, the pusher 34 located at the third transferring position TP3 and the pusher 33 located at the second transferring position TP2 are elevated to transfer the wafer C and the wafer E to the top ring 301B and the top ring 301A, respectively. Further, the wafer clamp mechanism 112 of the swing transporter 7 located at the fourth transferring position TP4 is swung, and the polished wafer A is transferred to the swing transporter 7 (FIG. 48C). At this time, the next wafer F is placed on the fourth transfer stage TS4 in the same manner as described above.

Then, the lower transfer stages TS1, TS2, and TS3 move toward the first transferring position TP1, and the upper transfer stage TS4 moves toward the fourth transferring position TP4. Thus, the wafer F on the fourth transfer stage TS4 is moved to the fourth transferring position TP4 (FIG. 48D). The wafer C and the wafer E, which have been polished in the respective polishing units, are placed on the third transfer stage TS3 and the second transfer stage TS2 by the pushers 34 and 33, respectively, and the next wafer G is placed on the first transfer stage TS1. Further, the wafer clamp mechanism 112 of the swing transporter 7 located at the fourth transferring position TP4 is swung, and the wafer F is transferred to the swing transporter 7 (FIG. 48E). Thereafter, the processes shown in FIGS. 48B through 48E are repeated.

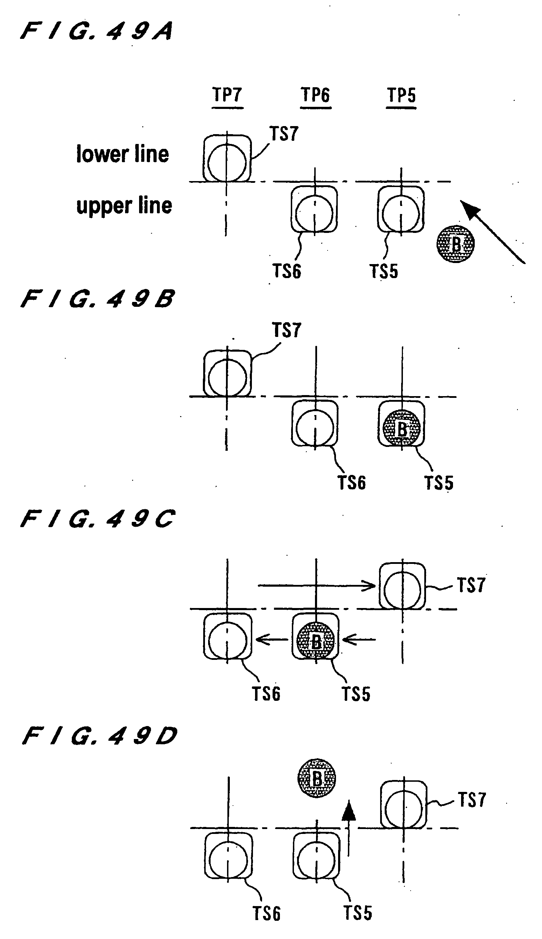

On the other hand, the swing transporter 7, which has received the wafer B, transfers the wafer B to the fifth transferring position TP5 of the second linear transporter 6 in the second polishing section 3b (FIG. 49A). The wafer B is placed on the fifth transfer stage TS5 of the second linear transporter 6 (FIG. 49B).

After the wafer B is placed on the fifth transfer stage TS5 of the second linear transporter 6, the upper transfer stages TS5 and TS6 move toward the seventh transferring position TP7, and the lower transfer stage TS7 moves toward the fifth transferring position TP5. Thus, the wafer B on the fifth transfer stage TS5 is moved to the wafer receiving/delivering position (sixth transferring position TP6) for the top ring 301C (FIG. 49C).

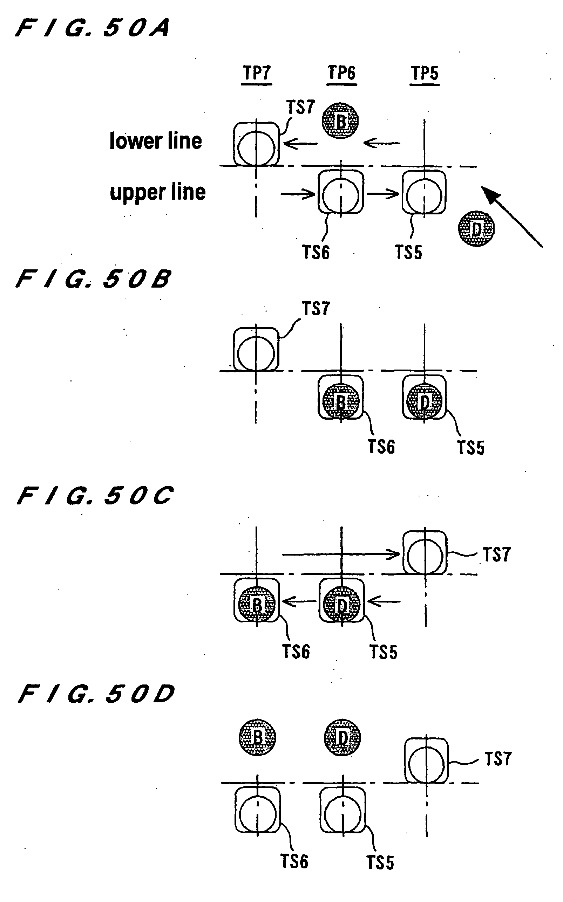

Then, the pusher 37 located at the sixth transferring position TP6 is elevated to transfer the wafer B to the top ring 301C (FIG. 49D). At this time, the upper transfer stages TS5 and TS6 move toward the fifth transferring position TP5, and the lower transfer stage TS7 moves toward the seventh transferring position TP7 (FIG. 50A). The polished wafer B is placed onto the sixth transfer stage TS6 by the pusher 37 (FIG. 50B). At this time, the wafer D, transferred to the swing transporter 7 as shown in FIG. 48A, is placed on the fifth transfer stage TS5.

Then, the upper transfer stages TS5 and TS6 move toward the seventh transferring position TP7, and the lower transfer stage TS7 moves toward the fifth transferring position TP5. Thus, the wafer B on the sixth transfer stage TS6 is moved to the wafer receiving/delivering position (seventh transferring position TP7) for the top ring 301D, and the wafer D on the fifth transfer stage TS5 is moved to the wafer receiving/delivering position (sixth transferring position TP6) for the top ring 301C (FIG. 50C).

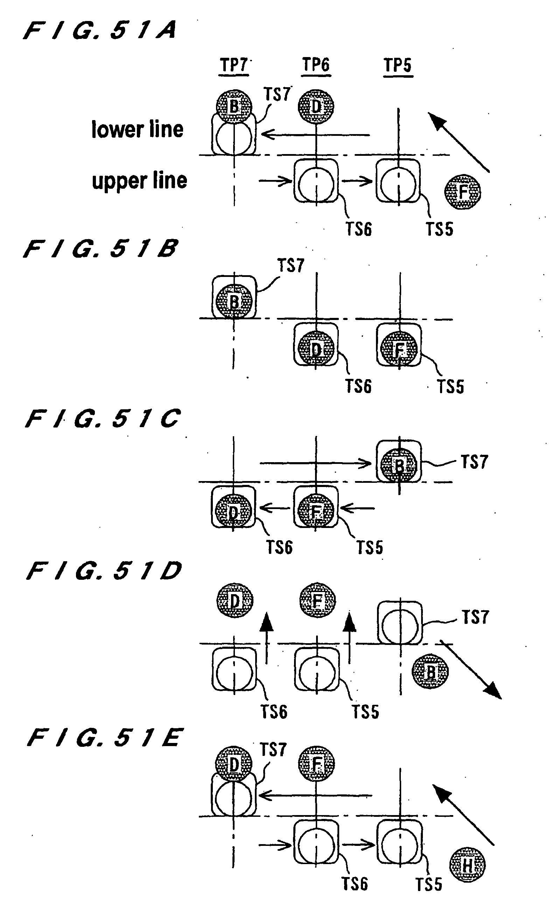

Then, the pusher 38 located at the seventh transferring position TP7 and the pusher 37 located at the sixth transferring position TP6 are elevated to transfer the wafer B and the wafer D to the top ring 301D and the top ring 301C, respectively (FIG. 50D). At this time, the upper transfer stages TS5 and TS6 move toward the fifth transferring position TP5, and the lower transfer stage TS7 moves toward the seventh transferring position TP7 (FIG. 51A). The wafer B and the wafer D, which have been polished in the respective polishing units, are placed on the seventh transfer stage TS7 and the sixth transfer stage TS6 by the pushers 38 and 37, respectively (FIG. 51B). At this time, the wafer F, transferred to the swing transporter 7 as shown in FIG. 48E, is placed on the fifth transfer stage TS5.

Then, the upper transfer stages TS5 and TS6 move toward the seventh transferring position TP7, and the lower transfer stage TS7 moves toward the fifth transferring position TP5. Thus, the wafer B on the seventh transfer stage TS7 is moved to the fifth transferring position TP5, the wafer D on the sixth transfer stage TS6 is moved to the wafer receiving/delivering position (seventh transferring position TP7) for the top ring 301D, and the wafer F on the fifth transfer stage TS5 is moved to the wafer receiving/delivering position (sixth transferring position TP6) for the top ring 301C (FIG. 51C).

Then, the pusher 38 located at the seventh transferring position TP7, and the pusher 37 located at the sixth transferring position TP6 are elevated to transfer the wafer D and the wafer F to the top ring 301D and the top ring 301C, respectively. The wafer clamp mechanism 112 of the swing transporter 7 located at the fifth transferring position is swung, and the wafer B is transferred to the swing transporter 7 (FIG. 51D). At this time, the upper transfer stages TS5 and TS6 move toward the fifth transferring position TP5, and the lower transfer stage TS7 moves toward the seventh transferring position TP7. The next wafer H is prepared by the swing transporter 7 (FIG. 51E). Thereafter, the processes shown in FIGS. 51A through 51E are repeated.

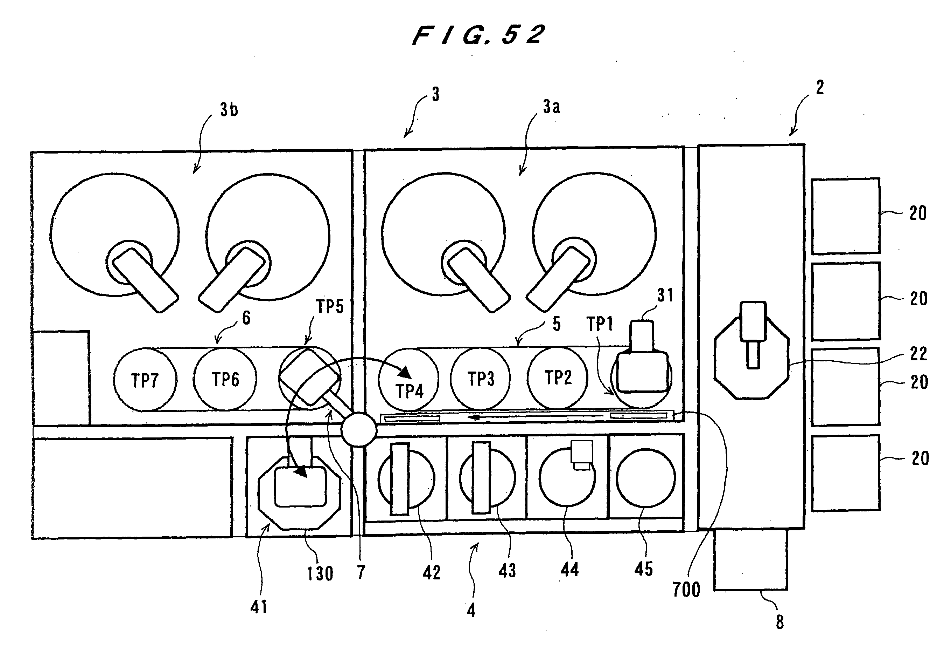

As described above, when performing parallel processing of a wafer, the fourth transfer stage TS4 of the first linear transporter 5 is operated so as to transfer the wafer from the first transferring position TP1 to the fourth transferring position TP4, and to skip the second transferring position TP2 and the third transferring position TP3. Instead of the fourth transfer stage TS4, as shown in FIG. 52, a vertical transfer mechanism 700, which is operable to hold a wafer vertically and to transfer the wafer from the first transferring position TP1 to the fourth transferring position TS4, may be provided between the first linear transporter 5 and the cleaning section 4. This vertical transfer mechanism 700 can be added to a horizontal transfer mechanism comprising the first transfer stage TS 1, the second transfer stage TS2, and the third transfer state TS3 of the first linear transporter 5. With this transfer mechanism, the wafer is not affected by contamination of the first polishing section 3a, and can thus be transferred to the second polishing section 3b in a clean condition. Further, a contamination route can be provided for checking a performance of the cleaning devices without passing a wafer through the polishing section. Specifically, a non-polished wafer can be transferred to the swing transporter 7 by the vertical transfer mechanism 700 and can be transferred to the cleaning devices 42-45 via the reversing machine 41. Therefore, a cleaning performance and back contamination of each of the cleaning devices 42-45 can be evaluated. Further, a wafer can be transferred from the transfer robot 22 to the second polishing section 3b via a route that is different from a wafer transferring route in the first polishing section 3a. Therefore, a wafer can be prevented from staying in the first linear transporter 5. This vertical transfer mechanism 700 may have the same structure as that of the above-mentioned transfer unit 46 of the cleaning section 4 (see FIG. 29).

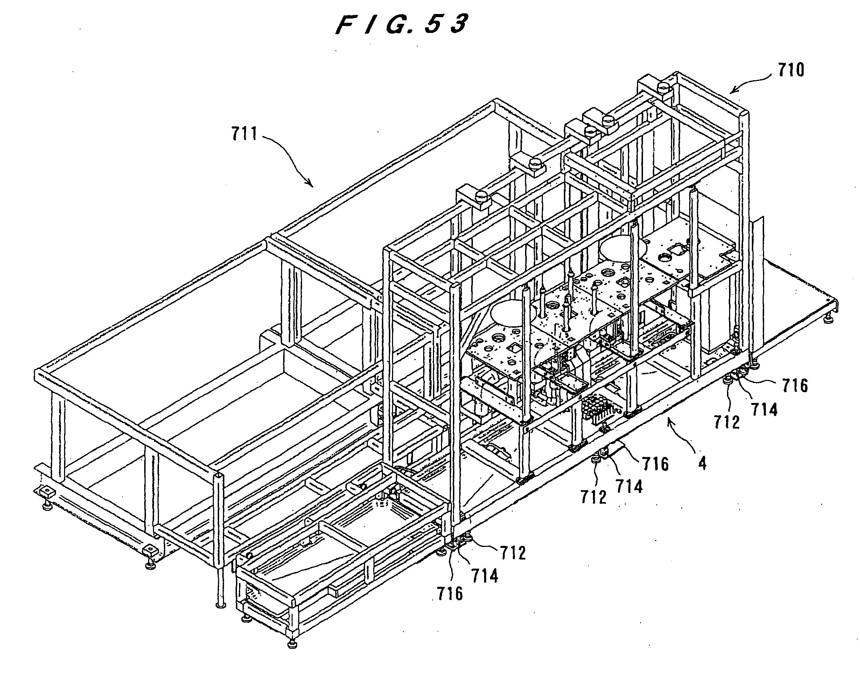

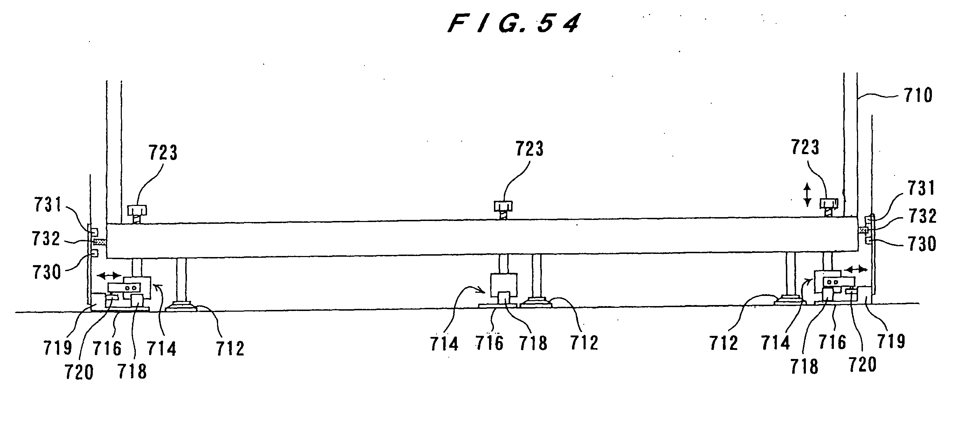

FIG. 53 is a perspective view showing a frame structure of the polishing apparatus shown in FIG. 1. In this embodiment, a frame 710 of the cleaning section 4 can be detached from another frame 711. Specifically, as shown in FIG. 54, immovable legs 712 for fixing the frame 710 and caster legs 714 for allowing the frame 710 to be pulled out are provided on a lower portion of the frame 710 of the cleaning section 4. Stainless plates 716 are provided on lower portions of the caster legs 714, respectively.

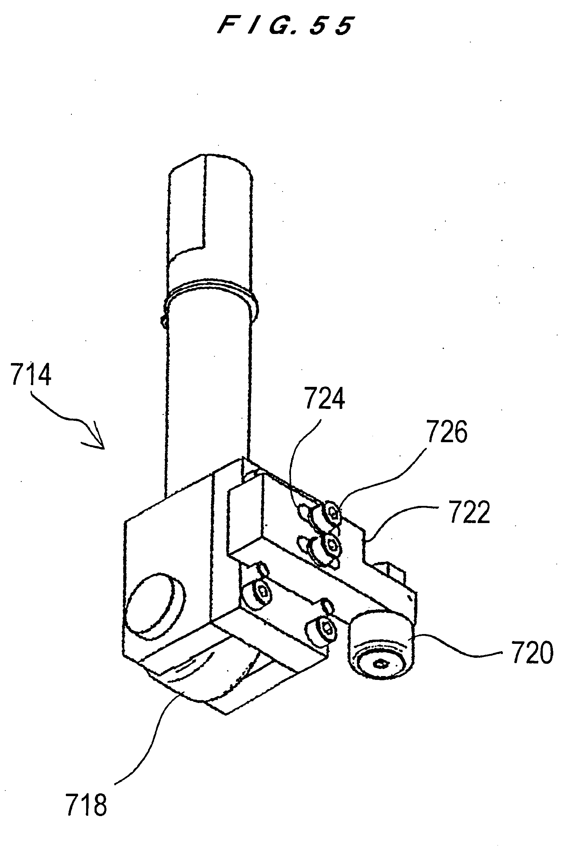

FIG. 55 is a perspective view showing the caster leg 714. As shown in FIG. 55, the caster leg 714 comprises a main roller 718 movable in a pullout direction of the frame 710, and a side roller 720 which is in contact with a projection 719 provided on the stainless plate 716. This side roller 720 is attached to a base 722 having elongate holes 724. Screws 726 are inserted into the elongate holes 724. By tightening these screws 726, a position of the side roller 720 can be adjusted. Further, a screw 723 is provided on an upper portion of the caster leg 714, so that a length of the caster leg 714 can be adjusted by rotation of the screw 723.

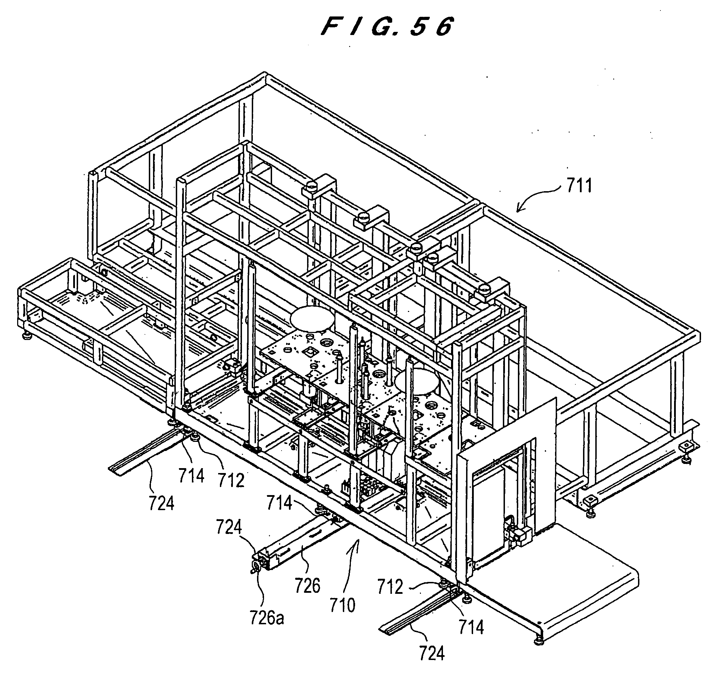

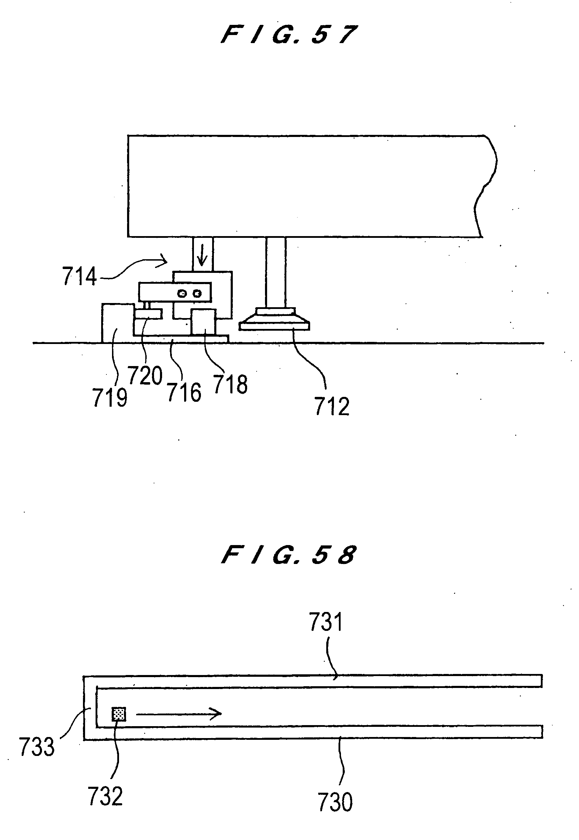

Pulling out of the frame 710 of the cleaning section 4 is performed as follows. As shown in FIG. 56, extension plates 724 are connected to the stainless plates 716 disposed beneath the caster legs 714, and a ball screw mechanism 726 having a handle is connected to a central portion of the frame 710. Then, the screws 723 on the upper portions of the caster legs 714 are tightened to extend the caster legs 714, so that the caster legs 714 become longer than the immovable legs 712, as shown in FIG. 57. As a result, the frame 710, which was supported by the immovable legs 712, is supported by the caster legs 714. In this state, a handle 726a of the ball screw mechanism 726 shown in FIG. 56 is rotated to thereby cause the main rollers 718 of the caster legs 714 to roll on the stainless plates 716 and the extension plates 724, whereby the frame 710 of the cleaning section 4 can be pulled out.

As shown in FIG. 54, guide members 730 and 731, extending in the pullout direction of the frame 710, are provided adjacent to the frame 710 of the cleaning section 4. Projections 732 are provided on side surfaces of the frame 710 of the cleaning section 4 at positions corresponding to the upper and lower guide members 730 and 731. Each of the projections 732 is located between the upper guide member 730 and the lower guide member 731. As indicated by arrow in FIG. 58, when the frame 710 of the cleaning section 4 is being pulled out, the projection 732 moves within a space between the upper and lower guide members 730 and 731. With this structure, even if the frame 710 is about to tilt and fall, the projection 732 of the frame 710 engages the lower guide member 730 or the upper guide member 710. Therefore, the frame 710 does not fall. The upper and lower guide members 730 and 731 have a push-restriction portion 733 on their ends for preventing the frame 710 from being excessively pushed in.

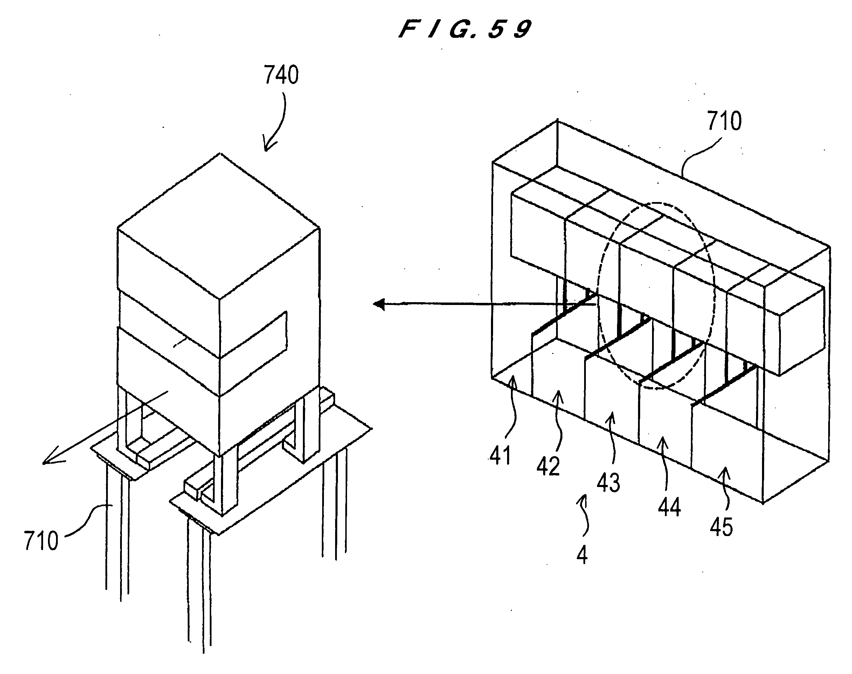

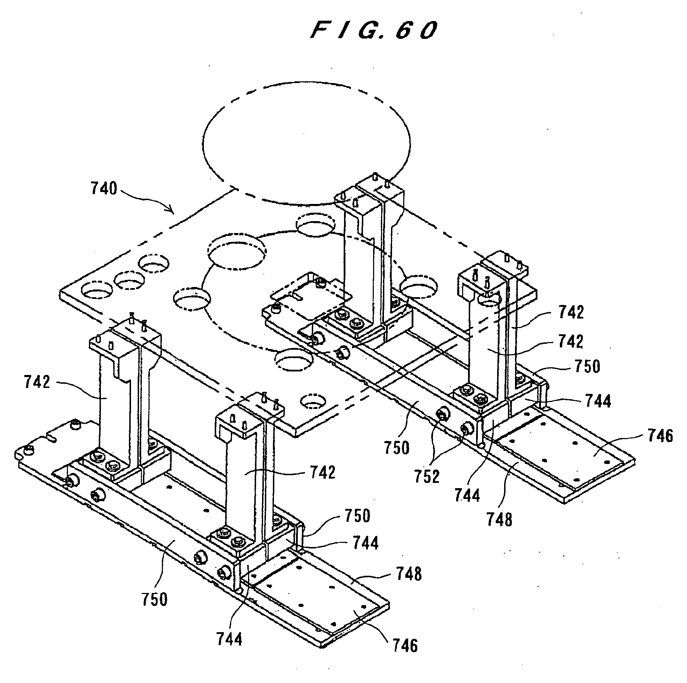

As shown in FIG. 59, the reversing machine 41 and the cleaning devices 42-45 are incorporated as units in the frame 710 of the above-described cleaning section 4. In the present embodiment, each of the units 740 can separately be pulled out and removed from the frame 710 of the cleaning section 4. Specifically, as shown in FIG. 60, the unit 740 has four legs 742 extending downwardly. Slide blocks 744 are attached to lower portions of these legs 742. The slide blocks 744 are disposed on resin plates 746 extending in a pullout direction of the unit 740. With this arrangement, when the unit 740 is pulled out, the slide blocks 744 slide on the resin plates 746.

The resin plates 746 are disposed on guide plates 748 extending in the pullout direction of the unit 740. Guide members 750 are provided on the guide plates 748. The slide blocks 744 of the adjacent units 740 are interposed between the guide members 750. These guide members 750 extend in the pullout direction of the unit 740 so as to guide the slide blocks 744 when the unit 740 is being pulled out. With this structure, a short period of time is required for replacing the cleaning device on the unit 740, and replacement operation can be facilitated. For example, the above-mentioned roll type cleaning device can be easily replaced with the pencil type cleaning device. Screws 752 are mounted on side surfaces of the guide members 750. When fixing the unit 740, the screws 752 are tightened so as to fix the sidle blocks 744.

The above-described exterior components, including the frames 710 and 711, are made from aluminum, so that the polishing apparatus can be lightweight. Therefore, it is easy to pull out the frame 710 of the cleaning section 4 and the unit 740 when maintenance is to be performed. Further, safety of moving operations thereof can be improved.

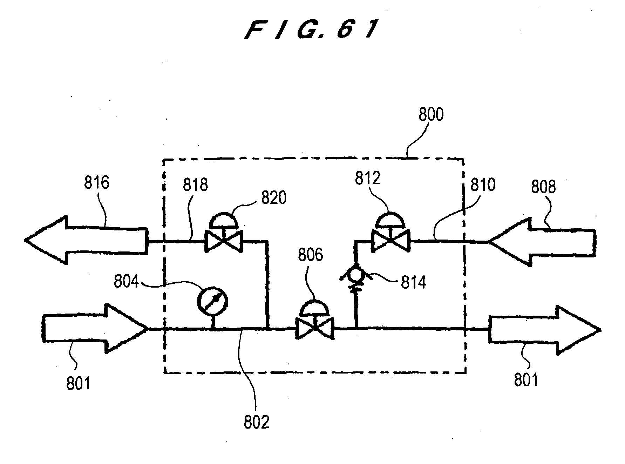

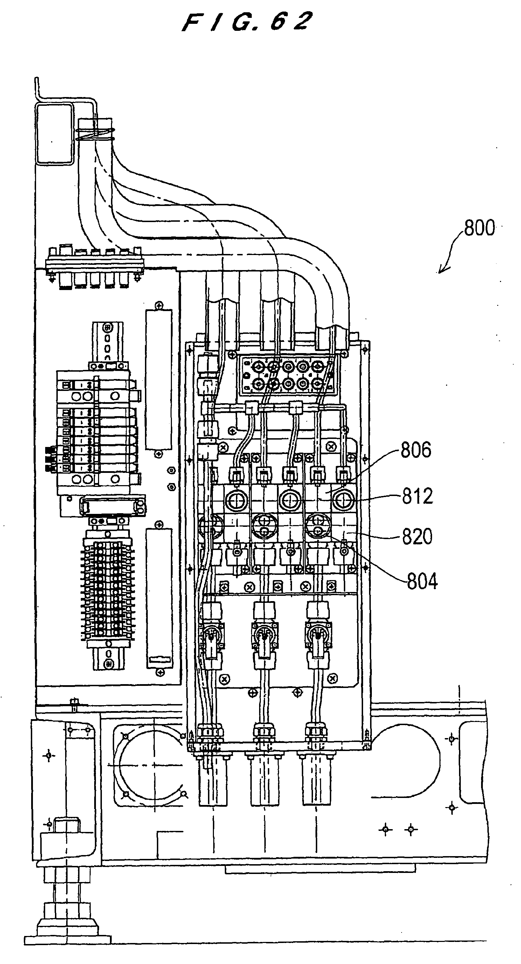

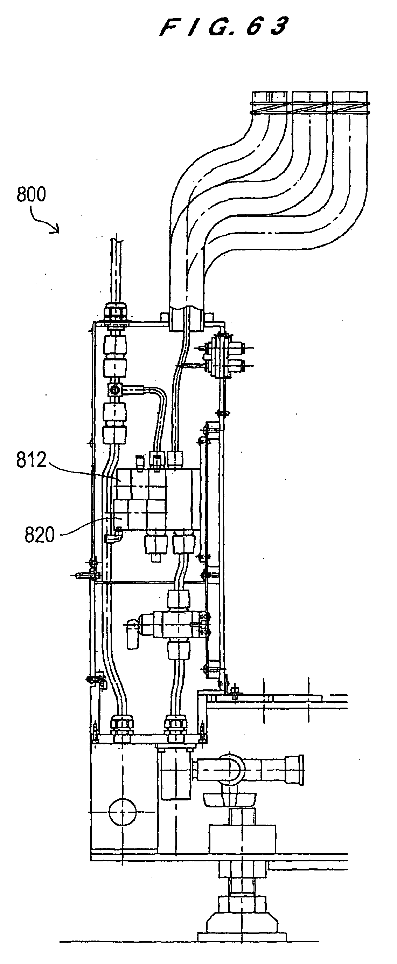

FIG. 61 is a block diagram of a chemical liquid supply apparatus 800 of the polishing apparatus shown in FIG. 1. FIGS. 62 and 63 are vertical cross-sectional views each showing the chemical liquid supply apparatus 800. As shown in FIGS. 61 through 63, the chemical liquid supply apparatus 800 according to the present embodiment comprises a chemical liquid supply pipe 802 for supplying a chemical liquid 801 such as a polishing liquid or a cleaning liquid, a pressure sensor 804 for detecting pressure of the chemical liquid 801 flowing through the chemical liquid supply pipe 802, an air operate valve 806 for performing on-off control of a flow rate of the chemical liquid 801 flowing through the chemical liquid supply pipe 802, a pure water supply pipe 810 for supplying pure water 808 to the chemical liquid supply pipe 802, an air operate valve 812 for performing on-off control of a flow rate of the pure water 808 flowing through the pure water supply pipe 810, a check valve 814 for preventing backflow of the chemical liquid 801 from the chemical liquid supply pipe 802 into the pure water supply pipe 810, a chemical liquid return pipe 818 for returning an unused chemical liquid 816 from the chemical liquid supply pipe 802, and an air operate valve 820 for performing on-off control of a flow rate of the chemical liquid 816 flowing through the chemical liquid return pipe 818. These components are arranged in a single unit.

In the chemical liquid supply apparatus 800 having the above structure, by adjusting the air operate valve 806, the chemical liquid 801 is supplied to the polishing liquid supply nozzles 302A, 302B, 302C, and 302D (see FIG. 1) of the of the respective polishing units 30A, 30B, 30C, and 30D through the chemical liquid supply pipe 802. When cleaning the chemical liquid supply pipe 802, the air operate valve 812 is opened and the pure wafer 808 is supplied to the chemical liquid supply pipe 802 to thereby prevent clogging of the chemical liquid supply pipe 802. The chemical liquid 816, which was not used in polishing, is returned to a supply source through the chemical liquid return pipe 818 by adjusting the air operate valve 820.

In this embodiment, as described above, the pressure sensor 804, the air operate valve 806, the air operate valve 812, the check valve 814, the air operate valve 820, and other components are integrally assembled. Thus, the chemical liquid supply apparatus 800 requires a small installation space, and a low cost can be achieved. Further, because those components are assembled within a single space, an efficiency of maintenance operations can be improved.

In the above embodiments, a polishing apparatus for polishing a workpiece has been described. However, the present invention is not limited to the polishing apparatus and is applicable to other substrate processing apparatuses. For example, some polishing units may be replaced with other substrate processing units (e.g., a film forming unit such as a plating unit or a CVD unit, a wet etching unit, or a dry etching unit) to form a substrate processing apparatus different from a polishing apparatus. Further, a plurality of different substrate processing units may be combined with each other and arrayed in a certain direction.

Although certain preferred embodiments of the present invention have been described, it should be understood that the present invention is not limited to the above embodiments, and that various changes and modifications may be made therein without departing from the scope of the technical concept.

### Industrial Applicability

The present invention is applicable to a polishing apparatus for polishing a substrate, such as a semiconductor wafer, to a flat mirror finish. The present invention is also applicable to a substrate transfer apparatus for use in such a substrate processing apparatus. Further, the present invention is applicable to a substrate clamp apparatus for use in such a substrate transfer apparatus and a reversing machine. Furthermore, the present invention is applicable to a chemical-liquid treatment apparatus for use in the above-mentioned substrate processing apparatus.

## Claims

1. A substrate processing apparatus, comprising:
plural processing sections each for performing predetermined processing on a substrate; and
a substrate transfer mechanism for transferring the substrate between said plural processing sections,
wherein said substrate transfer mechanism includes:
a substrate clamp mechanism adapted to clamp the substrate;
a vertically moving mechanism for vertically moving said substrate clamp mechanism along a frame of a casing of one of said plural processing sections; and
a swing mechanism for swinging said substrate clamp mechanism about said frame or a shaft adjacent to said frame.

2. A substrate processing apparatus, comprising:
a pair of clamp members having at least two chucking mechanisms which are to be brought into contact with a periphery of a substrate, said pair of clamp members being arranged symmetrically about a center of the substrate so as to face one another; and
an opening and closing mechanism for moving said pair of clamp members in directions toward and away from one another.

3. The substrate processing apparatus according to claim 2, wherein said chucking mechanisms comprise circular pieces shaped to come into point contact with the periphery of the substrate.

4. The substrate processing apparatus according to claim 2, wherein said chucking mechanisms comprise chucking members shaped to come into line contact with the periphery of the substrate.

5. The substrate processing apparatus according to claim 2, wherein each of said chucking mechanisms includes:
a slope which is gradually inclined with an upward gradient toward the periphery of the substrate; and
a projection provided at an outermost periphery of said slope.

6. A substrate processing apparatus, comprising:
a first processing section for performing a first process on a substrate;
a reversing machine for reversing the substrate that has been processed in said first processing section; and
a second processing section for performing a second process on the substrate that has been reversed by said reversing machine,
wherein said reversing machine includes:
holding members configured to clamp the substrate;
a reversing mechanism for reversing the substrate clamped by said holding members; and
a vertically movable temporary stage disposed below said holding members, said temporary stage being for holding the substrate that has been reversed by said reversing mechanism.

7. A substrate processing apparatus according to claim 6, further comprising:
a substrate transfer mechanism for transferring the substrate between said first processing section or second processing section and said holding members or temporary stage of said reversing machine.

8. A substrate transfer apparatus, comprising:
a guide stage for holding a top ring adapted to hold a substrate;
a push stage vertically movable relative to said guide stage;
a cylinder having a ball spline mechanism for vertically moving said guide stage; and
a linear way adapted to perform centering of said guide stage.

9. A substrate transfer apparatus, comprising:
plural substrate clamp mechanisms each having a pair of clamp arms for clamping a periphery of a substrate, said clamp arms being symmetrically arranged about a center of the substrate so as to face one another;
an opening and closing mechanism for moving said pair of clamp arms in directions toward and away from one another;
a rotating mechanism for rotating said clamp arms about a shaft extending in an arrangement direction of said plural substrate clamp mechanisms;
a vertically moving mechanism for vertically moving said plural substrate clamp mechanisms; and
a moving mechanism for moving said plural substrate clamp mechanisms along the arrangement direction of said plural substrate clamp mechanisms.

10. A substrate processing apparatus, comprising:
a processing section for performing predetermined processing on a substrate; and
a substrate transfer apparatus according to claim 9, said substrate transfer apparatus being for transferring the substrate to and from said processing section,
wherein said processing section includes:
plural rollers for holding and rotating the substrate, each of said plural rollers having a support portion onto which the substrate is placed; and
positioning guides configured to allow a vertical movement of the substrate, transferred by said substrate transfer apparatus, while restricting a horizontal movement of the substrate.

11. A substrate processing apparatus, comprising:
plural processing sections each for performing predetermined processing on a substrate; and
a substrate transfer apparatus according to claim 9, said substrate transfer apparatus being for transferring the substrate between said plural processing sections,
wherein said substrate transfer apparatus is operable to transfer the substrate to said plural processing sections using said clamp arms, move said clamp arms from said plural processing sections and then rotate said clamp arms, and then move said clamp arms to predetermined positions.

12. A substrate processing apparatus, comprising:
plural processing sections for performing predetermined processing on a substrate; and
a substrate transfer mechanism for transferring the substrate between said plural processing sections,
wherein said substrate transfer mechanism includes:
a horizontal transfer mechanism for transferring the substrate between predetermined processing sections selected from said plural processing sections, said horizontal transfer mechanism being operable to transfer the substrate in a direction parallel to a surface of the substrate with an attitude of the substrate kept horizontal; and
a vertical transfer mechanism for transferring the substrate so as to skip said predetermined processing sections, said vertical transfer mechanism being operable to transfer the substrate in the direction parallel to the surface of the substrate with the attitude of the substrate kept vertical.

13. A substrate processing apparatus, comprising:
plural processing sections each for performing predetermined processing on a substrate,
wherein at least one of said plural processing sections includes:
a frame;
an immovable leg for fixing said frame; and
a caster leg having a main roller movable in a pullout direction of said frame, a length of said caster leg being adjustable.

14. The substrate processing apparatus according to claim 13, wherein said caster leg has a side roller contacting a component adjacent to said caster leg.

15. The substrate processing apparatus according to claim 13 or 14, wherein said frame has a projection located between a pair of guide members provided adjacent to said frame, the pair of guide members extending in the pullout direction.

16. A substrate processing apparatus, comprising:
plural units each for performing predetermined processing on a substrate; and
a frame for housing said plural units therein,
wherein said frame includes:
slide blocks attached to legs of said plural units;
plates on which said slide blocks slide; and
guide members for guiding said slide blocks, sliding on said plates, in a pullout direction of said frame.

17. A chemical liquid supply apparatus, comprising:
a chemical liquid supply pipe for supplying a chemical liquid;
a pressure sensor for detecting pressure of the chemical liquid flowing through said chemical liquid supply pipe;
a first air operate valve for adjusting a flow rate of the chemical liquid flowing through said chemical liquid supply pipe;
a pure water supply pipe for supplying pure water to said chemical liquid supply pipe;
a second air operate valve for adjusting a flow rate of the pure water flowing through said pure water supply pipe;
a check valve for preventing backflow of the chemical liquid from the chemical liquid supply pipe into said pure water supply pipe;
a chemical liquid return pipe for returning the chemical liquid unused from said chemical liquid supply pipe; and
a third air operate valve for adjusting a flow rate of the chemical liquid flowing through said chemical liquid return pipe,
wherein said chemical liquid supply pipe, said pressure sensor, said first air operate valve, said pure water supply pipe, said second air operate valve, said check valve, said chemical liquid return pipe, and said third air operate valve are arranged in a single unit.

18. A substrate processing apparatus, comprising:
plural processing sections each for performing predetermined processing on a substrate; and
a substrate transfer mechanism for transferring the substrate between said plural processing sections,
wherein said substrate transfer mechanism includes:
projections extending toward a center of the substrate and having upper projections and lower projections;
a transfer robot operable to place a periphery of the substrate onto upper surfaces of said lower projections and then move away from said projection; and
an opening and closing mechanism operable to move said projections toward the center of the substrate and to close said projections when the periphery of the substrate is placed onto said upper surfaces of said lower projections.
